# EUROPEAN PATENT SPECIFICATION

(11) **EP 4 311 851 B1**
(45) Date of publication and mention of the grant of the patent: **04.09.2024**
(21) Application number: 23187933.9
(22) Date of filing: 26.07.2023
(51) Int. Cl.: C09K 11/06, C07D 233/00, H10K 50/00, C07F 9/66, C07F 15/00, H10K 85/30, H10K 101/10

(54) **DINUCLEAR PLATINUM COMPLEXES FOR OLED APPLICATIONS**
DINUKLEARE PLATINKOMPLEXE FÜR OLED-ANWENDUNGEN
COMPLEXES DE PLATINE DINUCLÉAIRES POUR APPLICATIONS OLED

(30) Priority: 28.07.2022 US 202263393021 P
(43) Date of publication of application: 31.01.2024
(73) Proprietor: The University Of Hong Kong, Pokfulam, Hong Kong (CN); Hong Kong Quantum AI Lab Limited, Hong Kong (HK)
(72) Inventor: LO, Kar-Wai, Hong Kong (HK); CHE, Chi-Ming, Pak Shek Kok (HK); CHENG, Gang, Pak Shek Kok (HK)
(74) Representative: HGF

(56) References cited:
- WO-A1-2011/045337
- US-A1- 2019 010 178
- US-A1- 2019 010 179
- SICILIA VIOLETA ET AL: "Chameleonic Photo- and Mechanoluminescence in Pyrazolate-Bridged NHC Cyclometalated Platinum Complexes", INORGANIC CHEMISTRY, vol. 60, no. 16, 16 August 2021 (2021-08-16), Easton , US, pages 12274 - 12284, XP093102950, ISSN: 0020-1669, Retrieved from the Internet <URL:https://pubs.acs.org/doi/pdf/10.1021/acs.inorgchem.1c01470> DOI: 10.1021/acs.inorgchem.1c01470
- SICILIA VIOLETA ET AL: "Metal-Metal Cooperation in the Oxidation of a Flapping Platinum Butterfly by Haloforms: Experimental and Theoretical Evidence", INORGANIC CHEMISTRY, vol. 59, no. 17, 8 September 2020 (2020-09-08), Easton , US, pages 12586 - 12594, XP093102952, ISSN: 0020-1669, DOI: 10.1021/acs.inorgchem.0c01701
- PINTER PIERMARIA ET AL: "Prediction of emission wavelengths of phosphorescent NHC based emitters for OLEDs", TETRAHEDRON, ELSEVIER SIENCE PUBLISHERS, AMSTERDAM, NL, vol. 75, no. 35, 27 June 2019 (2019-06-27), XP085797043, ISSN: 0040-4020, [retrieved on 20190627], DOI: 10.1016/J.TET.2019.06.039

## Description

### CROSS-REFERENCE TO RELATED APPLICATIONS

This application claims benefit of and priority to U.S.S.N. 63/393,021, filed July 28, 2022.

### FIELD OF THE INVENTION

The disclosed invention is generally in the field of dinuclear platinum (II) emitter complexes, particularly dinuclear platinum (II) blue emitter complexes containing cyclometalating tridentate ligands, and their use in organic electronics, such as organic light-emitting devices (OLEDs).

### BACKGROUND OF THE INVENTION

Transition metal complexes have gained significant interest in commercial and academic settings as molecular probes, catalysts, and luminescent materials. As luminescent materials, transition metal complexes are increasingly being explored as potential alternatives to pure organic-based materials due to their potential for improved luminescence efficiency and device stability, compared to pure organic-based materials.

The search for operationally stable and high-efficiency blue emitters continues to be insurmountable. Thus, development of new emitters remains a high value target for the OLED industry. Extensive efforts in this area have been directed to the research and development of novel phosphorescent metal complexes. Recently, thermally activated delayed fluorescent (TADF) compounds have been developed due to their intrinsic advantages in achieving high device operational efficiency. These efforts, thus far, have resulted in limited success for these classes of emitter complexes where, as an example, issues concerning low quantum efficiencies, poor operational lifetime, and long radiative lifetimes of the emitters remain. Therefore, device performance and operational stability/lifetime of metal-based OLEDs must be enhanced for practical applications.

WO2011/045337A1 discloses dinuclear pt-carbene complexes.

Sicilia Violeta et al: "Chameleonic Photo- and Mechanoluminescence in Pyrazolate-Bridged NHC Cyclometalated Platinum Complexes", INORGANIC CHEMISTRY,vol. 60, no. 16, 16 August 2021 (2021-08-16), pages 12274-12284 discloses photoluminescence and DFT calculations on a series of platinum butterflies having the formula [{Pt(C^C*)(µ-Rpz)}₂] (RPz: pz **1,** 4-Meps **2,** 3,5-dmpz **3,** 3,5-dmpz **3,** 3,5-dppz **4**).

Sicilia Violeta et al: "Metal-Metal Cooperation in the Oxidation of a Flapping Platinum Butterfly by Haloforms: Experimental and Theoretical Evidence", INORGANIC CHEMISTRY, vol. 59, no. 17, 8 September 2020 (2020-09-08), pages 12586-12594 discloses the synthesis of dinuclear metal-metal bonded Pt^{III}(µ-pz)₂Pt^{III} compounds.

US 2019/010179 A1 discloses platinum and palladium complexes that can be used as emitting materials in OLED devices.

US 2019/010178 A1 discloses platinum and palladium complexes that can be used as emitting materials in OLED devices.

Pinter Piermaria et al: "Prediction of emission wavelengths of phosphorescent NHC based emitters for OLEDs", TETRAHEDRON, ELSEVIER SIENCE PUBLISHERS, AMSTERDAM, NL, vol. 75, no. 35, 27 June 2019 (2019-06-27) discusses OLD emission wavelengths. It reports results on 34 metallic complexes, and a method of predicating emission wavelengths.

Accordingly, there remains a need to develop improved operationally stable and high-efficiency emitter complexes for OLED applications. There is also a need for elongating the operational lifetime of devices containing such emitters to more practical levels by tailoring the radiative lifetime of the emitters.

Therefore, it is an object of the present invention to provide new luminescent dinuclear transition metal complexes containing platinum (II) and cyclometalating tridentate ligands.

It is another object of the present invention to provide new fluorine-free, luminescent dinuclear transition metal complexes containing platinum (II) and cyclometalating tridentate ligands.

### SUMMARY OF THE INVENTION

The present invention is defined by the appended claims.

Dinuclear platinum emitter complexes containing platinum (II) atoms complexed by tridentate N-heterocyclic carbene cyclometalating CCN ligands. The ligands contain a phenyl ring, an imidazolyl N-heterocyclic carbene ring, and a pyrazole ring. Exemplary dinuclear platinum (II) emitter complexes can have a structure as follows: 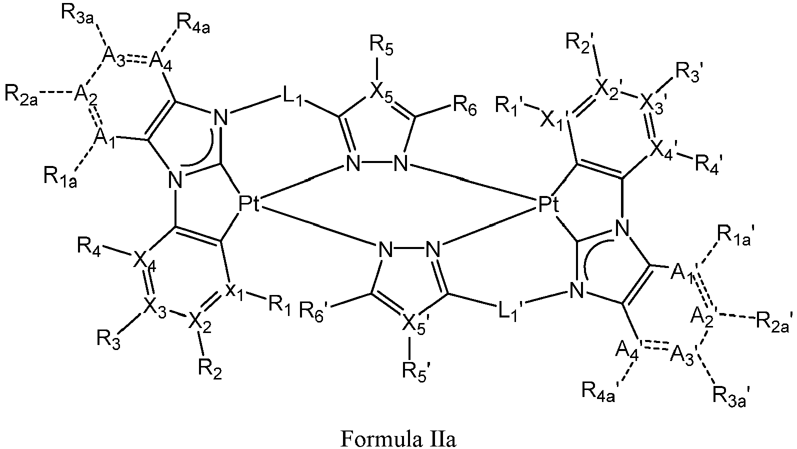 or 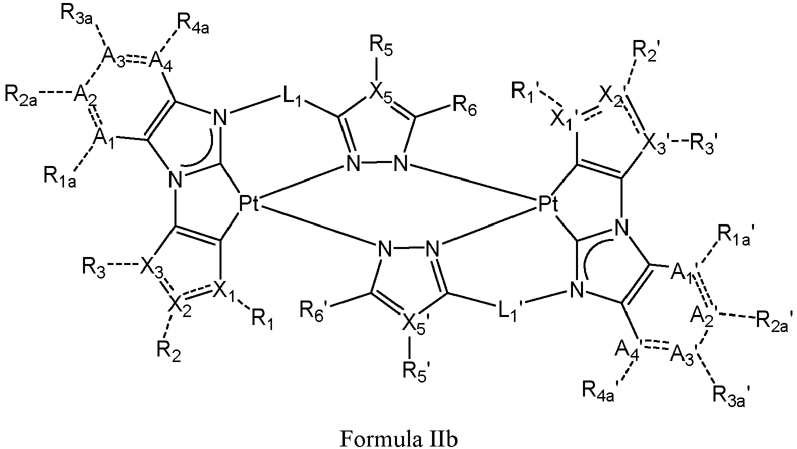 wherein:
the compound has an overall neutral, negative, or positive charge,
the dashed linear lines denote the presence or absence of a bond,
preferably, X₅ and X_{5'} are carbon,
preferably, X₁, X₂, X₃, X₄, X_{1'}, X_{2'}, X_{3'}, and X_{4'} when present, are independently carbon, nitrogen, oxygen, or sulfur, and are independently bonded to one or no hydrogen atom according to valency,
preferably R₅, R₆, R_{5'}, and R_{6'} are independently hydrogen, substituted alkyl, unsubstituted alkyl, substituted aryl, unsubstituted aryl, or R₅ and R₆ together, R_{5'} and R_{6'} together, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, fused combinations thereof,
preferably, A₁, A₂, A₃, A₄, A_{1'}, A_{2'}, A_{3'}, and A_{4'} are independently absent, hydrogen, deuterium, carbon, nitrogen, unsubstituted aryl, or substituted, and, when present, are independently bonded to one, two, three, four, five, or no hydrogen atom according to valency,
preferably, R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, unsubstituted aryl, substituted C₁-C₂₀ heterocyclyl, unsubstituted C₁-C₂₀ heterocyclyl, a fused combination thereof (such as dibenzofuran-4-yl, dibenzofuran-3-yl, dibenzothiopen-4-yl, dibenzothiopen-3-yl, *etc.*)*,* or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, fused combinations thereof,
preferably, R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted alkenyl, unsubstituted alkenyl, substituted alkynyl, unsubstituted alkynyl, substituted aryl (such as mesityl (2,4,6-trimethylphenyl), 3,5-di-*tert*-butylphenyl, 2,6-dimethylphenyl), unsubstituted aryl, halogen (such as fluorine), or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof, and/or
preferably, Li and L₁' are independently substituted C₁-C₁₀ alkyl or unsubstituted C₁-C₁₀ alkyl, preferably wherein the substituted C₁-C₁₀ alkyl contains one or more alkyl substituents (such as methyl, ethyl, propyl, *iso-*propyl, n-butyl, *sec*-butyl, *tert-butyl),* one or more ether bonds, one or more amine groups (such as substituted amine or unsubstituted amine), one or more substituted aryl groups, one or more substituted heteroaryl groups, one or more substituted C₃-C₂₀ cycloalkyl groups, one or more substituted C₁-C₂₀ heterocyclyl groups, or a combination thereof. It is to be understood that L₁ and L_{1'} are at least divalent.

In some forms, the compound can have any one of the following structures:

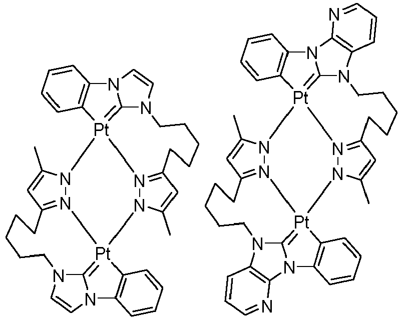

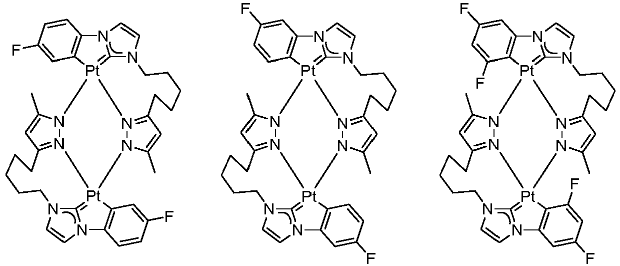

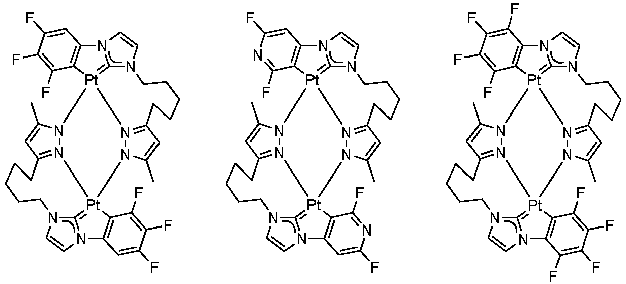

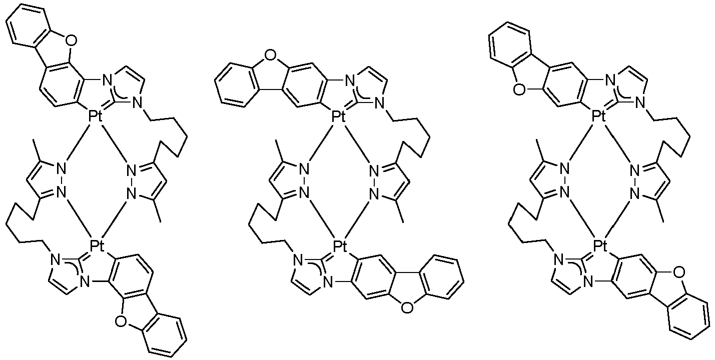

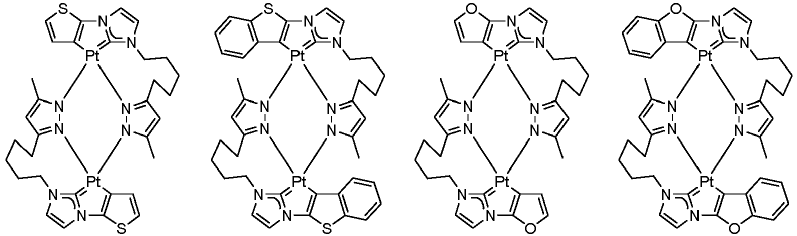

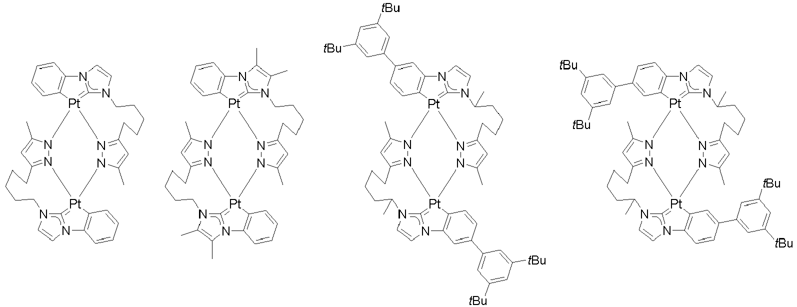

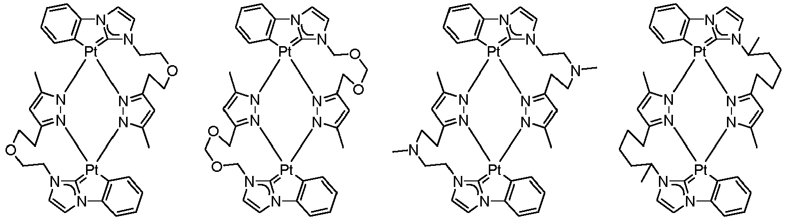

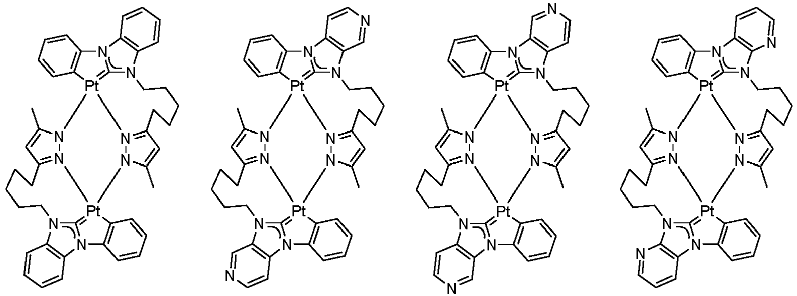

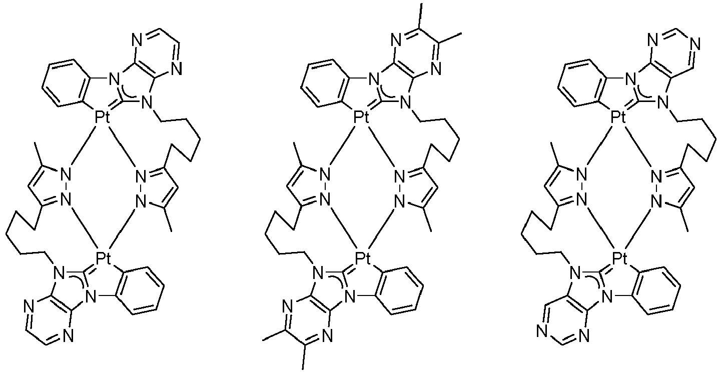

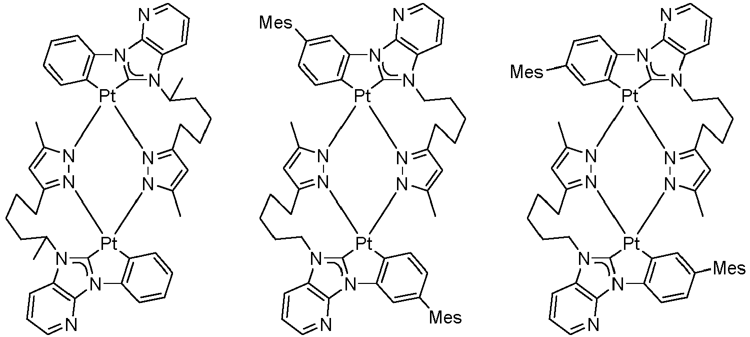

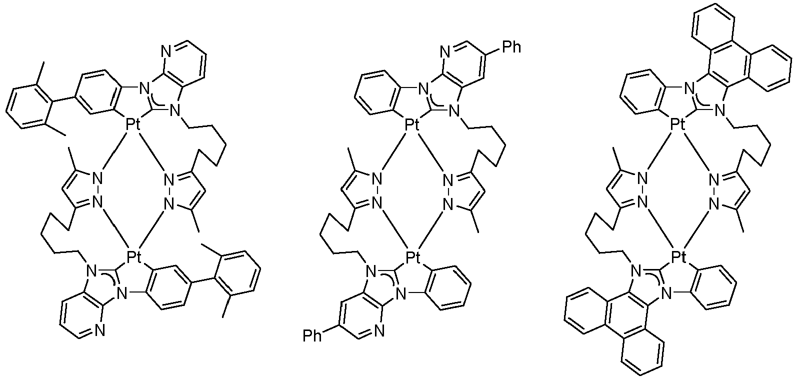

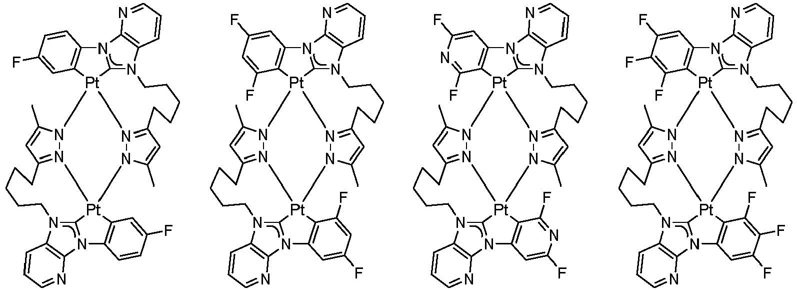

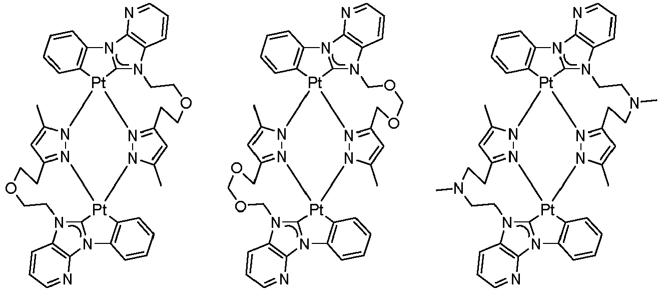

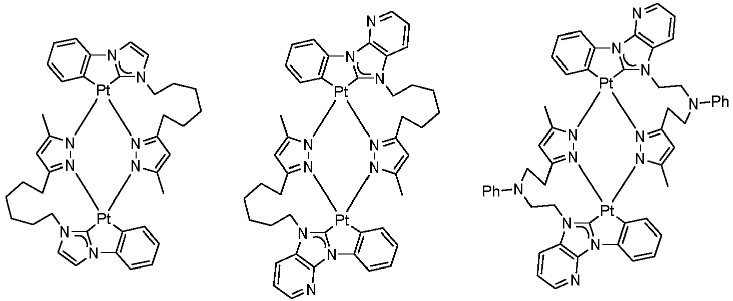

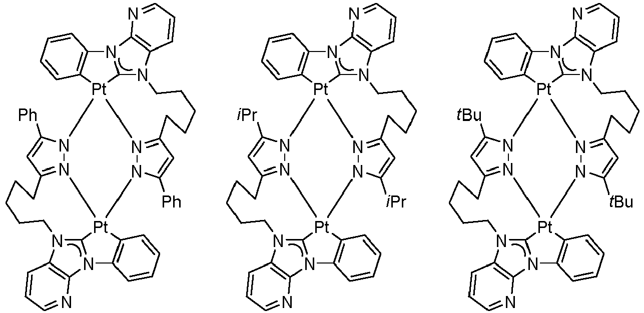

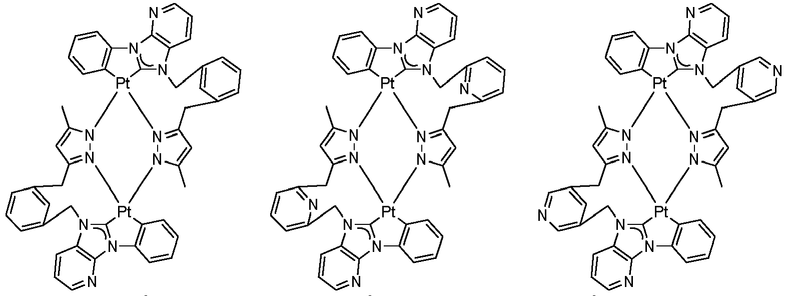

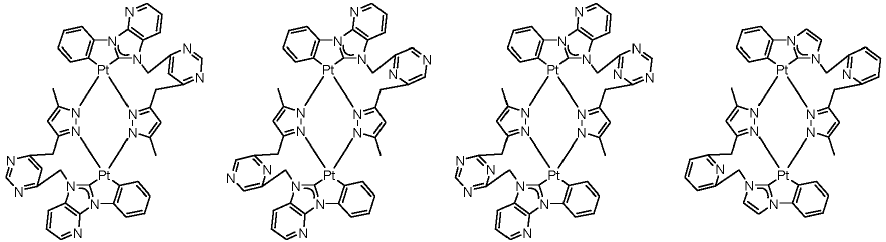

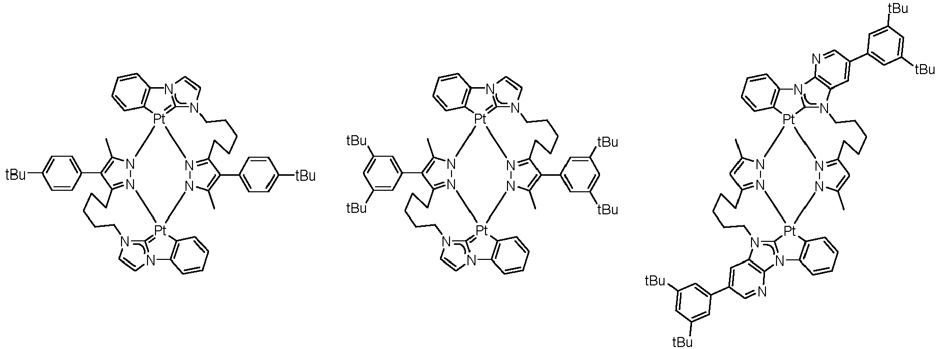

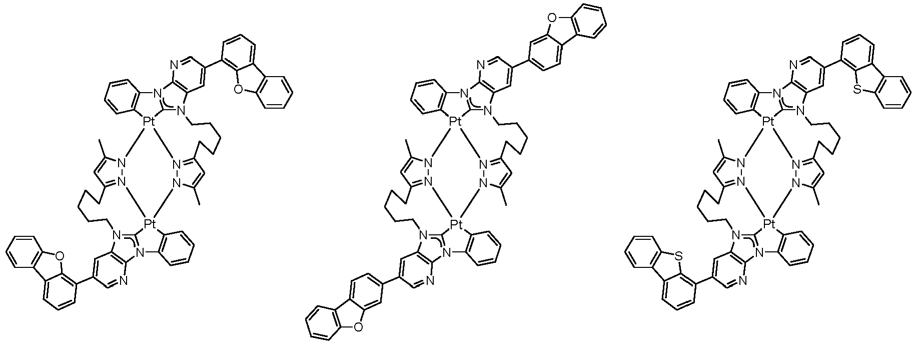

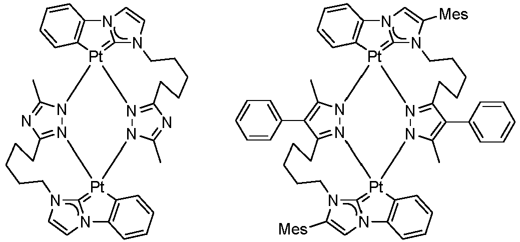

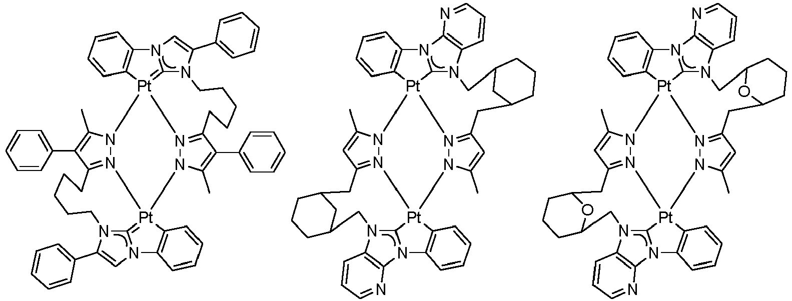

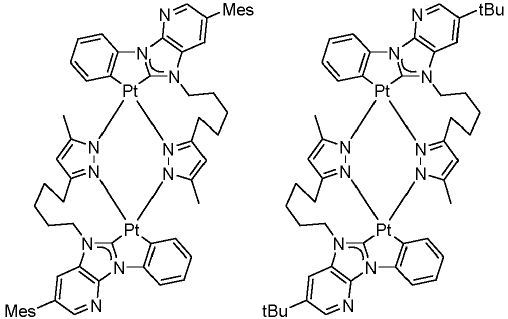

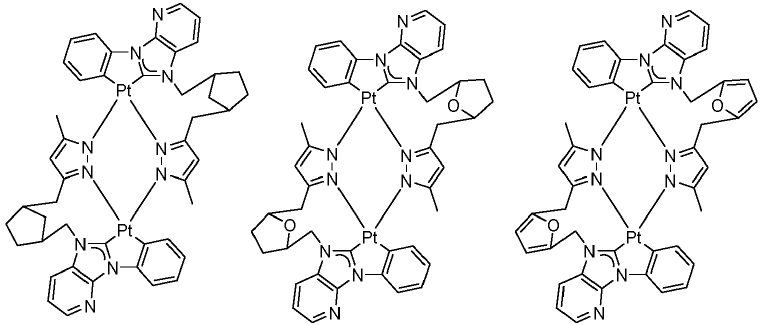

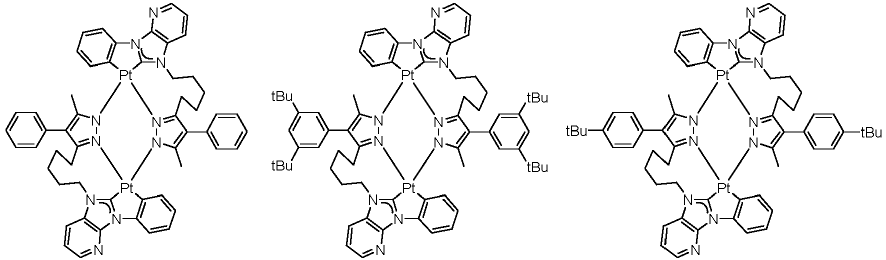

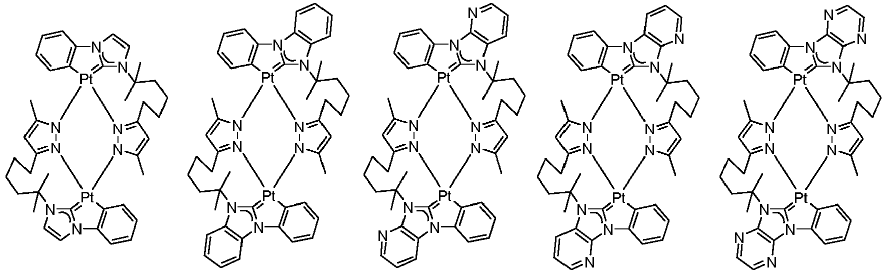

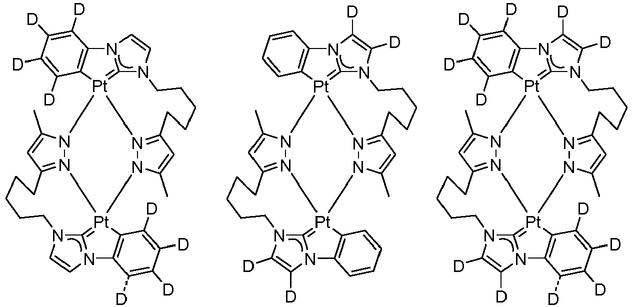

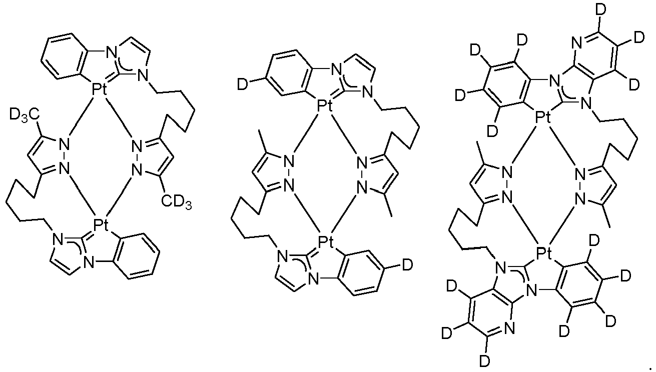

The dinuclear platinum emitter complexes described are phosphorescent and/or electroluminescent. The dinuclear platinum emitter complexes can be emissive at room temperature, low temperature, or both. The dinuclear platinum emitter complexes may be in a solid, liquid, glassy, film, or solution state. The dinuclear platinum emitter complexes can emit light in response to (i) the passage of an electric current or (ii) to an electric field. In some forms, the dinuclear platinum emitter complexes may emit light independent of concentration. The phosphorescent and/or electroluminescent properties of the dinuclear platinum emitter complexes are typically within a wavelength range of between about 380 nm and 550 nm, inclusive. In some forms, the dinuclear platinum emitter complexes preferably emit blue to deep-blue light within a wavelength range of between about 400 nm and 550 nm, inclusive, or any subrange within. The emissive properties of the dinuclear platinum emitter complexes can be tuned by way of the selection of substituents. The dinuclear platinum emitter complexes may emit exclusively or predominantly in the blue wavelength range of the visible spectrum and may contain one or two emission maxima within.

Preferably, the dinuclear platinum(II) emitter complexes described herein are photo-stable, thermally stable, and/or are emissive at room temperatures, low temperatures, or a combination thereof. Accordingly, the complexes can be incorporated into OLEDs. Such OLEDs can be used in commercial applications such visual display units, mobile visual display units, illumination units, keyboards, clothes, ornaments, garment accessories, wearable devices, medical monitoring devices, wall papers, tablet computers, laptops, advertisement panels, panel display units, household appliances, or office appliances.

### BRIEF DESCRIPTION OF THE DRAWINGS

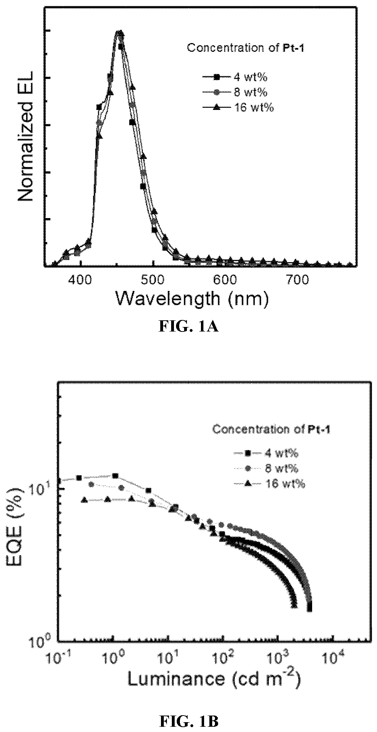

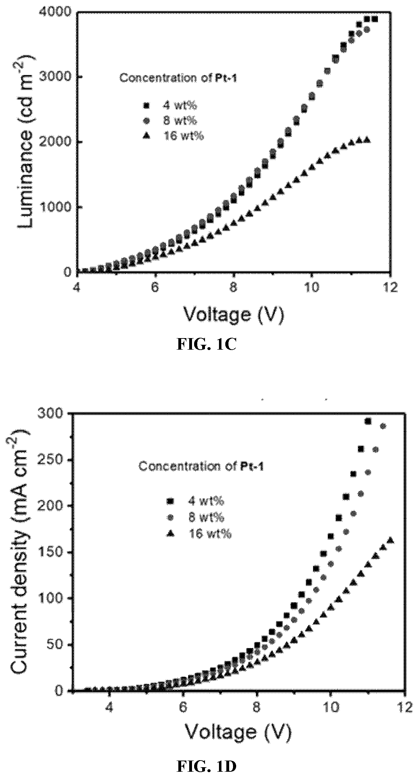

**FIGs. 1A-1D** are line graphs showing electroluminescent data for OLED fabricated with **Pt-1** with doping concentrations between 4 wt/wt% and 16 wt/wt% (such as 4 wt/wt%, 8wt/wt%, and 16 wt/wt%). The device structure is: ITO/HAT-CN(5 nm)/TAPC(40 nm)/TcTa(7 nm)/CzSi(3 nm)/**Pt-1**:CzSi (10 nm)/TSPO1(30 nm)/LiF (1 nm)/Al (100 nm).

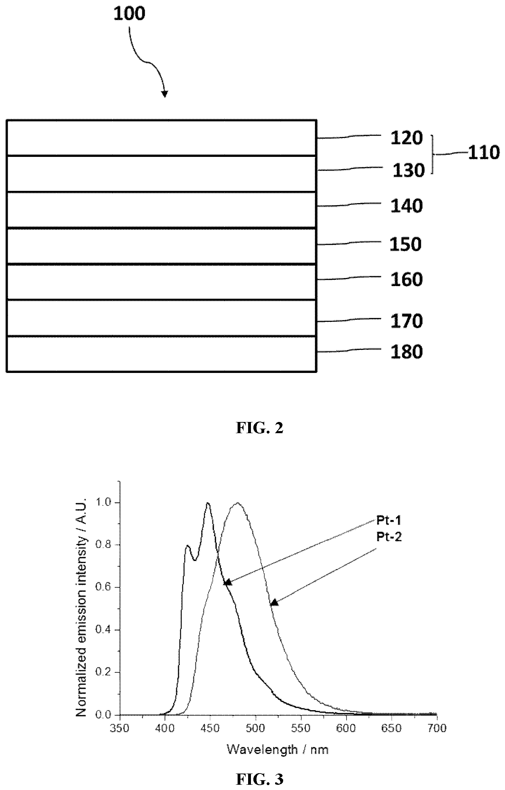

**FIG. 2** shows a non-limiting example of an organic light-emitting diode device, **100,** having a multilayer architecture. The device contains (i) a cathode **110** including a first layer **120** and a second layer **130;** (ii) an electron transporting layer **140;** (iii) an optional carrier confinement layer **150;** (iv) a light-emitting layer **160;** (v) a hole-transporting layer **170;** and (vi) an anode **180.**
**FIG. 3** is a line graph showing the emission spectra of **Pt-1** and **Pt-2** in PMMA films.

### DETAILED DESCRIPTION OF THE INVENTION

### I. Definitions

"Substituted," as used herein, refers to all permissible substituents of the compounds or functional groups described herein. In the broadest sense, the permissible substituents include acyclic and cyclic, branched and unbranched, carbocyclic and heterocyclic, aromatic and nonaromatic substituents of organic compounds. Illustrative substituents include, but are not limited to, halogens, hydroxyl groups, or any other organic groupings containing any number of carbon atoms, preferably 1-14 carbon atoms, and optionally include one or more heteroatoms such as oxygen, sulfur, or nitrogen grouping in linear, branched, or cyclic structural formats. Representative substituents include a substituted or unsubstituted alkyl, a substituted or unsubstituted alkenyl, a substituted or unsubstituted alkynyl, a substituted or unsubstituted heterocyclyl, a substituted or unsubstituted phenyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a halogen, a hydroxyl, an alkoxy, a phenoxy, an aroxy, a silyl, a thiol, an alkylthio, a substituted alkylthio, a phenylthio, an arylthio, a cyano, an isocyano, a nitro, a substituted or unsubstituted carbonyl, a carboxyl, an amino, an amido, an oxo, a sulfinyl, a sulfonyl, a sulfonic acid, a phosphonium, a phosphanyl, a phosphoryl, a phosphonyl, an amino acid. Such a substituted or unsubstituted alkyl, a substituted or unsubstituted alkenyl, a substituted or unsubstituted alkynyl, a substituted or unsubstituted heterocyclyl, a substituted or unsubstituted phenyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a halogen, a hydroxyl, an alkoxy, a phenoxy, an aroxy, a silyl, a thiol, an alkylthio, a substituted alkylthio, a phenylthio, an arylthio, a cyano, an isocyano, a nitro, a substituted or unsubstituted carbonyl, a carboxyl, an amino, an amido, an oxo, a sulfinyl, a sulfonyl, a sulfonic acid, a phosphonium, a phosphanyl, a phosphoryl, a phosphonyl, and an amino acid can be further substituted.

Heteroatoms such as nitrogen may have hydrogen substituents and/or any permissible substituents of organic compounds described herein which satisfy the valences of the heteroatoms. It is understood that "substitution" or "substituted" includes the implicit proviso that such substitution is in accordance with permitted valence of the substituted atom and the substituent, and that the substitution results in a stable compound, *i.e.,* a compound that does not spontaneously undergo transformation such as by rearrangement, cyclization, elimination, etc.

"Alkyl," as used herein, refers to the radical of saturated aliphatic groups, including straight-chain alkyl groups, branched-chain alkyl, and cycloalkyl (alicyclic). In some forms, a straight chain or branched chain alkyl has 30 or fewer carbon atoms in its backbone (e.g., C₁-C₃₀ for straight chains, C₃-C₃₀ for branched chains), 20 or fewer, 15 or fewer, or 10 or fewer. Alkyl includes methyl, ethyl, *n*-propyl, isopropyl, *n*-butyl, isobutyl, *t*-butyl, pentyl, hexyl, heptyl, octyl, decyl, tetradecyl, hexadecyl, eicosyl, tetracosyl and the like. Likewise, a cycloalkyl is a non-aromatic carbon-based ring composed of at least three carbon atoms, such as a nonaromatic monocyclic or nonaromatic polycyclic ring containing 3-30 carbon atoms, 3-20 carbon atoms, or 3-10 carbon atoms in their ring structure, and have 5, 6 or 7 carbons in the ring structure. Cycloalkyls containing a polycyclic ring system can have two or more non-aromatic rings in which two or more carbons are common to two adjoining rings (i.e., "fused cycloalkyl rings"). Examples of cycloalkyl groups include, but are not limited to, cyclopropyl, cyclobutyl, cyclopentyl, cyclohexyl, cycloheptyl, cyclooctanyl, etc.

"Substituted alkyl" refers to alkyl moieties having one or more substituents replacing a hydrogen on one or more carbons of the hydrocarbon backbone. Such substituents can be any substituents described above, e.g., halogen (such as fluorine, chlorine, bromine, or iodine), hydroxyl, carbonyl (such as a carboxyl, alkoxycarbonyl, formyl, or an acyl), thiocarbonyl (such as a thioester, a thioacetate, or a thioformate), aryl, alkoxyl, aralkyl, phosphonium, phosphanyl, phosphonyl, phosphoryl, phosphate, phosphonate, a phosphinate, amino, amido, amidine, imine, cyano, nitro, azido, oxo, sulfhydryl, thiol, alkylthio, silyl, sulfinyl, sulfate, sulfonate, sulfamoyl, sulfonamido, sulfonyl, heterocyclyl, an aromatic or heteroaromatic moiety. -NRR', wherein Rand R' are independently hydrogen, alkyl, or aryl, and wherein the nitrogen atom is optionally quaternized; -SR, wherein R is a phosphonyl, a sulfinyl, a silyl a hydrogen, an alkyl, or an aryl; -CN; -NO₂; -COOH; carboxylate; -COR, -COOR, or -CON(R)₂, wherein R is hydrogen, alkyl, or aryl; imino, silyl, ether, haloalkyl (such as -CF3, -CH₂-CF₃, -CCl₃); -CN; -NCOCOCH₂CH_{2;} -NCOCOCHCH; and -NCS; and combinations thereof.

It will be understood by those skilled in the art that the moieties substituted on the hydrocarbon chain can themselves be substituted, if appropriate. For instance, the substituents of a substituted alkyl may include halogen, hydroxy, nitro, thiols, amino, aralkyl, azido, imino, amido, phosphonium, phosphanyl, phosphoryl (including phosphonate and phosphinate), oxo, sulfonyl (including sulfate, sulfonamido, sulfamoyl and sulfonate), and silyl groups, as well as ethers, alkylthios, carbonyls (including ketones, aldehydes, carboxylates, and esters), haloalkyls, -CN and the like. Cycloalkyls can be substituted in the same manner.

Unless the number of carbons is otherwise specified, "lower alkyl" as used herein means an alkyl group, as defined above, but having from one to ten carbons, more preferably from one to six carbon atoms in its backbone structure. Likewise, "lower alkenyl" and "lower alkynyl" have similar chain lengths.

"Heteroalkyl," as used herein, refers to straight or branched chain, or cyclic carbon-containing alkyl radicals, or combinations thereof, containing at least one heteroatom on the carbon backbone. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkyl group" is a cycloalkyl group as defined above where at least one of the carbon atoms of the ring is substituted with a heteroatom such as, but not limited to, nitrogen, oxygen, sulphur, or phosphorus.

The term "alkenyl" as used herein is a hydrocarbon group of from 2 to 24 carbon atoms and structural formula containing at least one carbon-carbon double bond. Alkenyl groups include straight-chain alkenyl groups, branched-chain alkenyl, and cycloalkenyl. A cycloalkenyl is a non-aromatic carbon-based ring composed of at least three carbon atoms and at least one carbon-carbon double bond, such as a nonaromatic monocyclic or nonaromatic polycyclic ring containing 3-30 carbon atoms and at least one carbon-carbon double bond, 3-20 carbon atoms and at least one carbon-carbon double bond, or 3-10 carbon atoms and at least one carbon-carbon double bond in their ring structure, and have 5, 6 or 7 carbons and at least one carbon-carbon double bond in the ring structure. Cycloalkenyls containing a polycyclic ring system can have two or more non-aromatic rings in which two or more carbons are common to two adjoining rings (i.e., "fused cycloalkenyl rings") and contain at least one carbon-carbon double bond. Asymmetric structures such as (AB)C=C(C'D) are intended to include both the *E* and *Z* isomers. This may be presumed in structural formulae herein wherein an asymmetric alkene is present, or it may be explicitly indicated by the bond symbol C. The term "alkenyl" as used throughout the specification, examples, and claims is intended to include both "unsubstituted alkenyls" and "substituted alkenyls," the latter of which refers to alkenyl moieties having one or more substituents replacing a hydrogen on one or more carbons of the hydrocarbon backbone. The term "alkenyl" also includes "heteroalkenyl."

The term "substituted alkenyl" refers to alkenyl moieties having one or more substituents replacing one or more hydrogen atoms on one or more carbons of the hydrocarbon backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, oxo, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

"Heteroalkenyl," as used herein, refers to straight or branched chain, or cyclic carbon-containing alkenyl radicals, or combinations thereof, containing at least one heteroatom. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkenyl group" is a cycloalkenyl group where at least one of the carbon atoms of the ring is substituted with a heteroatom such as, but not limited to, nitrogen, oxygen, sulphur, or phosphorus.

The term "alkynyl group" as used herein is a hydrocarbon group of 2 to 24 carbon atoms and a structural formula containing at least one carbon-carbon triple bond. Alkynyl groups include straight-chain alkynyl groups, branched-chain alkynyl, and cycloalkynyl. A cycloalkynyl is a non-aromatic carbon-based ring composed of at least three carbon atoms and at least one carbon-carbon triple bond, such as a nonaromatic monocyclic or nonaromatic polycyclic ring containing 3-30 carbon atoms and at least one carbon-carbon triple bond, 3-20 carbon atoms and at least one carbon-carbon triple bond, or 3-10 carbon atoms and at least one carbon-carbon triple bond in their ring structure, and have 5, 6 or 7 carbons and at least one carbon-carbon triple bond in the ring structure. Cycloalkynyls containing a polycyclic ring system can have two or more non-aromatic rings in which two or more carbons are common to two adjoining rings (i.e., "fused cycloalkynyl rings") and contain at least one carbon-carbon triple bond. Asymmetric structures such as (AB)C≡C(C"D) are intended to include both the *E* and *Z* isomers. This may be presumed in structural formulae herein wherein an asymmetric alkyne is present, or it may be explicitly indicated by the bond symbol C. The term "alkynyl" as used throughout the specification, examples, and claims is intended to include both "unsubstituted alkynyls" and "substituted alkynyls," the latter of which refers to alkynyl moieties having one or more substituents replacing a hydrogen on one or more carbons of the hydrocarbon backbone. The term "alkynyl" also includes "heteroalkynyl."

The term "substituted alkynyl" refers to alkynyl moieties having one or more substituents replacing one or more hydrogen atoms on one or more carbons of the hydrocarbon backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

"Heteroalkynyl," as used herein, refers to straight or branched chain, or cyclic carbon-containing alkynyl radicals, or combinations thereof, containing at least one heteroatom. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkynyl group" is a cycloalkynyl group where at least one of the carbon atoms of the ring is substituted with a heteroatom such as, but not limited to, nitrogen, oxygen, sulphur, or phosphorus.

"Aryl," as used herein, refers to C₅-C₂₆-membered aromatic or fused aromatic ring systems. Examples of aromatic groups are benzene, naphthalene, anthracene, phenanthrene, chrysene, pyrene, corannulene, coronene, etc.

The term "substituted aryl" refers to an aryl group, wherein one or more hydrogen atoms on one or more aromatic rings are substituted with one or more substituents including, but not limited to, halogen, azide, alkyl, aralkyl, alkenyl, alkynyl, cycloalkyl, hydroxyl, alkoxy, carbonyl (such as a ketone, aldehyde, carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, imino, alkylthio, sulfate, sulfonate, sulfamoyl, sulfoxide, sulfonamido, sulfonyl, heterocyclyl, alkylaryl, haloalkyl (such as CF₃, -CH₂-CF₃, -CCl₃), -CN, aryl, heteroaryl, and combinations thereof.

"Heterocycle" and "heterocyclyl" are used interchangeably, and refer to a cyclic radical attached via a ring carbon or nitrogen atom of a non-aromatic monocyclic or polycyclic ring containing 3-30 ring atoms, 3-20 ring atoms, 3-10 ring atoms, or 5-6 ring atoms, where each ring contains carbon and one to four heteroatoms each selected from the group consisting of non-peroxide oxygen, sulfur, and N(Y) wherein Y is absent or is H, O, C₁-C₁₀ alkyl, phenyl or benzyl, and optionally containing 1-3 double bonds and optionally substituted with one or more substituents. Heterocyclyl are distinguished from heteroaryl by definition. Heterocycles can be a heterocycloalkyl, a heterocycloalkenyl, a heterocycloalkynyl, etc, such as piperazinyl, piperidinyl, piperidonyl, 4-piperidonyl, dihydrofuro[2,3-*b*]tetrahydrofuran, morpholinyl, piperazinyl, piperidinyl, piperidonyl, 4-piperidonyl, piperonyl, pyranyl, 2H-pyrrolyl, 4*H*-quinolizinyl, quinuclidinyl, tetrahydrofuranyl, 6*H*-1,2,5-thiadiazinyl. Heterocyclic groups can optionally be substituted with one or more substituents as defined above for alkyl and aryl.

The term "heteroaryl" refers to C₅-C₂₆-membered aromatic or fused aromatic ring systems, in which one or more carbon atoms on one or more aromatic ring structures have been substituted with a heteroatom. Suitable heteroatoms include, but are not limited to, oxygen, sulfur, and nitrogen. Examples of heteroaryl groups pyrrole, furan, thiophene, imidazole, oxazole, thiazole, triazole, tetrazole, pyrazole, pyridine, pyrazine, pyridazine and pyrimidine, and the like. Examples of heteroaryl rings include, but are not limited to, benzimidazolyl, benzofuranyl, benzothiofuranyl, benzothiophenyl, benzoxazolyl, benzoxazolinyl, benzthiazolyl, benztriazolyl, benztetrazolyl, benzisoxazolyl, benzisothiazolyl, benzimidazolinyl, carbazolyl, 4aH-carbazolyl, carbolinyl, chromanyl, chromenyl, cinnolinyl, decahydroquinolinyl, 2H,6H-1,5,2-dithiazinyl, furanyl, furazanyl, imidazolidinyl, imidazolinyl, imidazolyl, 1H-indazolyl, indolenyl, indolinyl, indolizinyl, indolyl, 3H-indolyl, isatinoyl, isobenzofuranyl, isochromanyl, isoindazolyl, isoindolinyl, isoindolyl, isoquinolinyl, isothiazolyl, isoxazolyl, methylenedioxyphenyl, naphthyridinyl, octahydroisoquinolinyl, 1,2,3-oxadiazolyl, 1,2,4-oxadiazolyl, 1,2,5-oxadiazolyl, 1,3,4-oxadiazolyl, oxazolidinyl, oxazolyl, oxindolyl, pyrimidinyl, phenanthridinyl, phenanthrolinyl, phenazinyl, phenothiazinyl, phenoxathinyl, phenoxazinyl, phthalazinyl, pteridinyl, purinyl, pyrazinyl, pyrazolidinyl, pyrazolinyl, pyrazolyl, pyridazinyl, pyridooxazole, pyridoimidazole, pyridothiazole, pyridinyl, pyridyl, pyrimidinyl, pyrrolidinyl, pyrrolinyl, pyrrolyl, quinazolinyl, quinolinyl, quinoxalinyl, tetrahydroisoquinolinyl, tetrahydroquinolinyl, tetrazolyl, 1,2,3-thiadiazolyl, 1,2,4-thiadiazolyl, 1,2,5-thiadiazolyl, 1,3,4-thiadiazolyl, thianthrenyl, thiazolyl, thienyl, thienothiazolyl, thienooxazolyl, thienoimidazolyl, thiophenyl and xanthenyl. One or more of the rings can be substituted as defined below for "substituted heteroaryl."

The term "substituted heteroaryl" refers to a heteroaryl group in which one or more hydrogen atoms on one or more heteroaromatic rings are substituted with one or more substituents including, but not limited to, halogen, azide, alkyl, aralkyl, alkenyl, alkynyl, cycloalkyl, hydroxyl, alkoxy, carbonyl (such as a ketone, aldehyde, carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, imino, alkylthio, sulfate, sulfonate, sulfamoyl, sulfoxide, sulfonamido, sulfonyl, heterocyclyl, alkylaryl, haloalkyl (such as CF₃, -CH₂-CF₃, -CCl₃), -CN, aryl, heteroaryl, and combinations thereof.

The term "polyaryl" refers to a chemical moiety that includes two or more fused aryl groups. When two or more fused heteroaryl groups are involved, the chemical moiety can be referred to as a "polyheteroaryl."

The term "substituted polyaryl" refers to a polyaryl in which one or more of the aryls are substituted, with one or more substituents including, but not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, alkylthio, sulfate, sulfonate, sulfamoyl, sulfoxide, sulfonamido, sulfonyl, heterocyclyl, alkylaryl, haloalkyl, -CN, aryl, heteroaryl, and combinations thereof. When a polyheteroaryl is involved, the chemical moiety can be referred to as a "substituted polyheteroaryl."

The term "cyclic ring" or "cyclic group" refers to a substituted or unsubstituted monocyclic ring or a substituted or unsubstituted polycyclic ring (such as those formed from single or fused ring systems), such as a substituted or unsubstituted cycloalkyl, a substituted or unsubstituted cycloalkenyl, a substituted or unsubstituted cycloalkynyl, or a substituted or unsubstituted heterocyclyl, that have from three to 30 carbon atoms, as geometric constraints permit. The substituted cycloalkyls, cycloalkenyls, cycloalkynyls, and heterocyclyls are substituted as defined above for the alkyls, alkenyls, alkynyls, and heterocyclyls, respectively.

The term "aralkyl" as used herein is an aryl group or a heteroaryl group having an alkyl, alkynyl, or alkenyl group as defined above attached to the aromatic group, such as an aryl, a heteroaryl, a polyaryl, or a polyheteroaryl. An example of an aralkyl group is a benzyl group.

The terms "alkoxyl" or "alkoxy," "aroxy" or "aryloxy," generally describe compounds represented by the formula -OR^{v}, wherein R^{v} includes, but is not limited to, a substituted or unsubstituted alkyl, a substituted or unsubstituted alkenyl, a substituted or unsubstituted alkynyl, a substituted or unsubstituted cycloalkyl, a substituted or unsubstituted heterocyclyl, a substituted or unsubstituted cycloalkenyl, a substituted or unsubstituted heterocycloalkenyl, a substituted or unsubstituted aryl, a substituted or unsubstituted heteroaryl, a substituted or unsubstituted polyaryl, a substituted or unsubstituted polyheteroaryl, a substituted or unsubstituted arylalkyl, a substituted or unsubstituted heteroalkyl, a substituted or unsubstituted alkylaryl, a substituted or unsubstituted alkylheteroaryl, a substituted or unsubstituted aralkyl, a substituted or unsubstituted carbonyl, a phosphonium, a phosphanyl, a phosphonyl, a sulfinyl, a silyl, a thiol, an amido, and an amino. Exemplary alkoxyl groups include methoxy, ethoxy, propyloxy, tert-butoxy and the like. A "lower alkoxy" group is an alkoxy group containing from one to six carbon atoms. An "ether" is two functional groups covalently linked by an oxygen as defined below. Accordingly, the substituent of an alkyl that renders that alkyl an ether is or resembles an alkoxyl, such as can be represented by one of -O-alkyl, -O-alkenyl, -O-alkynyl, -O-arakyl, -O-aryl, -O-heteroaryl, -O-polyaryl, -O-polyheteroaryl, -O-heterocyclyl, etc.

The term "substituted alkoxy" refers to an alkoxy group having one or more substituents replacing one or more hydrogen atoms on one or more carbons of the alkoxy backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, oxo, sulfate, sulfonate, sulfamoyl, sulfonamido, sulfonyl, heterocyclyl, alkylaryl, haloalkyl, -CN, aryl, heteroaryl, and combinations thereof.

The term "ether" as used herein is represented by the formula A²OA¹, where A² and A¹ can be, independently, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl, a substituted or unsubstituted polyaryl, a substituted or unsubstituted polyheteroaryl, a phosphonium, a phosphanyl, a phosphonyl, a sulfinyl, a silyl, a thiol, a substituted or unsubstituted carbonyl, an alkoxy, an amido, or an amino, described above.

The term "polyether" as used herein is represented by the formula: 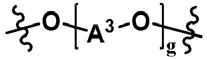 where A³ can be, independently, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl, a substituted or unsubstituted polyaryl, a substituted or unsubstituted polyheteroaryl, a phosphonium, a phosphanyl, a substituted or unsubstituted carbonyl, an alkoxy, an amido, or an amino, described above; g can be a positive integer from 1 to 30.

The term "phenoxy" is art recognized and refers to a compound of the formula -OR^{v} wherein R^{v} is C₆H₅ (*i.e.,* -O-C₆H₅). One of skill in the art recognizes that a phenoxy is a species of the aroxy genus.

The term "substituted phenoxy" refers to a phenoxy group, as defined above, having one or more substituents replacing one or more hydrogen atoms on one or more carbons of the phenyl ring. Such substituents include, but are not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, and combinations thereof.

The terms "aroxy" and "aryloxy," as used interchangeably herein, are represented by -O-aryl or -O-heteroaryl, wherein aryl and heteroaryl are as defined herein.

The terms "substituted aroxy" and "substituted aryloxy," as used interchangeably herein, represent -O-aryl or -O-heteroaryl, having one or more substituents replacing one or more hydrogen atoms on one or more ring atoms of the aryl and heteroaryl, as defined herein. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

The term "amino" as used herein includes the group 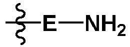 (primary amino), 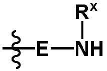 (secondary amino), 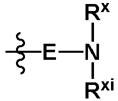 (tertiary amino), and 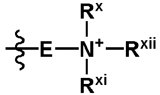 (quaternary amino),
wherein, E is absent, or E is substituted or unsubstituted alkyl, substituted or unsubstituted alkenyl, substituted or unsubstituted alkynyl, substituted or unsubstituted aralkyl, substituted or unsubstituted aryl, substituted or unsubstituted heteroaryl, a substituted or unsubstituted polyaryl, a substituted or unsubstituted polyheteroaryl, substituted or unsubstituted heterocyclyl, wherein independently of E, R^{x}, R^{xi}, and R^{xii} each independently represent a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or -(CH₂)ₘ-R‴; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. The term "quaternary amino" also includes the groups where the nitrogen, R^{x}, R^{xi}, and R^{xii} with the N⁺ to which they are attached complete a heterocyclyl or heteroaryl having from 3 to 14 atoms in the ring structure. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The terms "amide" or "amido" are used interchangeably, refer to both "unsubstituted amido" and "substituted amido" and are represented by the general formula: 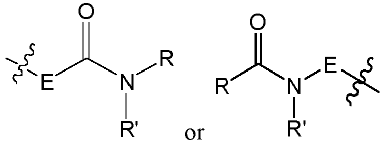 wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted aryl, substituted or unsubstituted heteroaryl, a substituted or unsubstituted polyaryl, a substituted or unsubstituted polyheteroaryl, or a substituted or unsubstituted heterocyclyl, wherein independently of E, R and R' each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or -(CH₂)ₘ-R‴, or R and R' taken together with the N atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. In some forms, when E is oxygen, a carbamate is formed. It is understood by those of ordinary skill in the art, that the E groups listed above are divalent (e.g., methylene, ethane-1,2-diyl, ethene-1,2-diyl, 1,4-phenylene, cyclohexane-1,2-diyl).

"Carbonyl," as used herein, is art-recognized and includes such moieties as can be represented by the general formula: 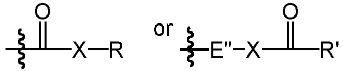 wherein X is a bond, or represents an oxygen or a sulfur, and R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or -(CH₂)ₘ-R", or a pharmaceutical acceptable salt; E" is absent, or E" is a substituted or unsubstituted alkyl, a substituted or unsubstituted alkenyl, a substituted or unsubstituted alkynyl, a substituted or unsubstituted aralkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl; R' represents a hydrogen, a substituted or unsubstituted alkyl, a substituted or unsubstituted alkenyl, a substituted or unsubstituted alkynyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or -(CH₂)ₘ-R"; R" represents a hydroxyl group, a substituted orunsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, and combinations thereof. It is understood by those of ordinary skill in the art, that the E" groups listed above are divalent (e.g., methylene, ethane-1,2-diyl, ethene-1,2-diyl, 1,4-phenylene, cyclohexane-1,2-diyl). Where X is oxygen and R is defined as above, the moiety is also referred to as a carboxyl group. When X is oxygen and R is hydrogen, the formula represents a "carboxylic acid." Where X is oxygen and R' is hydrogen, the formula represents a "formate." Where X is oxygen and R or R' is not hydrogen, the formula represents an "ester." In general, where the oxygen atom of the above formula is replaced by a sulfur atom, the formula represents a "thiocarbonyl" group. Where X is sulfur and R or R' is not hydrogen, the formula represents a "thioester." Where X is sulfur and R is hydrogen, the formula represents a "thiocarboxylic acid." Where X is sulfur and R' is hydrogen, the formula represents a "thioformate." Where X is a bond and R is not hydrogen, the above formula represents a "ketone." Where X is a bond and R is hydrogen, the above formula represents an "aldehyde."

The term "phosphanyl" is represented by the formula 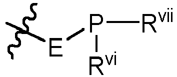 wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted cycloalkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, R^{vi} and R^{vii} each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or -(CH₂)ₘ-R‴, or R^{vi} and R^{vii} taken together with the P atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphonium" is represented by the formula 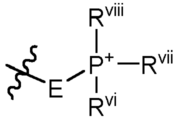 wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted cycloalkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, R^{vi}, R^{vii}, and R^{viii} each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or -(CH₂)ₘ-R‴, or R^{vi}, R^{vii}, and R^{viii} taken together with the P⁺ atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphonyl" is represented by the formula 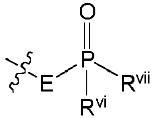 wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, oxygen, alkoxy, aroxy, or substituted alkoxy or substituted aroxy, wherein, independently of E, R^{vi} and R^{vii} are independently a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or -(CH₂)ₘ-R‴, or R^{vi} and R^{vii} taken together with the P atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphoryl" defines a phosphonyl in which E is absent, oxygen, alkoxy, aroxy, substituted alkoxy or substituted aroxy, as defined above, and independently of E, R^{vi} and R^{vii} are independently hydroxyl, alkoxy, aroxy, substituted alkoxy or substituted aroxy, as defined above. When E is oxygen, the phosphoryl cannot be attached to another chemical species, such as to form an oxygen-oxygen bond, or other unstable bonds, as understood by one of ordinary skill in the art. When E, R^{vi} and R^{vii} are substituted, the substituents include, but are not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfinyl" is represented by the formula 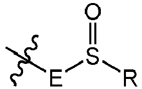 wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted heterocyclyl, a substituted or unsubstituted polyaryl, a substituted or unsubstituted polyheteroaryl, wherein independently of E, R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a silyl, a thiol, an amido, an amino, or -(CH₂)ₘ-R‴, or E and R taken together with the S atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonyl" is represented by the formula 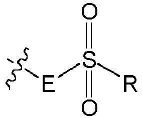 wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted heterocyclyl, a substituted or unsubstituted polyaryl, a substituted or unsubstituted polyheteroaryl, wherein independently of E, R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or -(CH₂)ₘ-R‴, or E and R taken together with the S atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonic acid" refers to a sulfonyl, as defined above, wherein R is hydroxyl, and E is absent, or E is substituted or unsubstituted cycloalkyl, substituted or unsubstituted heterocyclyl, substituted or unsubstituted alkylaryl, substituted or unsubstituted arylalkyl, substituted or unsubstituted aryl, a substituted or unsubstituted polyaryl, a substituted or unsubstituted polyheteroaryl, or substituted or unsubstituted heteroaryl. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfate" refers to a sulfonyl, as defined above, wherein E is absent, oxygen, alkoxy, aroxy, substituted alkoxy or substituted aroxy, as defined above, and R is independently hydroxyl, alkoxy, aroxy, substituted alkoxy or substituted aroxy, as defined above. When E is oxygen, the sulfate cannot be attached to another chemical species, such as to form an oxygen-oxygen bond, or other unstable bonds, as understood by one of ordinary skill in the art. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonate" refers to a sulfonyl, as defined above, wherein E is oxygen, alkoxy, aroxy, substituted alkoxy or substituted aroxy, as defined above, and R is independently hydrogen, substituted or unsubstituted alkyl, substituted or unsubstituted alkenyl, substituted or unsubstituted alkynyl, substituted or unsubstituted amino, substituted or unsubstituted cycloalkyl, substituted or unsubstituted heterocyclyl, substituted or unsubstituted aralkyl, substituted or unsubstituted alkylaryl, substituted or unsubstituted arylalkyl, substituted or unsubstituted aryl, substituted or unsubstituted heteroaryl, a substituted or unsubstituted polyaryl, a substituted or unsubstituted polyheteroaryl, -(CH₂)ₘ-R‴, R‴ represents a hydroxy group, substituted or unsubstituted carbonyl group, an aryl, a cycloalkyl ring, a cycloalkenyl ring, a heterocycle, an amido, an amino, or a polycycle; and m is zero or an integer ranging from 1 to 8. When E is oxygen, sulfonate cannot be attached to another chemical species, such as to form an oxygen-oxygen bond, or other unstable bonds, as understood by one of ordinary skill in the art. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfamoyl" refers to a sulfonamide or sulfonamide represented by the formula 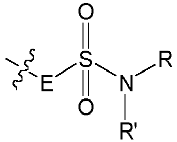 wherein E is absent, or E is substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted cycloalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, R and R' each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or -(CH₂)ₘ-R‴, or Rand R' taken together with the N atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "silyl group" as used herein is represented by the formula -SiRR'R," where R, R', and R" can be, independently, a hydrogen, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl (e.g. a substituted or unsubstituted alkylaryl, a substituted or unsubstituted arylalkyl, etc.), a substituted or unsubstituted polyaryl, a substituted or unsubstituted polyheteroaryl, a substituted or unsubstituted carbonyl, a phosphonium, a phosphanyl, a phosphonyl, a sulfinyl, a thiol, an amido, an amino, an alkoxy, or an oxo, described above. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

The terms "thiol" are used interchangeably and are represented by -SR, where R can be a hydrogen, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl (e.g. a substituted or unsubstituted alkylaryl, a substituted or unsubstituted arylalkyl, etc.), a substituted or unsubstituted polyaryl, a substituted or unsubstituted polyheteroaryl, a substituted or unsubstituted carbonyl, a phosphonium, a phosphanyl, an amido, an amino, an alkoxy, an oxo, a phosphonyl, a sulfinyl, or a silyl, described above. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, -CN, aryl, heteroaryl, polyaryl, polyheteroaryl, and combinations thereof.

The disclosed compounds and substituent groups, can, independently, possess two or more of the groups listed above. For example, if the compound or substituent group is a straight chain alkyl group, one of the hydrogen atoms of the alkyl group can be substituted with a hydroxyl group, an alkoxy group, etc. Depending upon the groups that are selected, a first group can be incorporated within second group or, alternatively, the first group can be pendant (*i.e.,* attached) to the second group. For example, with the phrase "an alkyl group comprising an ester group," the ester group can be incorporated within the backbone of the alkyl group. Alternatively, the ester can be attached to the backbone of the alkyl group. The nature of the group(s) that is (are) selected will determine if the first group is embedded or attached to the second group.

The compounds and substituents can be substituted, independently, with the substituents described above in the definition of "substituted."

The numerical ranges disclose individually each possible number that such a range could reasonably encompass, as well as any sub-ranges and combinations of sub-ranges encompassed therein. For example, in a given range carbon range of C₃-C₉, the range also discloses C₃, C₄, C₅, C₆, C₇, C₈, and C₉, as well as any subrange between these numbers (for example, C₄ -C₆), and any possible combination of ranges possible between these values. In yet another example, a given temperature range may be from about 25 °C to 30 °C, where the range also discloses temperatures that can be selected independently from about 25, 26, 27, 28, 29, and 30 °C, as well as any range between these numbers (for example, 26 to 28 °C), and any possible combination of ranges between these values.

Use of the term "about" is intended to describe values either above or below the stated value, which the term "about" modifies, to be within a range of approximately +/- 10%. When the term "about" is used before a range of numbers (*i.e.,* about 1-5) or before a series of numbers (*i.e.,* about 1, 2, 3, 4, etc.) it is intended to modify both ends of the range of numbers and/or each of the numbers recited in the entire series, unless specified otherwise.

The disclosed compounds and substituent groups, can, independently, possess two or more of the groups listed above. For example, if the compound or substituent group is a straight chain alkyl group, one of the hydrogen atoms of the alkyl group can be substituted with a hydroxyl group, an alkoxy group, etc. Depending upon the groups that are selected, a first group can be incorporated within second group or, alternatively, the first group can be pendant (*i.e.,* attached) to the second group. For example, with the phrase "an alkyl group comprising an ester group," the ester group can be incorporated within the backbone of the alkyl group. Alternatively, the ester can be attached to the backbone of the alkyl group. The nature of the group(s) that is (are) selected will determine if the first group is embedded or attached to the second group.

The compounds and substituents can be substituted with, independently, with the substituents described above in the definition of "substituted."

### II. Compositions

Described are a class of dinuclear cyclometalated platinum(II) carbene emitters complexes with a tridentate CCN ligand. The disclosed compounds can be produced via a single step of metalation, and preferably possess low CIE-y values down to about 0.07. Without wishing to be bound by theory, it is believed that the increased denticity, with respect to monodentate and bidentate ligands, increases device stability by preventing emitter degradation.

The disclosed compounds have a structure: 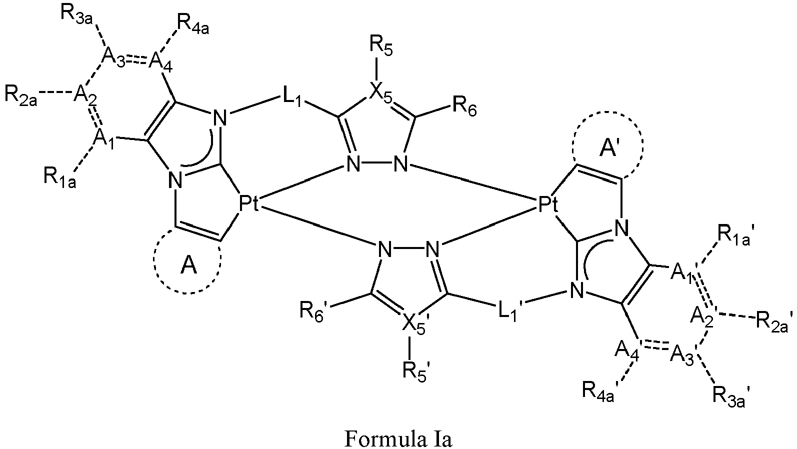 wherein:
the compound has an overall neutral, negative, or positive charge,
the dashed linear lines denote the presence or absence of a bond,
A and A' are independently a substituted cycloalkyl, an unsubstituted cycloalkyl, a substituted cycloalkenyl, an unsubstituted cycloalkenyl, a substituted cycloalkynyl, an unsubstituted cycloalkynyl, a substituted C₁-C₂₀ heterocyclyl, an unsubstituted C₁-C₂₀ heterocyclyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, or fused combinations thereof; preferably A and A' are independently a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, or fused combinations thereof;
X₅, and X_{5'} are independently carbon or nitrogen, and are independently bonded to one or no hydrogen atom according to valency, preferably, X₅ and X_{5'} are carbon,
R₅, R₆, R_{5'}, and R_{6'} are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, unsubstituted C₃-C₂₀ cycloalkynyl, or R₅ and R₆ together, R_{5'} and R_{6'} together, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, fused combinations thereof, preferably R₅, R₆, R_{5'}, and R_{6'} are independently absent, hydrogen, substituted alkyl, unsubstituted alkyl, substituted aryl, unsubstituted aryl,
A₁, A₂, A₃, A₄, A_{1'}, A_{2'}, A_{3'}, and A_{4'} are independently absent, hydrogen, deuterium, carbon, nitrogen, unsubstituted aryl, or substituted aryl, and, when present, are independently bonded to one, two, three, four, five, or no hydrogen atom according to valency,
R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, unsubstituted C₃-C₂₀ cycloalkynyl, a fused combination thereof (such as dibenzofuran-4-yl, dibenzofuran-3-yl, dibenzothiopen-4-yl, dibenzothiopen-3-yl, *etc.*), or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, fused combinations thereof, or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, fused combinations thereof, and
L₁ and L_{1'} are independently substituted alkyl, unsubstituted alkyl, substituted alkenyl, unsubstituted alkenyl, substituted alkynyl, unsubstituted alkynyl, unsubstituted alkoxy, substituted alkoxy, unsubstituted aroxy, substituted aroxy, unsubstituted alkylthio, substituted alkylthio, unsubstituted carbonyl, substituted carbonyl, unsubstituted carboxyl, substituted carboxyl, unsubstituted ester, substituted ester, unsubstituted ether, substituted ether, unsubstituted polyether, substituted polyether, substituted amino, unsubstituted amino, substituted amide, unsubstituted amide, substituted aryl, unsubstituted aryl, substituted heteroaryl, unsubstituted heteroaryl, substituted polyaryl, unsubstituted polyaryl, substituted polyheteroaryl, unsubstituted polyheteroaryl, substituted C₃-C₂₀ cycloalkyl, unsubstituted C₃-C₂₀ cycloalkyl, substituted Ci-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, unsubstituted C₃-C₂₀ cycloalkynyl, or fused combinations thereof. In some forms, L₁ and L₁' are independently substituted alkyl or unsubstituted alkyl. In some forms, L₁ and L₁' are independently substituted C₁-C₁₀ alkyl or unsubstituted C₁-C₁₀ alkyl. In some forms, L₁ and L₁' are independently substituted C₂-C₁₀ alkyl or unsubstituted C₂-C₁₀ alkyl. In some forms of L₁ and L₁' the substituted alkyl, substituted C₁-C₁₀ alkyl, or substituted C₂-C₁₀ alkyl contains one or more alkyl substituents (such as methyl, ethyl, propyl, *iso-*propyl, n-butyl, *sec*-butyl, *tert-*butyl), one or more ether bonds, one or more amine groups (such as substitut*e*d amine or unsubstituted amine), one or more substituted aryl groups, one or more substituted heteroaryl groups, one or more substituted C₃-C₂₀ cycloalkyl groups, one or more substituted C₁-C₂₀ heterocyclyl groups, or a combination thereof. In some forms, the compound is fluorine-free, *i.e.,* not covalently bonded to a fluorine atom. It is to be understood that Li and L_{1'} are at least divalent. Without wishing to be bound by theory, fluorine-containing emitter complexes have poorer thermal and electrochemical stability. For example, cleavage of fluorine happens during the sublimation process. This means that the stability of fluorine-containing emitter in electroluminescent devices can be decreased and hence device lifetime can be shortened.

In some forms, the compound is as described above for Formula Ia, except that the compound has a structure: 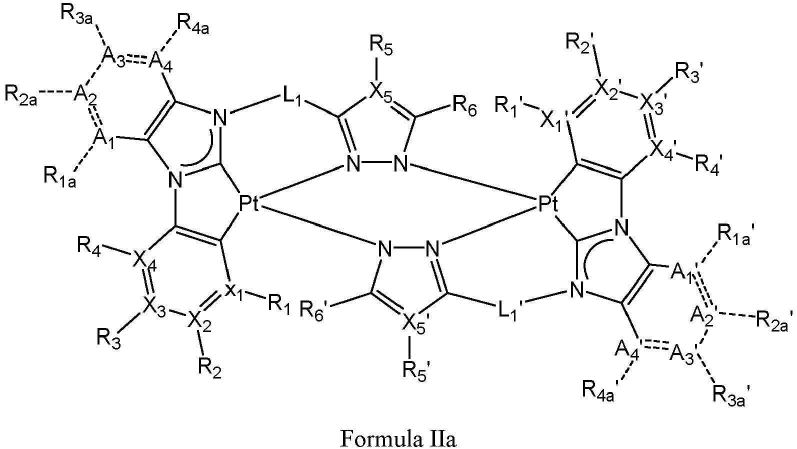 or 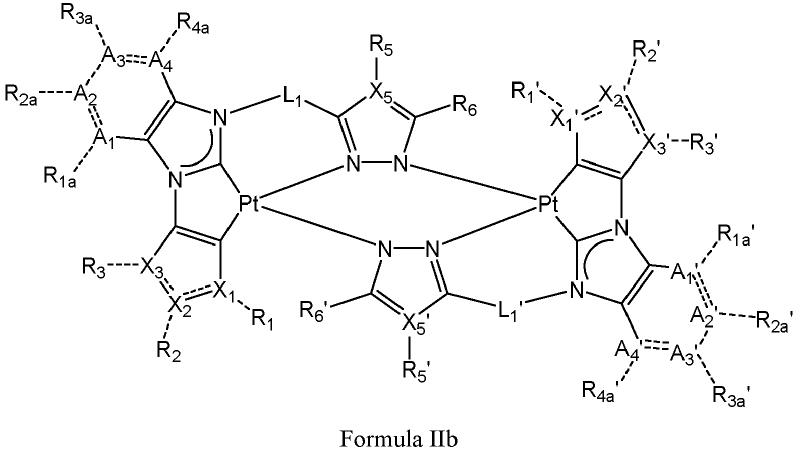 wherein:
the dashed linear lines denote the presence or absence of a bond,
(i) A₁, A₂, A₃, A₄, A_{1'}, A_{2'}, A_{3'}, and A_{4'}, (ii) R₁ₐ, R₂ₐ, R₃ₐ, R₄ₐ, R_{1a'}, R_{2a'}, R_{3a'}, and R_{4a'}, (iii) Li and L_{1'}, and (iv) X₅, X_{5'}, R₅, R₆, R_{5'}, and R_{6'} are as described above for Formula Ia,
X₁, X₂, X₃, X₄, X_{1'}, X_{2'}, X_{3'}, and X_{4'} when present, are independently carbon, nitrogen, oxygen, or sulfur, and are independently bonded to one or no hydrogen atom according to valency,
R₁, R₂, R₃, R₄, R_{1'}, R_{2'}, R_{3'}, and R_{4'} are independently absent, deuterium, hydrogen, substituted alkyl (such as trifluoromethyl), unsubstituted alkyl, substituted alkenyl, unsubstituted alkenyl, substituted alkynyl, unsubstituted alkynyl, substituted aryl (such as mesityl (2,4,6-trimethylphenyl), *3,5-di-tert-*butylphenyl, 2,6-dimethylphenyl), unsubstituted aryl, halogen (such as fluorine), hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, or unsubstituted C₃-C₂₀ cycloalkynyl, or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, or fused combinations thereof. In some forms, R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted aryl (such as mesityl (2,4,6-trimethylphenyl), 3,5-di-*tert-*butylphenyl, 2,6-dimethylphenyl), unsubstituted aryl, halogen (such as fluorine), or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof.

In some forms, the compound is as described above for Formula Ia, IIa, or IIb, except that the compound has a structure: 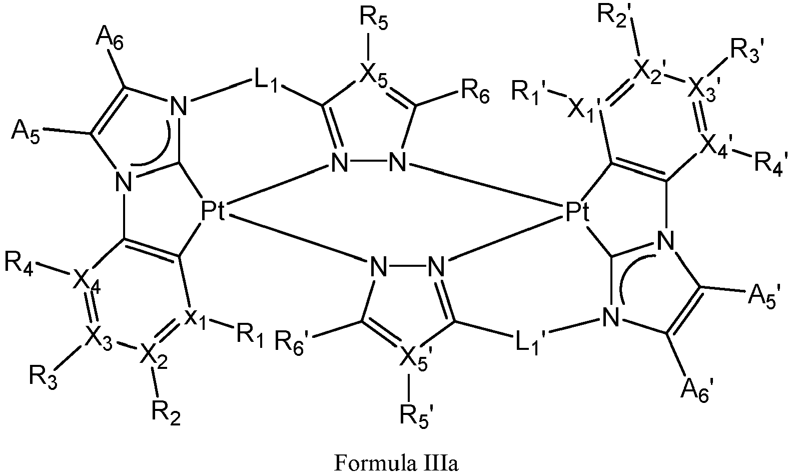 or 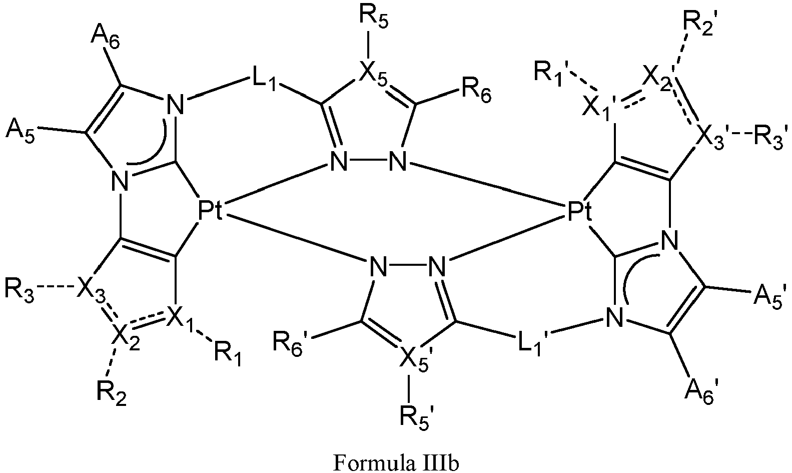 wherein:
the dashed linear lines denote the presence or absence of a bond,
A₅, A₆, A_{5'}, and A_{6'} are independently hydrogen, deuterium, unsubstituted alkyl, substituted alkyl, substituted aryl, unsubstituted aryl, unsubstituted heteroaryl, substituted heteroaryl, unsubstituted polyheteroaryl, substituted polyheteroaryl, substituted C₁-C₂₀ heterocyclyl, or unsubstituted Ci-C₂₀ heterocyclyl; or preferably hydrogen, unsubstituted alkyl, substituted alkyl, deuterium, substituted aryl, or unsubstituted aryl. In some forms, A₅, A₆, A_{5'}, and A_{6'} are hydrogen or deuterium. In some forms, A₅, A₆, A_{5'}, and A_{6'} are unsubstituted alkyl (such as unsubstituted C₁-C₁₀ alkyl, unsubstituted C₁-C₅ alkyl, or unsubstituted C₁-C₃ alkyl) or substituted alkyl (such as substituted Ci-C₁₀ alkyl, substituted C₁-C₅ alkyl, or substituted C₁-C₃ alkyl). In some forms, A₅, A₆, A_{5'}, and A_{6'} are hydrogen, substituted aryl, or unsubstituted aryl, with the proviso at least one of A₅ and A₆, or A_{5'} and A_{6'} is substituted aryl or unsubstituted aryl.

In some forms, the compound is as described above for Formula IIa or IIIa, except that X₁, X₂, X₃, X₄, X_{1'}, X_{2'}, X_{3'}, and X_{4'} are carbon, and are independently bonded to one or no hydrogen atom according to valency.

In some forms, the compound is as described above for Formula IIa or IIIa, except that one or more of X₁, X₂, X₃, X₄, and one or more of X_{1'}, X_{2'}, X_{3'}, and X_{4'} are nitrogen, and X₁, X₂, X₃, X₄, X_{1'}, X_{2'}, X_{3'}, and X_{4'} are independently bonded to one or no hydrogen atom according to valency. In some forms, the compound is as described above for Formula IIa or IIIa, except that X₂ and X_{2'} are nitrogen, X₁, X₃, X₄, X_{1'}, X_{3'}, and X_{4'} are carbon, and X₁, X₂, X₃, X₄, X_{1'}, X_{2'}, X_{3'}, and X_{4'} are independently bonded to one or no hydrogen atom according to valency.

In some forms, the compound is as described above for Formula IIa or IIIa, except that R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted aryl (such as mesityl (2,4,6-trimethylphenyl), *3,5-di-tert-*butylphenyl, 2,6-dimethylphenyl), unsubstituted aryl, halogen (such as fluorine), or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof.

In some forms, the compound is as described above for Formula IIa or IIIa, except that R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted aryl (such as mesityl (2,4,6-trimethylphenyl), *3,5-di-tert-*butylphenyl, 2,6-dimethylphenyl), unsubstituted aryl, or halogen (such as fluorine).

In some forms, the compound is as described above for Formula IIa or IIIa, except that R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof. In some forms, R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form: 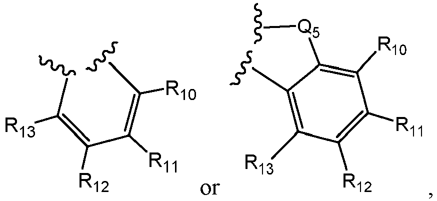 wherein Q₅ can be NR₁₄, carbon, or sulfur, or oxygen; and R₁₀-R₁₄ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted C₁-C₂₀ heterocyclyl, or unsubstituted C₁-C₂₀ heterocyclyl. In some forms, Q₅ can be NR₁₄, carbon, or sulfur, or oxygen, such as oxygen; and R₁₀-R₁₄ can be independently absent, hydrogen, substituted alkyl, or unsubstituted alkyl. In some forms, Q₅ can be oxygen; and R₁₀-R₁₄ can be hydrogen.

In some forms, the compound is as described above for Formula IIb or IIIb, except that one or more of X₁, X₂, and X₃, and one or more of X_{1'}, X_{2'} and X_{3'} are sulfur, oxygen, or nitrogen, and X₁, X₂, X₃, X_{1'}, X_{2'}, and X_{3'} are independently bonded to one or no hydrogen atom according to valency. In some forms, the compound is as described above for Formula IIb or IIIb, except that one or more of X₁, X₂, and X₃, and one or more of X_{1'}, X_{2'} and X_{3'} are sulfur and X₁, X₂, X₃, X_{1'}, X_{2'}, and X_{3'} are independently bonded to one or no hydrogen atom according to valency. In some forms, the compound is as described above for Formula IIb or IIIb, except that one of X₁, X₂, and X₃, and one of X_{1'}, X_{2'} and X_{3'} are sulfur and X₁, X₂, X₃, X_{1'}, X_{2'}, and X_{3'} are independently bonded to one or no hydrogen atom according to valency.

In some forms, the compound is as described above for Formula IIb or IIIb, except that one or more of X₁, X₂, and X₃, and one or more of X_{1'}, X_{2'} and X_{3'}, are oxygen, and X₁, X₂, X₃, X_{1'}, X_{2'}, and X_{3'} are independently bonded to one or no hydrogen atom according to valency. In some forms, the compound is as described above for Formula IIb or IIIb, except that one of X₁, X₂, and X₃, and one of X_{1'}, X_{2'} and X_{3'}, are oxygen, and X₁, X₂, X₃, X_{1'}, X_{2'}, and X_{3'} are independently bonded to one or no hydrogen atom according to valency.

In some forms, the compound is as described above for Formula IIb or IIIb, except that R₁, R₂, R₃, R_{1'}, R_{2'}, and R_{3'} are independently absent, hydrogen, substituted alkyl, unsubstituted alkyl, substituted aryl, unsubstituted aryl, halogen, or R₁ and R₂ together, R₂ and R₃ together, R_{1'} and R_{2'} together, R_{2'} and R_{3'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted Ci-C₂₀ heterocyclyl, or fused combinations thereof.

In some forms, the compound is as described above for Formula IIb or IIIb, except that R₁, R₂, R₃, R_{1'} , R_{2'}, and R_{3'} are hydrogen, substituted alkyl, unsubstituted alkyl, substituted aryl, unsubstituted aryl, halogen. In some forms, the compound is as described above for Formula IIb or IIIb, except that R₁, R₂, R₃, R_{1'}, R_{2'}, and R_{3'} are absent, hydrogen, or a combination thereof.

In some forms, the compound is as described above for Formula IIb or IIIb, except that R₁ and R₂ together, R₂ and R₃ together, R_{1'} and R_{2'} together, R_{2'} and R_{3'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof. In some forms, the compound is as described above for Formula IIb or IIIb, except that R₁ and R₂ together, R₂ and R₃ together, R_{1'} and R_{2'} together, R_{2'} and R_{3'} together, or a combination thereof, with the atom to which they are attached, form: 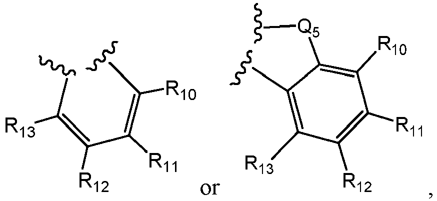 wherein Q₅ can be NR₁₄, carbon, or sulfur, or oxygen; and R₁₀-R₁₄ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted C₁-C₂₀ heterocyclyl, or unsubstituted C₁-C₂₀ heterocyclyl. In some forms, Q₅ can be NR₁₄, carbon, or sulfur, or oxygen, such as sulfur, and R₁₀-R₁₄ can be independently absent, hydrogen, substituted alkyl, or unsubstituted alkyl. In some forms, Q₅ can be sulfur; and R₁₀-R₁₄ can be hydrogen.

In some forms, the compound is as described above for Formula Ia, IIa, or IIb, except that the compound has a structure: 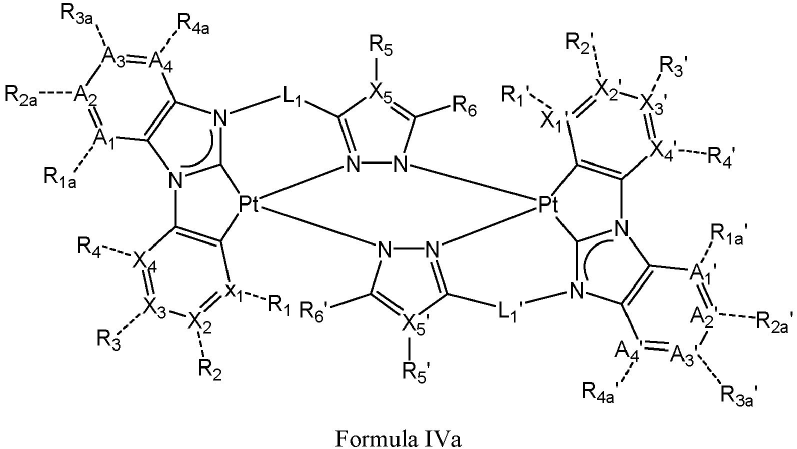 or 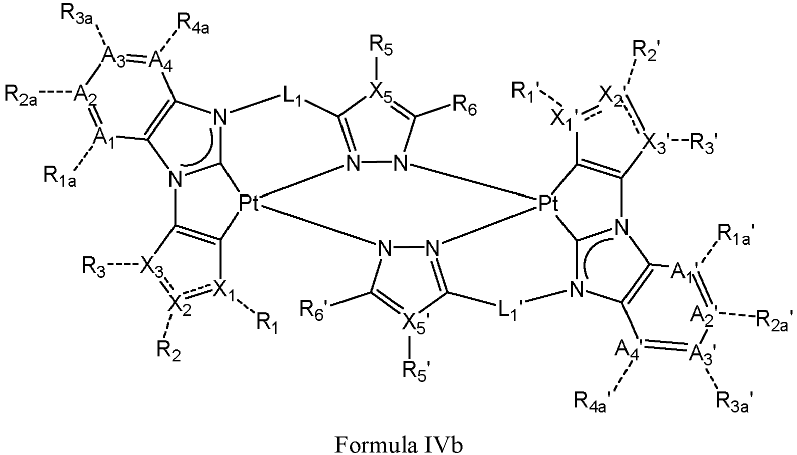 wherein:
the dashed linear lines denote the presence or absence of a bond, (i) R₁ₐ, R₂ₐ, R₃ₐ, R₄ₐ, R_{1a'}, R_{2a'}, R_{3a'}, and R_{4a'}, (ii) Li and Lr, and (iii) X₅, X_{5'}, R₅, R₆, R_{5'}, and R_{6'} are as described above for Formula Ia,
A₁, A₂, A₃, A₄, A_{1'}, A_{2'}, A_{3'}, and A_{4'} are independently carbon, nitrogen, oxygen, or sulfur, and are independently bonded to one or no hydrogen atom according to valency,
X₁, X₂, X₃, X₄, X_{1'}, X_{2'}, X_{3'}, and X_{4'} when present, are independently carbon, nitrogen, oxygen, or sulfur, and are independently bonded to one or no hydrogen atom according to valency, and
R₁, R₂, R₃, R₄, R_{1'}, R_{2'}, R_{3'}, and R_{4'} are independently absent, hydrogen, deuterium, substituted alkyl, unsubstituted alkyl, substituted alkenyl, unsubstituted alkenyl, substituted alkynyl, unsubstituted alkynyl, substituted aryl (such as mesityl (2,4,6-trimethylphenyl), 3,5-di-*tert*-butylphenyl, 2,6-dimethylphenyl), unsubstituted aryl, halogen (such as fluorine), hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, or unsubstituted C₃-C₂₀ cycloalkynyl, or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, or fused combinations thereof. In some forms, R₁, R₂, R₃, R₄, R_{1'}, R_{2'}, R_{3'}, and R_{4'} are independently absent, hydrogen, deuterium, substituted alkyl, unsubstituted alkyl, substituted aryl (such as mesityl (2,4,6-trimethylphenyl), 3,5-di-*ter*t-butylphenyl, 2,6-dimethylphenyl), unsubstituted aryl, halogen (such as fluorine), or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, or fused combinations thereof. In some forms, R₁, R₂, R₃, R₄, R_{1'}, R_{2'}, R_{3'}, and R_{4'} are independently absent, hydrogen, deuterium, substituted alkyl, unsubstituted alkyl, substituted aryl (such as mesityl (2,4,6-trimethylphenyl), 3,5-di-*tert*-butylphenyl, 2,6-dimethylphenyl), unsubstituted aryl, halogen (such as fluorine).

In some forms, the compounds are as described above for Formula Ia, IIa, or IVa, except that A₁, A₂, A₃, A₄, A_{1'}, A_{2'}, A_{3'}, and A_{4'} are carbon, and are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency. In some forms, R₁, R₂, R₃, R₄, R_{1'}, R_{2'}, R_{3'}, and R_{4'} are independently absent, hydrogen, substituted alkyl, unsubstituted alkyl, substituted aryl, unsubstituted aryl, or halogen. In some forms, R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, or unsubstituted aryl, or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted aryl, or an unsubstituted aryl. In some forms, R₁ₐ and R₂ₐ together, R₃ₐ and R₄ₐ together, R_{1a'} and R_{2a'} together, R_{3a'} and R_{4a'} together, with the atom to which they are attached, form a substituted aryl, or an unsubstituted aryl.

In some forms, the compounds are as described above for Formula Ia, IIa, or IVa, except that one or more of A₁, A₂, A₃, and A₄ are oxygen, nitrogen, or sulfur, one or more of A_{1'}, A_{2'}, A_{3'}, and A_{4'} are oxygen, nitrogen, or sulfur, and A₁, A₂, A₃, A₄, A_{1'}, A_{2'}, A_{3'}, and A_{4'} are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency. In some forms, R₁, R₂, R₃, R₄, R_{1'}, R_{2'}, R_{3'}, and R_{4'} are independently absent, hydrogen, deuterium, substituted alkyl, unsubstituted alkyl, substituted aryl (such as mesityl (2,4,6-trimethylphenyl), *3,5-di-tert-*butylphenyl, 2,6-dimethylphenyl), unsubstituted aryl, or halogen (such as fluorine). In some forms, R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, or unsubstituted aryl (such as phenyl).

In some forms, the compounds are as described above for Formula Ia, IIa, or IVa, except that one or more of A₁, A₂, A₃, and A₄ are nitrogen, one or more of A_{1'}, A_{2'}, A_{3'}, and A_{4'} are nitrogen, and A₁, A₂, A₃, A₄, A_{1'}, A_{2'}, A_{3'}, and A_{4'} are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency. In some forms, the compounds are as described above for Formula Ia, IIa, or IVa, except that one of A₁, A₂, A₃, and A₄ is nitrogen and the others are carbon, one of A_{1'}, A_{2'}, A_{3'}, and A_{4'} is nitrogen and the others are carbon, and A₁, A₂, A₃, A₄, A_{1'}, A_{2'}, A_{3'}, and A_{4'} are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency. In some forms, the compounds are as described above for Formula Ia, IIa, or IVa, except that two of A₁, A₂, A₃, and A₄ are nitrogen and the others are carbon, two of A_{1'}, A_{2'}, A_{3'}, and A_{4'} are nitrogen and the others are carbon, and A₁, A₂, A₃, A₄, A_{1'}, A_{2'}, A_{3'}, and A_{4'} are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency.

In some forms, the compounds are as described above for Formula Ia, IIa, or IVa, except that one or more of A₁, A₂, A₃, and A₄ are oxygen, nitrogen, or sulfur, one or more of A_{1'}, A_{2'}, A_{3'}, and A_{4'} are nitrogen or sulfur, and A₁, A₂, A₃, A₄, A_{1'}, A_{2'}, A_{3'}, and A_{4'} are independently bonded to one or no hydrogen atom according to valency, and one or more of X₁, X₂, X₃, X₄, X_{1'}, X_{2'}, X_{3'}, and X_{4'} are oxygen, nitrogen, or sulfur, and X₁, X₂, X₃, X₄, X_{1'}, X_{2'}, X_{3'}, and X_{4'} are independently bonded to one or no hydrogen atom according to valency. In some forms, R₁, R₂, R₃, R₄, R_{1'}, R_{2'}, R_{3'}, and R_{4'} are independently absent, hydrogen, substituted alkyl, unsubstituted alkyl, substituted aryl, unsubstituted aryl, or halogen (such as fluorine). In some forms, R₁ₐ, R₂ₐ, R₃ₐ, R₄ₐ, R_{1a'}, R_{2a'}, R_{3a'}, and R_{4a'} are independently absent, hydrogen, substituted alkyl, unsubstituted alkyl, substituted aryl, or unsubstituted aryl.

In some forms, the compounds are as described above for Formula Ia, IIa, or IVa, except that one or more of A₁, A₂, A₃, and A₄ are nitrogen, one or more of A_{1'}, A_{2'}, A_{3'}, and A_{4'} are nitrogen, and A₁, A₂, A₃, A₄, A_{1'}, A_{2'}, A_{3'}, and A_{4'} are independently bonded to one or no hydrogen atom according to valency, and one or more of X₁, X₂, X₃, X₄, X_{1'}, X_{2'}, X_{3'}, and X_{4'} are nitrogen, and X₁, X₂, X₃, X₄, X_{1'}, X_{2'}, X_{3'}, and X_{4'} are independently bonded to one or no hydrogen atom according to valency. In some forms, the compounds are as described above for Formula Ia, IIa, or IVa, except that one of A₁, A₂, A₃, and A₄ is nitrogen and the others are carbon, one of A_{1'}, A_{2'}, A_{3'}, and A_{4'} is nitrogen and the others are carbon, and A₁, A₂, A₃, A₄, A_{1'}, A_{2'}, A_{3'}, and A_{4'} are independently bonded to one or no hydrogen atom according to valency, and one of X₁, X₂, X₃, and X₄ is nitrogen and the others are carbon, one of X_{1'}, X_{2'}, X_{3'}, and X_{4'} is nitrogen and the others are carbon, and X₁, X₂, X₃, X₄, X_{1'}, X_{2'}, X_{3'}, and X_{4'} are independently bonded to one or no hydrogen atom according to valency.

In some forms, the compound has a structure selected from:

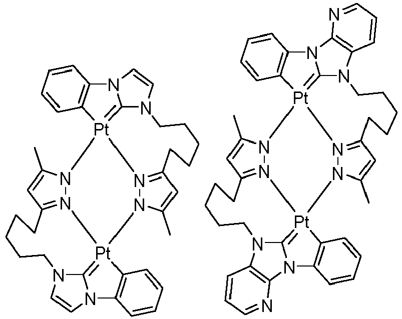

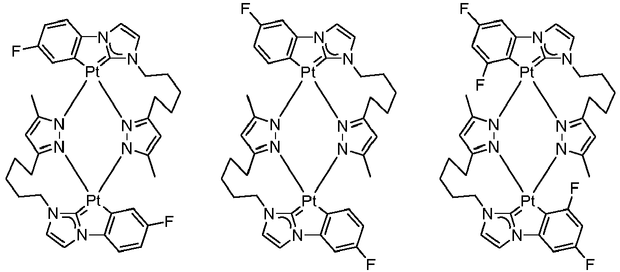

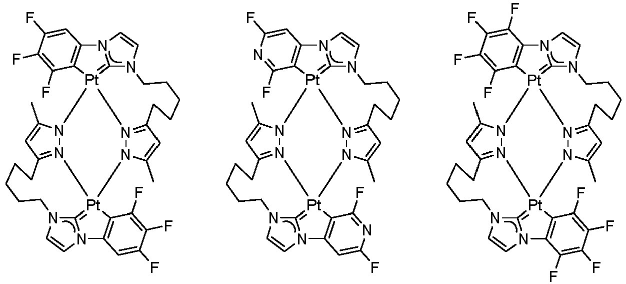

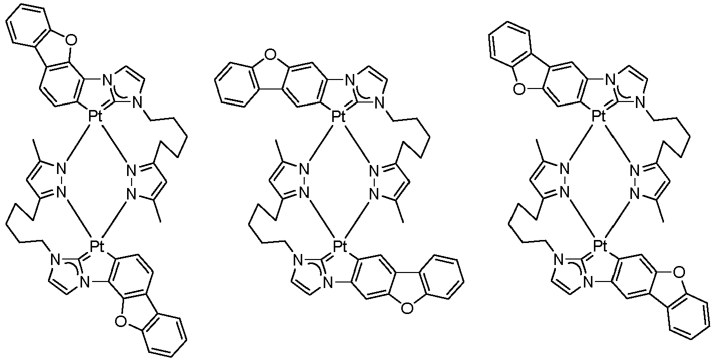

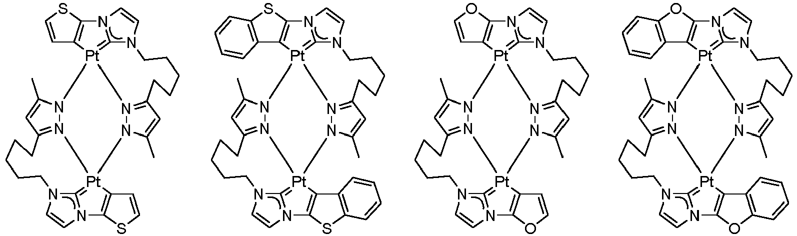

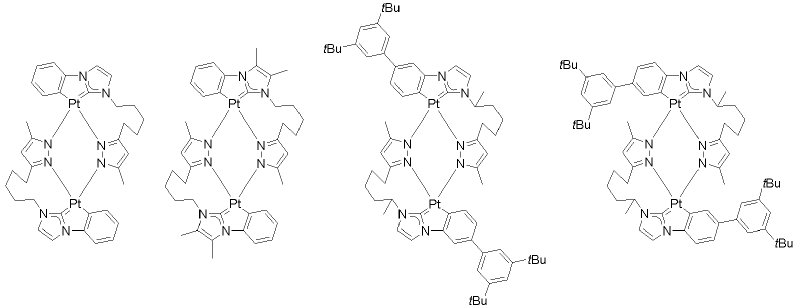

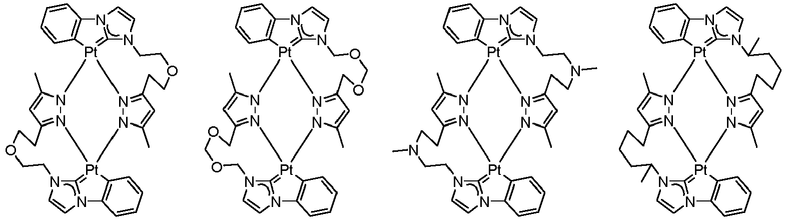

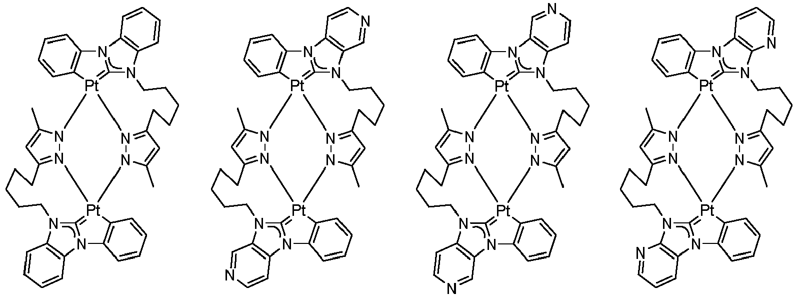

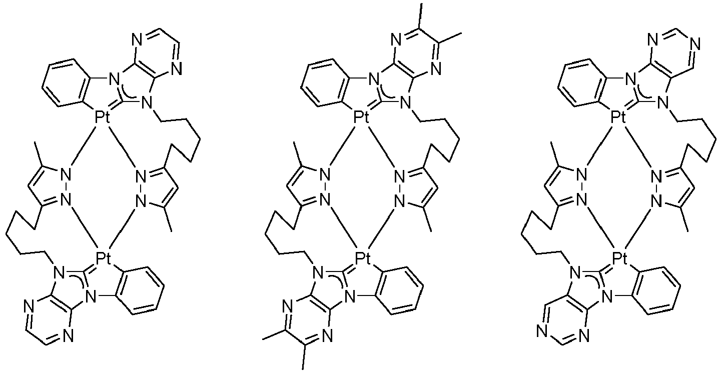

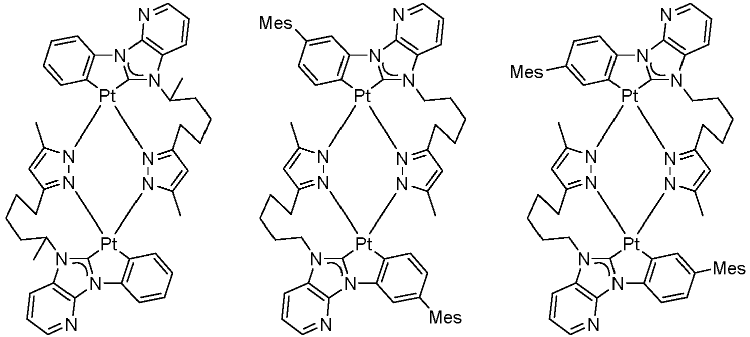

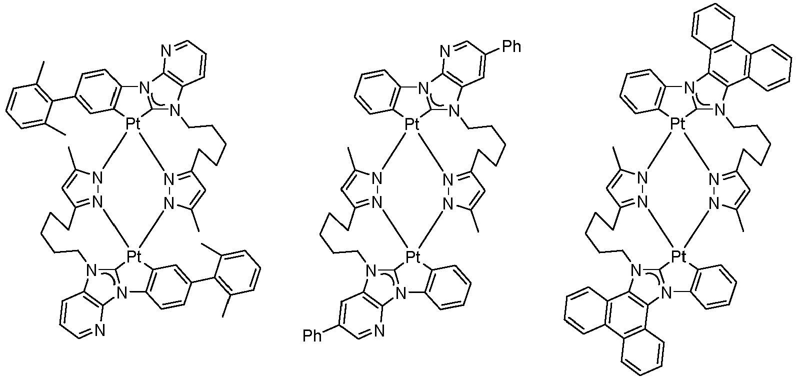

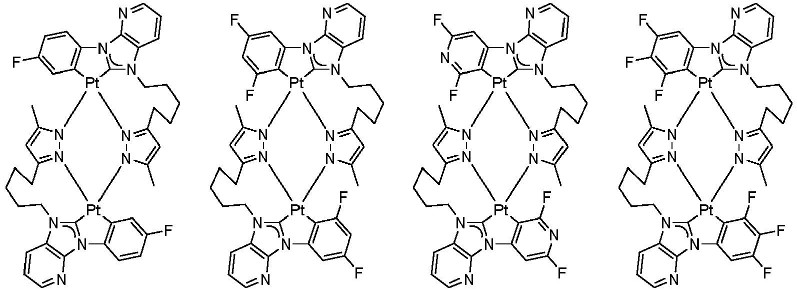

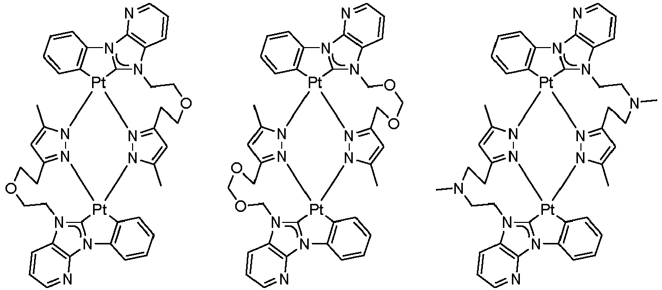

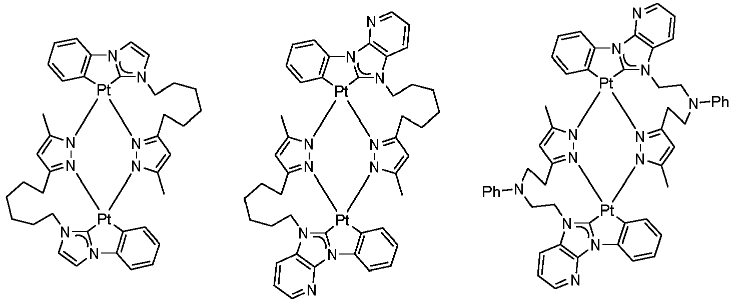

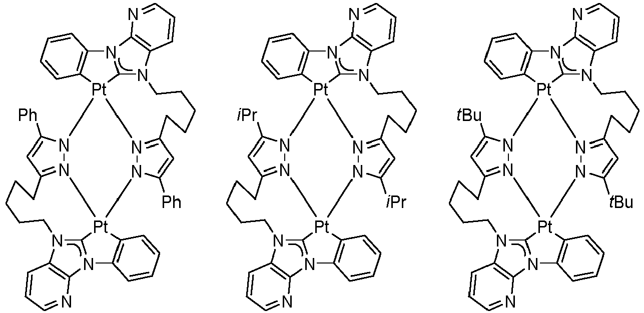

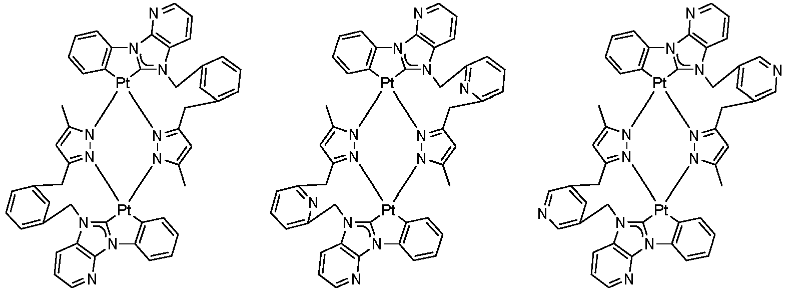

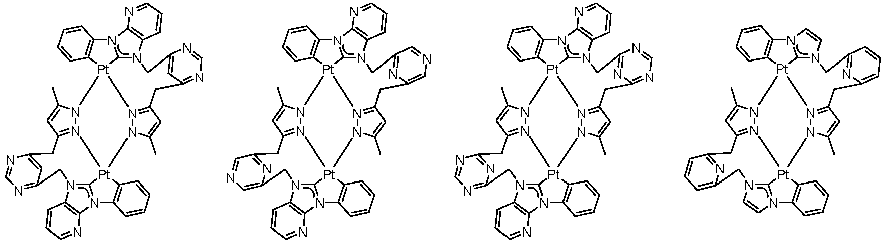

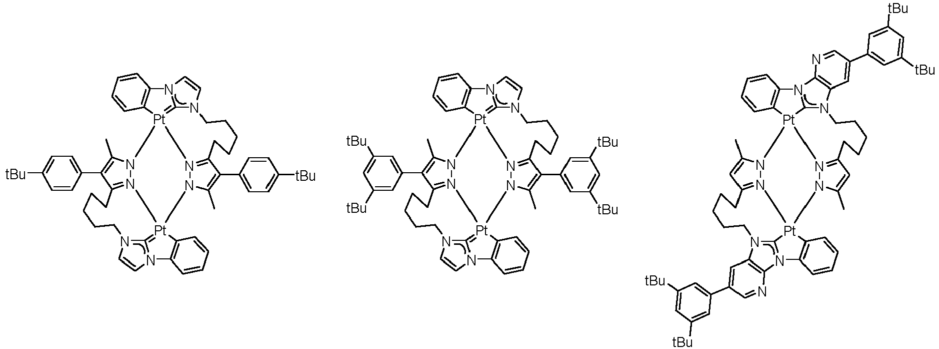

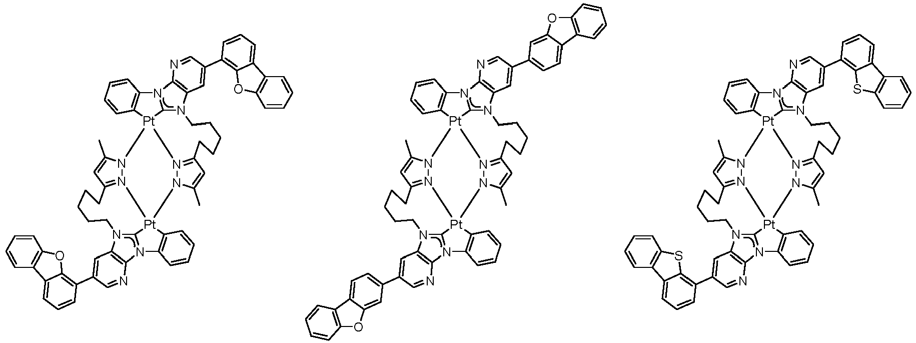

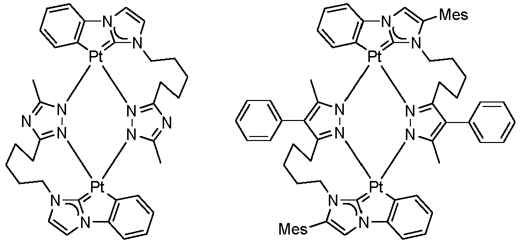

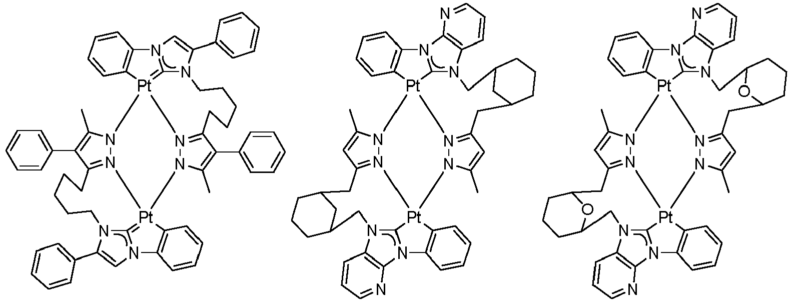

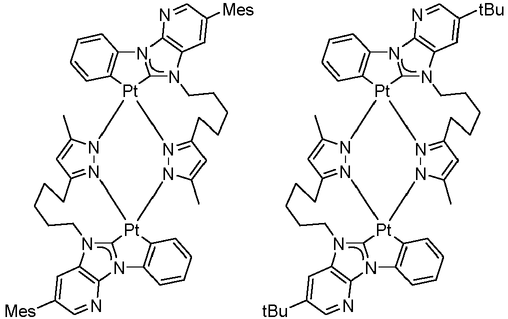

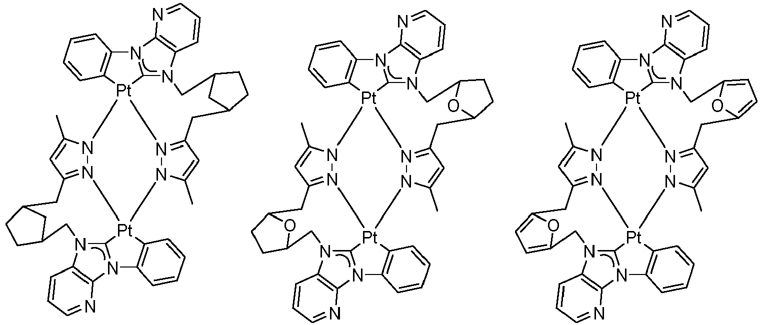

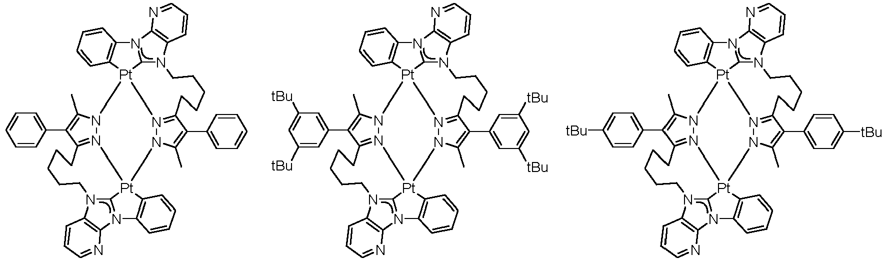

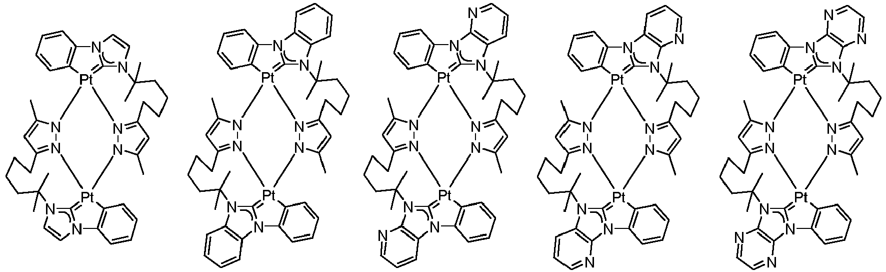

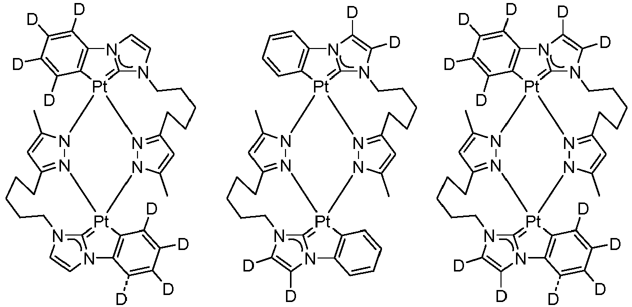

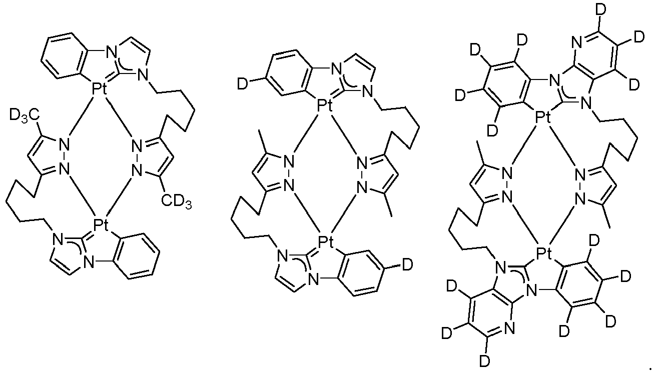

### III. Methods of Making and Reagents therefor

### A. Dinuclear Platinum (II) Emitter Complexes

The dinuclear platinum(II) emitter complexes and the ligands described herein can be synthesized using methods known in the art of organic chemical synthesis. For instance, ligands can be purchased from commercial chemical manufacturers or may be prepared according to procedures reported and/or adapted from the literature. The selection of appropriate synthetic conditions, reagents, reaction workup conditions, purification techniques (as needed) are known to those in the field of synthesis. Exemplary and non-limiting syntheses of ligands and dinuclear platinum(II) emitter complexes are discussed in the Examples below.

### B. Ligands

Synthetic methods for preparing ligands of the compounds described above are known or may be adapted from the literature. In some instances, pyrazole and triazole ligands described herein and used in the examples below can be readily obtained from commercial chemical manufacturers. Example syntheses of an NHC ligands and a bridging ligands are described in the Examples below.

### C. Organic light-emitting devices

Also described are methods of making organic light-emitting devices, such as OLEDs, containing one or more dinuclear platinum(II) emitter complexes described above. In some forms, preparation of the OLEDs can be via vacuum deposition or solution processing techniques such as spin-coating and ink printing (such as, ink-jet printing or roll-to-roll printing). An exemplary and nonlimiting method of making an OLED including containing one or more dinuclear platinum(II) emitter complexes described herein is disclosed in the Examples.

While non-specific tridentate ligands are generally known in the field, metal complexes formed from the tridentate ligands are typically and most generally mononuclear. It is not straight forward to obtain dinuclear metal complexes, particularly from methods used to form mononuclear complexes. Further, changing the denticity of a ligand from bidentate to tridentate, can induce structural distortions to the metal complexes, resulting in unknown photophysical properties. In addition, the synthetic methods for the tridentate ligands have to be developed.

### IV. Methods of Using

Preferably, the dinuclear platinum(II) emitter complexes described herein are photo-stable, thermally stable, and/or are emissive at room temperatures, low temperatures, or a combination thereof. Accordingly, the complexes can be incorporated into organic electronic components including, but not limited to, OLEDs or a light-emitting electrochemical cell (LEEC). Such OLEDs can be used in commercial applications such smart phones, televisions, monitors, digital cameras, tablet computers, lighting fixtures that usually operate at room temperatures, a fixed visual display unit, mobile visual display unit, illumination unit, keyboard, clothes, ornaments, garment accessary, wearable devices, medical monitoring devices, wall paper, tablet PC, laptop, advertisement panel, panel display unit, household appliances, and office appliances.

In some forms of the organic electronic component, the compounds are in a light-emitting layer. In some forms, the compounds are in a light-emitting layer that also contains a pure organic emitter. In these forms, the compounds can act as a sensitizer to transfer energy to the pure organic emitter. In these forms, the compounds can have a higher-lying singlet state than the pure organic emitter. The phrase "pure organic emitter" as used throughout this application refers to a light-emitting organic molecule formed exclusively from main group elements of the periodic table, such that the light-emitting organic molecule does not contain a covalent bond or a dative bond to a main group metal. Notably, the phrase is not intended to define or specify a level of purity of a composition containing the light-emitting organic molecule. In some forms, the organic electronic component contains an anode, a cathode, a hole transport region, and an electron transport region. In some forms, the hole transport region contains a hole injection layer and/or a hole transport layer, and optionally an electron blocking layer. In some forms, the electron transport region contains an electron transport layer and/or an electron injection layer, and optionally a hole blocking layer. In some forms, the light emitting layer is located in between the anode and the cathode. In some forms, the hole transport region is located between the anode and the light-emitting layer. In some forms, the electron transport region is located in between the cathode and the light-emitting layer.

Methods of preparing OLEDs containing one or more dinuclear platinum(II) emitter complexes, as described above, are well-known in the art of organic electronics. Such method of making OLEDs can involve vacuum deposition or solution processing techniques, such as spin-coating and ink-jet printing. The selection of suitable materials (anode, cathode, hole transport layer, electron transport layer, etc.) and fabrication parameters (such as deposition conditions or solvent selections) needed to fabricate OLEDs containing the dinuclear platinum(II) emitter complexes described herein are known in the art.

In one non-limiting example, organic light-emitting devices can have an ordered structure containing at least an anode, a hole-transporting layer, a light-emitting layer, an electron-transporting layer, and a cathode, wherein the light-emitting layer contains a dinuclear platinum(II) emitter complex, as described above. Referring to **FIG. 2****,** an organic light-emitting device OLED 100 can include (i) a cathode **110** preferably including an aluminum layer **120** and a lithium layer **130;** (ii) optionally, an electron transporting layer **140;** (iii) optionally, a carrier confinement layer **150;** (iv) a light-emitting layer **160** containing a dinuclear platinum(II) emitter complex described herein; (v) optionally, a hole-transporting layer **170;** and (vi) an anode **180,** such as indium tin oxide-coated glass. Flexible substrates other than glass, such as on plastic are also known in the art. The above is a non-limiting illustration of an OLED device which may be fabricated. It is understood that various other OLED architectures are possible.

The light-emitting layer can be formed by doping the dinuclear platinum(II) emitter complex, as a dopant, into a host compound and the luminescent compound has a percent composition between about 3 wt/wt% and about 20 wt/wt%, such as about 4 wt/wt% and about 16 wt/wt%, such as about 4 wt/wt%, about 8wt/wt%, and about 16 wt/wt%, of the light-emitting layer. In some forms, the light-emitting layer has a thickness between about 5 nm and about 120 nm, between about 5 nm and about 60 nm, such as between about 10 nm and about 60 nm.

In some forms, the light-emitting layer contains a host compound selected from, but is not limited to, 1,3-bis(N-carbazolyl)benzene (mCP), 4,4'-bis(carbazol-9-yl)biphenyl (CBP), 4,4',4"-tris(carbazol-9-yl)- triphenylamine (TCTA), 3-(4-biphenylyl)-4-phenyl-5-tert-butylphenyl-1,2,butylphenyl-1,2,4-triazole (TAZ), p-bis(triphenylsilyl)benzene (UGH2), 9-(4-tert-Butylphenyl)-3,6-bis(triphenylsilyl)-9H-carbazole (CzSi), Bis-4-(N-carbazolyl)phenyl)phenylphosphine oxide (BCPO), diphenyl-4-triphenylsilylphenyl-phosphine oxide (TSPO1), 2,8-bis(diphenylphosphoryl)dibenzo[b,d]furan (PPF), bis[2-(diphenylphosphino)phenyl]ether oxide (DPEPO), 3,3'-di(9H-carbazol-9-yl)-1,1'-biphenyl (mCBP), poly(methyl methacrylate) (PMMA), polystyrene (PS), and suitable combinations thereof. For example, two hosts, such as CzSi:TSPO1, BCPO:TSPO1, and BCPO:CzSi may be used in some forms at suitable relative ratios. Exemplary relative molar ratios of two respective hosts can range from between about 0.5: 1 to 2:1.

In some forms, the hole-transporting layer contains an organic compound that can be, but is not limited to, 4,4'-bis[*N*-(1-naphthyl)-*N-*phenylamino]biphenyl (NPB), 4,4'-bis[*N*-(3-methylphenyl)-*N-*phenylamino]biphenyl (TPD), 4,4',4"-tris[(3-methylphenyl)phenylamino] triphenylamine (MTDATA), and di-[4-(*N,N*-ditolyl-amino)phenyl]cyclohexane (TAPC). In addition, polymeric hole-transporting materials can be used including poly(N-vinylcarbazole) (PVK), polythiophene, polypyrrole, polyaniline, and copolymers including PEDOT:PSS. In some forms, the hole-transporting layer has a thickness between about 10 nm and 70 nm, such as 40 nm.

In some forms, the electron-transporting layer contains an organic compound that can be, but is not limited to, 1,3,5-tris(phenyl-2-benzimidazolyl)-benzene (TPBI), 1,3,5-tri[(3-pyridyl)-phen-3-yl] benzene (TmPyPB), bathocuproine (BCP), bathophenanthroline (BPhen) and bis(2-methyl-8-quinolinolate)-4-(phenylphenolate)-aluminum (BAlq), 1,3,5-tri[(3-pyridyl)-phen-3-yl]benzene (TmPyPB),1,3-bis[3,5-di(pyridin-3-yl)- phenyl]benzene (BmPyPhB) and 1,3,5-tris(6-(3-(pyridin-3-yl)phenyl)pyridin-2-yl)benzene (Tm3PyP26PyB). In some forms, the electron-transporting layer has a thickness between about 10 nm and 60 nm, such as 40 nm.

In some forms, the light-emitting device can contain a carrier confinement layer inserted between the hole-transporting layer and the light-emitting layer, or between the light-emitting layer and the electron-transporting layer. Preferably, the carrier confinement layer improves the performance of the light-emitting device. In some forms, the carrier confinement layer contains an organic compound that can be, but is not limited to, CBP, TCTA, 3TPYMB, BmPyPhB, and Tm3PyP26PyB. In some forms, the carrier confinement layer has a thickness between about 5 nm and about 50 nm, such as between about 10 nm and about 50 nm.

Preferably, the anode of the light-emitting device contains indium tin oxide-coated glass. Preferably, the cathode of the light-emitting device can contain lithium fluoride, aluminium, or a combination thereof. In some forms, the lithium fluoride forms a layer having a thickness between about 0.05 nm and 5 nm, such as 1 nm. In some forms, the aluminium forms a layer having a thickness between about 50 nm and about 250 nm, between about 50 nm and about 200 nm, such as 150 nm.

OLEDs containing the dinuclear platinum(II) emitter complexes can demonstrate maximum current efficiencies (CE) of up to 35 cd/A. In some forms, the CE can include, but is not limited to values of about 5 cd/A, 7.5 cd/A, 10 cd/A, 15 cd/A, 20 cd/A, 25 cd/A, 30 cd/A, or 35 cd/A. The CE values at luminances of 1000 cd/m² may be up to 30 cd/A. In some forms, the CE at luminances of 1000 cd/m² can include, but is not limited to values of about 2 cd/A, 2.5 cd/A, 5 cd/A, 10 cd/A, 15 cd/A, 20 cd/A, 25 cd/A, or 30 cd/A.

OLEDs containing the dinuclear platinum(II) emitter complexes can demonstrate maximum power efficiencies (PE) of up to 30 lumens per watt. In some forms, the PE can include, but is not limited to values of about 5 lm/W, 10 lm/W, 15 lm/W, 20 lm/W, 25 lm/W, or 30 lm/W. The PE values at luminances of 1000 cd/m² may be up to 25 lm/W. In some forms, the PE at luminances of 1000 cd/m² can include, but is not limited to values of about 5 lm/W, 5.5 lm/W, 6 lm/W, 6.5 lm/W, 10 lm/W, 15 lm/W, 20 lm/W, 25 lm/W.

OLEDs containing the dinuclear platinum(II) emitter complexes can demonstrate maximum external quantum efficiencies (EQE) of up to about 30%. In some forms, the EQE can include, but is not limited to values of about 10 to 30%. The EQE values at luminances of 1000 cd/m² may be up to 20% or 25%. In some forms, the PE at luminances of 1000 cd/m² can include, but is not limited to values of about 1% to about 20%, about 1% to about 15%, about 1% to about 10%, or about 1% to about 5%. wherein:

### Examples

### Example 1: Synthesis and characterization of compounds

The new di-platinum(II) complexes, such as fluorine-free complexes, show strong deep blue phosphorescence, with outstanding emission quantum yields of up to 0.74 in thin films at room temperature. The emission can be further tuned by the substituent(s) on the cyclometalating NHC ligands. The most striking feature of the new Pt(II) emitter is its deep blue emission (emission maximum at 447 nm) and the exceptionally short radiative lifetime down to around 2 µs. The preliminary results of the vapor-deposited deep blue OLEDs exhibit EQE and CE of 12.1% and 7.53 cd/A, respectively with CIE (x,y) of 0.16, 0.07. To the best of Applicant's knowledge, this is one of the few examples of a metal complex based device that could meet National Television System Committee's (NTSC) coordinates definition for pure blue of (0.14, 0.08).

### Materials and Methods

The chemical reagents used for synthesis were purchased from commercial sources such as Dieckmann, Tiv Scientific, J & K Scientific, BLDpharm, Bidepharm, Strem Chemicals. They were directly used without further processing. The solvents used for synthesis were purchased from Duksan, RCI Labscan, Scharlau. They were directly used without further processing.

### Characterization

¹H and ¹³C NMR spectra were recorded on DPX-400 or DPX-500 Bruker FT-NMR spectrometer. The chemical shift of proton or carbon signals were calibrated by the corresponding solvent residual signals. High resolution mass spectra were measured with Bruker Impact II mass spectrometer.

### Fabrication process of OLEDs

Indium-tin-oxide (ITO) coated glass with a sheet resistance of 10 Ω/sq was used as the anode substrate. Before film deposition, patterned ITO substrates were cleaned with detergent, rinsed in de-ionized water, acetone, and isopropanol, and then dried in an oven for 1 h in a cleanroom. The slides were then treated in an ultraviolet-ozone chamber for 5 min. The OLEDs were fabricated in a Kurt J. Lesker SPECTROS vacuum deposition system with a base pressure of 10⁻⁷ mbar. In the vacuum chamber, organic materials were thermally deposited in sequence at a rate of 0.5 Å s⁻¹. The doping process in the emissive layers (EMLs) was realized using co-deposition technology. Afterward, LiF (1.2 nm) and Al (100 nm) were thermally deposited at rates of 0.02 and 0.2 nm s⁻¹, respectively. The film thicknesses were determined in situ with calibrated oscillating quartz-crystal sensors.

### Characterization of OLEDs

Current density-brightness-voltage characteristics, EL spectra, and EQE of electroluminescent (EL) device were obtained by using a Keithley 2400 source-meter and an absolute external quantum efficiency measurement system (C9920-12, Hamamatsu Photonics). All devices were encapsulated in a 200-nm-thick Al₂O₃ thin film deposited by atomic layer deposition (ALD) in a Kurt J. Lesker SPECTROS ALD system before measurements.

### (i) Synthesis of ligand

### Scheme 1 shows syntheses of tridentate NHC ligands (L1 and L2).

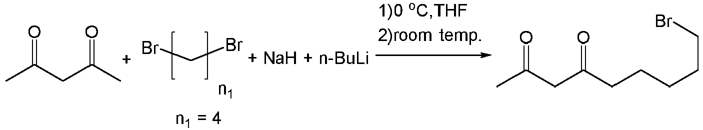

Synthesis of 9-bromononane-2,4-dione (Chen, et al., Chem. Commun., 2011, 47, 9519-9521): Acetylacetone (1 eq.) was added to NaH (1.15 eq.) at 0 °C in 20 mL dry THF. The reaction mixture was stirred for 30 mins before n-BuLi (1.2 eq.) was added. The reaction mixture was stirred for 30 mins more. Dibromoalkane (1.5 eq., n₁ = 4 (**L1/L2**)) was added and was stirred for 2 hours at 0 °C and 2 hours at room temperature. Water was added and the reaction mixture was acidified to pH~2. The aqueous phase was extracted with CHCl₃. The combined organic fraction was dried with MgSO₄, filtered, and concentrated under reduced pressure. The crude product was used in next step without further purification. 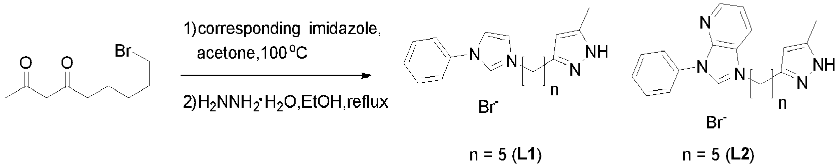 1-Phenylimidazole for **L1** or 3-phenyl-3*H*-imidazo[4,5-*b*]pyridine (Pinter, etal., Organometallics 2016, 35, 673-680) for **L2** (0.66 equiv.) and 9-bromononane-2,4-dione (Chen, et al., Chem. Commun., 2011, 47, 9519-9521) (1.00 equiv.) were stirred for 48h at 100 °C in acetone (1 mL per 1 mmol of imidazole). The solvent was removed under reduced pressure and the residue was used in next step without further purification. Hydrazine hydrate (1.1 equiv.) and EtOH (2 mL per 1 mmol of imidazole) was added and the reaction mixture was refluxed overnight. The solvent was removed under reduced pressure and the residue was purified with silica gel column with acetone/EtOH.
**L1:** Overall yield: 54%. ¹H NMR (500 MHz, DMSO): δ 11.99 (s, 1H), 9.80 (s, 1H), 8.30 (s, 1H), 8.01 (s, 1H), 7.76 (d, *J* = 8.1 Hz, 2H), 7.64 (t, *J* = 7.7 Hz, 2H), 7.56 (t, *J=* 7.4 Hz, 1H), 5.73 (s, 1H), 4.21 (t, *J=* 7.2 Hz, 2H), 3.41 (q, *J=* 6.8 Hz, 2H), 2.08 (s, 3H), 1.93 - 1.84 (m, 2H), 1.62 -1.53 (m, 2H), 1.33 - 1.27 (m, 2H). HRMS (ESI) for C₁₈H₂₃N₄ [M]⁺: calcd 295.1923, found 295.1916.
**L2:** Overall yield: 22%. ¹H NMR (500 MHz, DMSO): δ 10.44 (s, 1H), 8.82 (d, *J* = 4.8 Hz, 1H), 8.75 (d, *J* = 8.4 Hz, 1H), 7.93 (d, *J=* 7.9 Hz, 2H), 7.90 - 7.85 (m, 1H), 7.75 (t, *J* = 7.7 Hz, 2H), 7.68 (t, *J* = 7.6 Hz, 1H), 5.94 (s, 1H), 4.58 (t, *J* = 7.1 Hz, 2H), 2.19 (s, 3H), 2.06 - 2.00 (m, 2H), 1.70 - 1.62 (m, 2H), 1.56 - 1.53 (m, 2H), 1.50 - 1.42 (m, 2H).

### (ii) Synthesis of platinum (II) emitter

**Scheme 2** shows the syntheses of dinuclear platinum(II) emitter complexes.

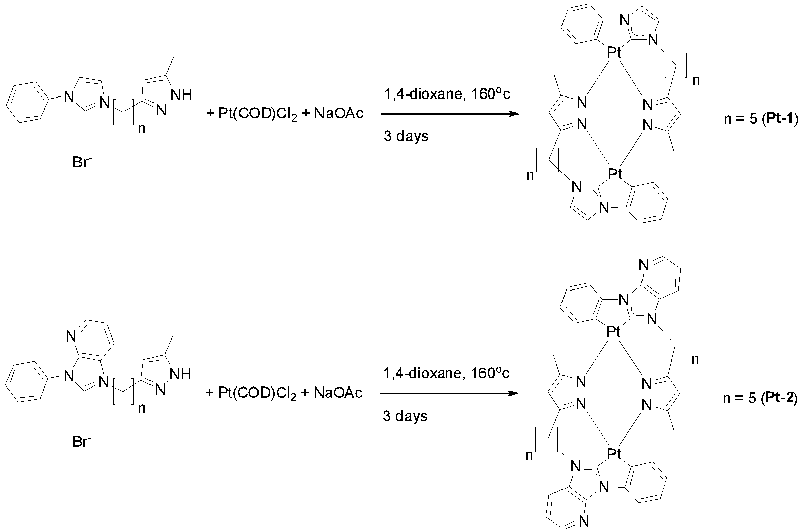

**L1** or **L2** (1 eq.), Pt(COD)Cl₂, (1.04 eq.) and NaOAc (3 eq.) was stirred in 1,4-dioxane (1 mL per 0.1 mmol of imidazolium salt) at 160 °C for 3 days. Water was added to the reaction mixture and the aqueous phase was extracted with DCM. The organic phase was dried with MgSO4, filtered and concentrated under reduced pressure. The crude product was purified with silica gel column using DCM/hexane as eluent.
**Pt-1:** Yield: 17%. ¹H NMR (500 MHz, DMSO): δ 7.89 (s, 2H), 7.26 (s, 2H), 7.21 (d, *J* = 7.6 Hz, 2H), 6.96 - 6.87 (m, 4H), 6.74 (t, *J=* 7.3 Hz, 2H), 6.00 (s, 2H), 3.65 - 3.57 (m, 2H), 3.47 - 3.40 (m, 2H), 2.97 - 2.90 (m, 2H), 2.63 - 2.58 (m, 2H), 2.16 (s, 6H), 2.02 - 1.92 (m, 2H), 1.86 - 1.74 (m, 2H), 1.74 - 1.59 (m, 4H), 1.57 - 1.48 (m, 2H), 1.30 - 1.24 (m, 2H). HRMS (ESI) for C₃₆H₄₁N₈Pt₂ [M+H]⁺: calcd. 975.2750, found 975.2724.
**Pt-2:** Yield: 2%. ¹H NMR (500 MHz, CD₂Cl₂): δ 8.36 (s, 1H), 8.35 (s, 1H), 7.61 (d, J= 8.1 Hz, 1H), 7.20 -7.11 (m, 2H), 7.06 (t, J= 7.4 Hz, 1H), 6.89 (t, J= 7.4 Hz, 1H), 6.15 (s, 1H), 4.33 - 4.23 (m, 1H), 3.91 - 3.83 (m, 1H), 3.16 (t, J= 13.7 Hz, 1H), 2.79 (d, *J=* 15.2 Hz, 1H), 2.32 (s, 3H), 2.11 - 2.02 (m, 1H), 1.96 - 1.80 (m, J= 39.1 Hz, 3H), 1.65 - 1.58 (m, 2H). HRMS (ESI) for C₄₂H₄₃N₁₀Pt₂ [M+H]⁺: calcd 1077.2968, found 1077.2950.

### Results

The results of the instant work are presented below.

### Photophysical characterization of the dinuclear complexes in host compounds

The dinuclear Pt(II) complexes (**Pt-1** and **Pt-2**) display strong deep blue to blue photoluminescence at 447-480 nm with emission quantum yield of 0.74-0.82 in PMMA film at room temperature. The emission lifetimes are short, of 1.3-2.0 µs, giving rise to large radiative rate constant of 3.7×10⁵ s⁻¹ to 6.3×10⁵ s⁻¹ or short radiative lifetimes of 1.6-2.7 µs. The absorption and emission data, and related photophysical data are shown in Table 1.

**Table 1. Emission data of Pt-1 at room temperature**

| | **medium** | **λₑₘ/ nm** | **FWHM/ nm** | **Φₑₘ; τₑₘ/ µs** | ***k*ᵣ/ ×10⁵ s⁻¹; τᵣ/ µs** |
|---|---|---|---|---|---|
| **Pt-1** | 4 wt/wt% t in PMMA | 425, 447 | 60 | 0.74; 2.0 | 3.7; 2.7 |
| **Pt-2** | 4 wt/wt% in PMMA | 480 | 74 | 0.82; 1.3 | 6.3; 1.6 |

Vacuum-deposited devices fabricated with **Pt-1** exhibited deep-blue electroluminescence with CIE(x, y) of (0.15-0.16, 0.07-0.08) at different doping concentrations. The maximum EQE and CE of the devices doped with 4wt/wt% of **Pt-1** were 12.14% and 7.53 cd/A, respectively, giving decent blue-index of 108.

**Table 2. Performance data of vacuum-deposited devices with Pt-1**

| **Pt-1** conc. | L [cd m⁻²] | CE [cd A⁻¹] | | PE [lm W⁻¹] | | EQE [%] | | CIE [(x,y)] | FWHM [nm] | λmax [nm] |
|---|---|---|---|---|---|---|---|---|---|---|
| | | Max | at 1000 cd m⁻² | Max | at 1000 cd m⁻² | Max | at 1000 cd m⁻² | | | |
| 4 wt/wt% (A) | 3900 | 7.53 | 2.29 | 6.45 | 0.92 | 12.14 | 3.69 | 0.16, 0.07 | 56 | 449 |
| 8 wt/wt% (A) | 3730 | 7.35 | 2.95 | 6.42 | 1.22 | 10.71 | 4.24 | 0.15, 0.07 | 58 | 452 |
| 16 wt/wt% (A) | 2030 | 6.51 | 2.21 | 5.59 | 0.81 | 8.55 | 2.92 | 0.16, 0.08 | 60 | 453 |

| | | | | | | | | | | |
|---|---|---|---|---|---|---|---|---|---|---|
| (A) **Device structure: ITO/HAT-CN(5 nm)/TAPC(40 nm)/TcTa(7 nm)/CzSi(3 nm)/Pt-1:CzSi (10 nm)/TSPO1(30 nm)/LiF (1 nm)/Al (100 nm)** | | | | | | | | | | |

**Table 3. Comparison with other Pt(II) blue emitters**

| | Current data for Pt-1 | IP00584 | IP01050 |
|---|---|---|---|
| Kᵣ; kₙᵣ (s⁻¹) | 3.7×10⁵; 1.3×10⁵ | 1.0×10⁵; 2.5×10⁴ | 2.4×10⁵; 6.7×10⁴ |
| CIE (x,y) | (0.15, 0.07) | (0.14, 0.16) | (0.15, 0.11) |
| Maximum Brightness (cd/m²) | 3730 | NA | **2620** |
| Current efficiency @1000 cd/m² (cd/A) | 3.0 | 21.6 | 12.4 |
| Power efficiency @1000 cd/m² (Im/W) | 1.2 | 13.6 | 7.0 |
| External quantum efficiency @1000 cd/m² (%) | 4.3 | 16.6 | 11.4 |
| LT | NA | NA | NA |

Work is ongoing to (i) further enhance the thermal stability of the complex for facile application in vacuum-deposition fabrication techniques, and (ii) further elucidate structure-property relationship that could guide the enhancement of photophysical attributes (such as emission band-width, color purity) to cater for blue OLED applications.

Unless defined otherwise, all technical and scientific terms used herein have the same meanings as commonly understood by one of skill in the art to which the disclosed invention belongs. Further, unless otherwise indicated, use of the expression "wt%" refers to "wt/wt%."

Those skilled in the art will recognize, or be able to ascertain using no more than routine experimentation, many equivalents to the specific embodiments of the invention described herein. Such equivalents are intended to be encompassed by the following claims.

## Claims

1. A compound having a structure: 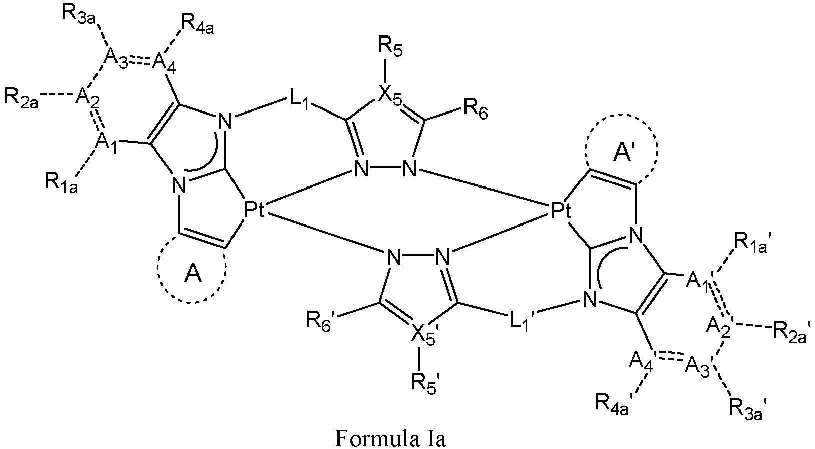 wherein:
the compound has an overall neutral, negative, or positive charge,
the dashed linear lines denote the presence or absence of a bond,
A and A' are independently a substituted cycloalkyl, an unsubstituted cycloalkyl, a substituted cycloalkenyl, an unsubstituted cycloalkenyl, a substituted cycloalkynyl, an unsubstituted cycloalkynyl, a substituted C₁-C₂₀ heterocyclyl, an unsubstituted C₁-C₂₀ heterocyclyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, or fused combinations thereof; preferably A and A' are independently a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, or fused combinations thereof,
X₅, and X_{5'} are independently carbon or nitrogen, and are independently bonded to one or no hydrogen atom according to valency, preferably, X₅ and X_{5'} are carbon,
R₅, R₆, R_{5'}, and R_{6'} are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, unsubstituted C₃-C₂₀ cycloalkynyl, or R₅ and R₆ together, R_{5'} and R_{6'} together, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, fused combinations thereof, or preferably R₅, R₆, R_{5'}, and R_{6'} are independently absent, hydrogen, substituted alkyl, unsubstituted alkyl, substituted aryl, unsubstituted aryl,
A₁, A₂, A₃, A₄, A_{1'}, A_{2'}, A_{3'}, and A_{4'} are independently absent, hydrogen, deuterium, carbon, nitrogen, unsubstituted aryl, or unsubstituted aryl, and, when present, are independently bonded to one, two, three, four, five, or no hydrogen atom according to valency,
R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, unsubstituted C₃-C₂₀ cycloalkynyl, unsubstituted C₁-C₂₀ heterocyclyl, a fused combination thereof (such as dibenzofuran-4-yl, dibenzofuran-3-yl, dibenzothiopen-4-yl, dibenzothiopen-3-yl, *etc*.), or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, fused combinations thereof, or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, fused combinations thereof, and
L₁ and L_{1'} are independently substituted alkyl, unsubstituted alkyl, substituted alkenyl, unsubstituted alkenyl, substituted alkynyl, unsubstituted alkynyl, unsubstituted alkoxy, substituted alkoxy, unsubstituted aroxy, substituted aroxy, unsubstituted alkylthio, substituted alkylthio, unsubstituted carbonyl, substituted carbonyl, unsubstituted carboxyl, substituted carboxyl, unsubstituted ester, substituted ester, unsubstituted ether, substituted ether, unsubstituted polyether, substituted polyether, substituted amino, unsubstituted amino, substituted amide, unsubstituted amide, substituted aryl, unsubstituted aryl, substituted heteroaryl, unsubstituted heteroaryl, substituted polyaryl, unsubstituted polyaryl, substituted polyheteroaryl, unsubstituted polyheteroaryl, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, unsubstituted C₃-C₂₀ cycloalkynyl, or fused combinations thereof.

2. The compound of claim 1, wherein L₁ and L₁' are independently substituted alkyl or unsubstituted alkyl, optionally
wherein L₁ and L₁' are independently substituted C₁-C₁₀ alkyl, unsubstituted C₁-C₁₀ alkyl, substituted C₂-C₁₀ alkyl or unsubstituted C₂-C₁₀ alkyl, preferably wherein the substituted alkyl, substituted C₁-C₁₀ alkyl, substituted C₂-C₁₀ alkyl contains one or more alkyl substituents (such as methyl, ethyl, propyl, iso-propyl, n-butyl, sec-butyl, tert-butyl), one or more ether bonds, one or more amine groups (such as substituted amine or unsubstituted amine), one or more substituted aryl groups, one or more substituted heteroaryl groups, one or more substituted C₃-C₂₀ cycloalkyl groups, one or more substituted C₁-C₂₀ heterocyclyl groups, or a combination thereof.

3. The compound of claim 1 or claim 2, wherein R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, or unsubstituted aryl, or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, fused combinations thereof.

4. The compound of any one of claims 1 to 3, having a structure: 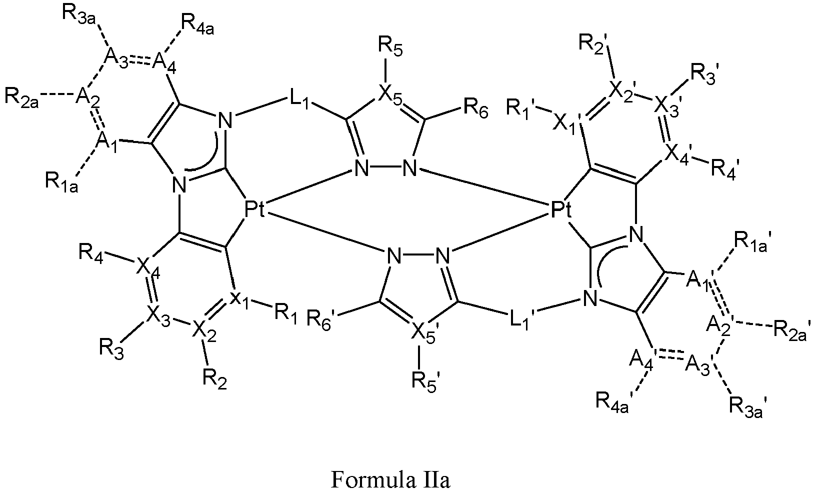 or 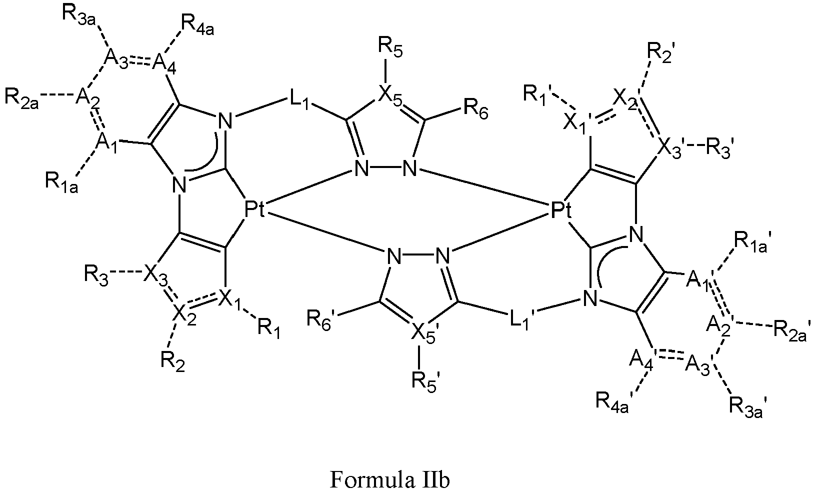 wherein:
the dashed linear lines denote the presence or absence of a bond,
X₁, X₂, X₃, X₄, X_{1'}, X_{2'}, X_{3'}, and X_{4'} when present, are independently carbon, nitrogen, oxygen, or sulfur, and are independently bonded to one or no hydrogen atom according to valency,
R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted alkenyl, unsubstituted alkenyl, substituted alkynyl, unsubstituted alkynyl, substituted aryl (such as mesityl (2,4,6-trimethylphenyl), 3,5-di-tert-butylphenyl, 2,6-dimethylphenyl), unsubstituted aryl, halogen (such as fluorine), hydroxyl, thiol, cyano, nitro-, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted alkylthio, substituted alkylthio, unsubstituted carbonyl, substituted carbonyl, unsubstituted carboxyl, substituted carboxyl, unsubstituted ester, substituted ester, substituted C₃-C₂₀ cycloalkyl, unsubstituted C₃-C₂₀ cycloalkyl, substituted C₁-C₂₀ heterocyclyl, unsubstituted C₁-C₂₀ heterocyclyl, substituted C₃-C₂₀ cycloalkenyl, unsubstituted C₃-C₂₀ cycloalkenyl, substituted C₃-C₂₀ cycloalkynyl, or unsubstituted C₃-C₂₀ cycloalkynyl, or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted C₁-C₂₀ heterocyclyl, an unsubstituted C₁-C₂₀ heterocyclyl, or fused combinations thereof, optionally wherein R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted aryl (such as mesityl (2,4,6-trimethylphenyl), 3,5-di-tert-butylphenyl, 2,6-dimethylphenyl), unsubstituted aryl, halogen (such as fluorine), or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof.

5. The compound of any one of claims 1 to 4, having a structure: 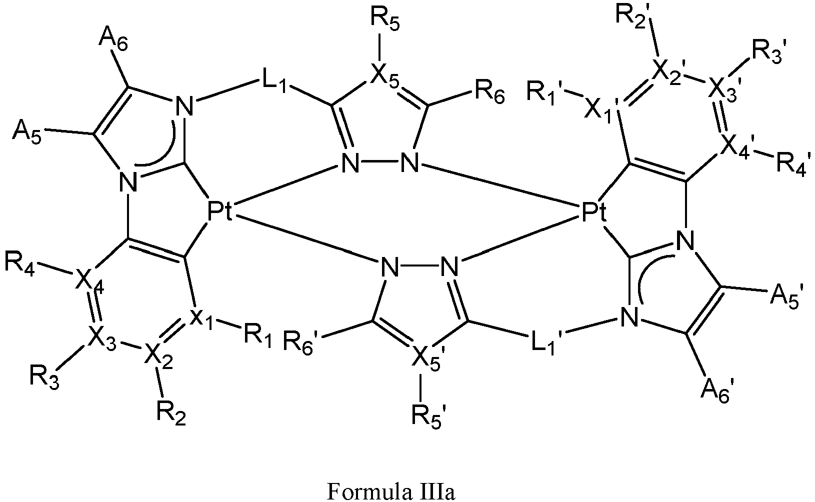 or 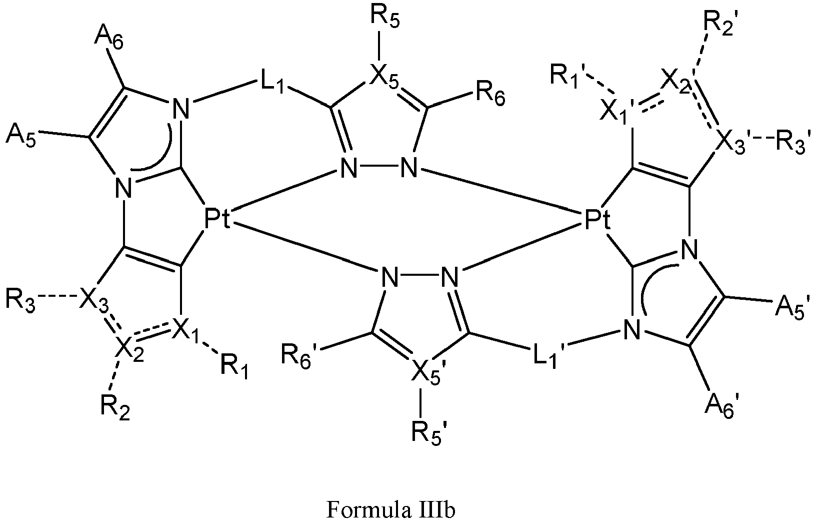 wherein:
the dashed linear lines denote the presence or absence of a bond,
A₅, A₆, A_{5'}, and A_{6'} are independently hydrogen, deuterium, unsubstituted alkyl, substituted alkyl, substituted aryl, unsubstituted aryl, unsubstituted heteroaryl, substituted heteroaryl, unsubstituted polyheteroaryl, substituted polyheteroaryl, substituted C₁-C₂₀ heterocyclyl, or unsubstituted C₁-C₂₀ heterocyclyl; or preferably hydrogen, unsubstituted alkyl, substituted alkyl, deuterium, substituted aryl, or unsubstituted aryl, optionally wherein A₅, A₆, A_{5'}, and A_{6'} are hydrogen or deuterium, or
wherein A₅, A₆, A_{5'}, and A_{6'} are
(i) unsubstituted alkyl (such as unsubstituted C₁-C₁₀ alkyl, unsubstituted C₁-C₅ alkyl, or unsubstituted C₁-C₃ alkyl) or substituted alkyl (such as substituted C₁-C₁₀ alkyl, substituted C₁-C₅ alkyl, or substituted C₁-C₃ alkyl), or
(ii) hydrogen, substituted aryl, or unsubstituted aryl, with the proviso at least one of A₅ and A₆, or A_{5'} and A_{6'} is substituted aryl or unsubstituted aryl.

6. The compound of claim 4 or claim 5, wherein
(i) for Formula IIa or IIIa, X₁, X₂, X₃, X₄, X_{1'}, X_{2'}, X_{3'}, and X_{4'} are carbon, and are independently bonded to one or no hydrogen atom according to valency, or
(ii) wherein for Formula IIa or IIIa, one or more of X₁, X₂, X₃, and X₄, and one or more of X_{1'}, X_{2'}, X_{3'}, and X_{4'} are nitrogen, and X₁, X₂, X₃, X₄, X_{1'}, X_{2'}, X_{3'}, and X_{4'} are independently bonded to one or no hydrogen atom according to valency, optionally wherein for Formula IIa or IIIa, X₂ and X_{2'} are nitrogen, X₁, X₃, X₄, X_{1'}, X_{3'}, and X_{4'} are carbon, and X₁, X₂, X₃, X₄, X_{1'}, X_{2'}, X_{3'}, and X_{4'} are independently bonded to one or no hydrogen atom according to valency.

7. The compound of any one of claims 4 to 6, wherein for Formula IIa or IIIa, R₁, R₂, R₃, R₄, R_{1'}, R_{2'}, R_{3'}, and R_{4'} are independently absent, hydrogen, deuterium, substituted alkyl (such as trifluoromethyl), unsubstituted alkyl, substituted aryl (such as mesityl (2,4,6-trimethylphenyl), 3,5-di-tert-butylphenyl, 2,6-dimethylphenyl), unsubstituted aryl, halogen (such as fluorine), or R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof,
optionally wherein for Formula IIa or IIIa, R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof,
further optionally wherein for Formula IIa or IIIa, R₁ and R₂ together, R₂ and R₃ together, R₃ and R₄ together, R_{1'} and R_{2'} together, R_{2'} and R_{3'} together, R_{3'} and R_{4'} together, or a combination thereof, with the atom to which they are attached, form: 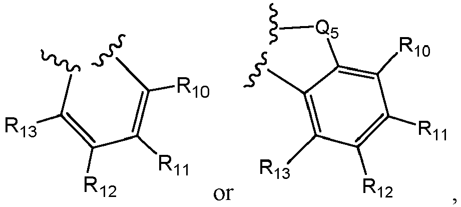 wherein Q₅ is NR₁₄, carbon, or sulfur, or oxygen; and R₁₀-R₁₄ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted C₁-C₂₀ heterocyclyl, or unsubstituted C₁-C₂₀ heterocyclyl, optionally wherein Q₅ is NR₁₄, carbon, or sulfur, or oxygen, such as oxygen; and R₁₀-R₁₄ are independently absent, hydrogen, substituted alkyl, or unsubstituted alkyl
further optionally, wherein Q₅ is oxygen; and R₁₀-R₁₄ are hydrogen.

8. The compound of claim 4 or claim 5, wherein for Formula IIb or IIIb:
(a) one or more of X₁, X₂, and X₃, and one or more of X_{1'}, X_{2'} and X_{3'} are sulfur, oxygen, or nitrogen, and X₁, X₂, X₃, X_{1'}, X_{2'} and X_{3'} are independently bonded to one or no hydrogen atom according to valency; and/or
(b)
(i) wherein for Formula IIb or IIIb, one of X₁, X₂, and X₃, and one of X_{1'}, X_{2'} and X_{3'} are sulfur, and X₁, X₂, X₃, X_{1'}, X_{2'} and X_{3'} are independently bonded to one or no hydrogen atom according to valency, or
(ii) wherein for Formula IIb or IIIb, one of X₁, X₂, and X₃, and one of X_{1'}, X_{2'} and X_{3'}, are oxygen, and X₁, X₂, X₃, X_{1'}, X_{2'}, and X_{3'} are independently bonded to one or no hydrogen atom according to valency;
and/or
(c) wherein for Formula Ilb or IIIb, R₁, R₂, R₃, R_{1'}, R_{2'}, and R_{3'} are independently absent, hydrogen, substituted alkyl, unsubstituted alkyl, substituted aryl, unsubstituted aryl, halogen, or R₁ and R₂ together, R₂ and R₃ together, R_{1'} and R_{2'} together, R_{2'} and R_{3'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof; and/or
(d) wherein for Formula IIb or IIIb, R₁, R₂, R₃, R_{1'}, R_{2'}, and R_{3'} are absent, hydrogen, or a combination thereof.

9. The compound of any one of claims 4, 5, or 8, wherein for Formula IIb or IIIb, R₁ and R₂ together, R₂ and R₃ together, R_{1'} and R_{2'} together, R_{2'} and R_{3'} together, or a combination thereof, with the atom to which they are attached, form a substituted aryl, an unsubstituted aryl, a substituted heteroaryl, an unsubstituted heteroaryl, a substituted C₁-C₂₀ heterocyclyl, an unsubstituted C₁-C₂₀ heterocyclyl, or fused combinations thereof, or wherein for Formula IIb or IIIb, R₁ and R₂ together, R₂ and R₃ together, R_{1'} and R_{2'} together, R_{2'} and R_{3'} together, or a combination thereof, with the atom to which they are attached, form: 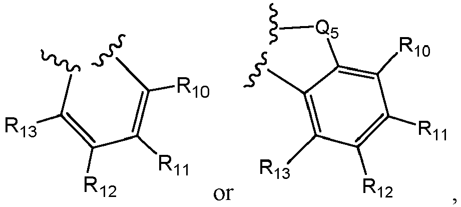 wherein Q₅ is NR₁₄, carbon, or sulfur, or oxygen; and R₁₀-R₁₄ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted C₁-C₂₀ heterocyclyl, or unsubstituted C₁-C₂₀ heterocyclyl, optionally
wherein Q₅ is NR₁₄, carbon, sulfur, or oxygen, such as sulfur, and R₁₀-R₁₄ are independently absent, hydrogen, substituted alkyl, or unsubstituted alkyl, further optionally
wherein Q₅ is sulfur; and R₁₀-R₁₄ are hydrogen.

10. The compound of any one of claims 1 to 4, wherein for Formula Ia, IIa, or IIb, the compound has a structure: 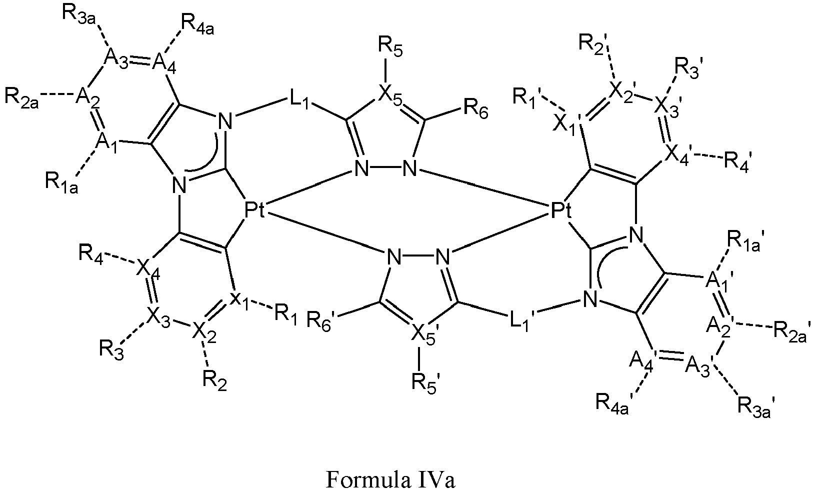 or 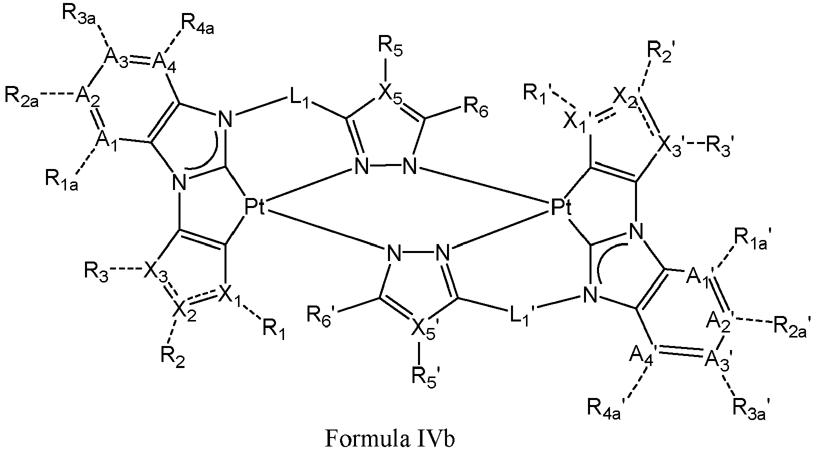 wherein:
A₁, A₂, A₃, A₄, A_{1'}, A_{2'}, A_{3'}, and A_{4'} are independently carbon, nitrogen, oxygen, or sulfur, and are independently bonded to one or no hydrogen atom according to valency, and
X₁, X₂, X₃, X₄, X_{1'}, X_{2'}, X_{3'}, and X_{4'} when present, are independently carbon, nitrogen, oxygen, or sulfur, and are independently bonded to one or no hydrogen atom according to valency.

11. The compound of claim 10, wherein for Formula IVa, A₁, A₂, A₃, A₄, A_{1'}, A_{2'}, A_{3'}, and A_{4'} are carbon, and are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency, and/or
wherein for Formula IVa, R₁, R₂, R₃, R₄, R_{1'}, R_{2'}, R_{3'}, and R_{4'} are independently absent, hydrogen, deuterium, substituted alkyl, unsubstituted alkyl, substituted aryl, unsubstituted aryl, or halogen, and/or
wherein for Formula IVa, R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, or unsubstituted aryl, or R₁ₐ and R₂ₐ together, R₂ₐ and R₃ₐ together, R₃ₐ and R₄ₐ together, R_{1a'} and R_{2a'} together, R_{2a'} and R_{3a'} together, R_{3a'} and R_{4a'} together, or a combination thereof, with the atom to which they are attached, form a substituted aryl, or an unsubstituted aryl, and/or
wherein for Formula IVa, R₁ₐ and R₂ₐ together, R₃ₐ and R₄ₐ together, R_{1a'} and R_{2a'} together, R_{3a'} and R_{4a'} together, with the atom to which they are attached, form a substituted aryl, or an unsubstituted aryl.

12. The compound of any one of claims 1 to 4 or 11, wherein
A. for Formula Ia, IIa, or IVa, one or more of A₁, A₂, A₃, and A₄ are nitrogen, one or more of A_{1'}, A_{2'}, A_{3'}, and A_{4'} are nitrogen, and A₁, A₂, A₃, A₄, A_{1'}, A_{2'}, A_{3'}, and A_{4'} are independently bonded to one or no hydrogen atom according to valency, and X₁, X₂, X₃, X₄, X_{1'}, X_{2'}, X_{3'}, and X_{4'} are carbon, and are independently bonded to one or no hydrogen atom according to valency, optionally
wherein for Formula IVa, R₁, R₂, R₃, R₄, R_{1'}, R_{2'}, R_{3'}, and R_{4'} are independently absent, hydrogen, deuterium, substituted alkyl, unsubstituted alkyl, substituted aryl (such as mesityl (2,4,6-trimethylphenyl), 3,5-di-tert-butylphenyl, 2,6-dimethylphenyl), unsubstituted aryl, or halogen (such as fluorine),
and/or
wherein R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, or unsubstituted aryl (such as phenyl),
and/or
(i) wherein for Formula IVa, one of A₁, A₂, A₃, and A₄ is nitrogen and the others are carbon, one of Ar, A_{2'}, A_{3'}, and A_{4'} is nitrogen and the others are carbon, and A₁, A₂, A₃, A₄, A_{1'}, A_{2'}, A_{3'}, and A_{4'} are independently bonded to one or no hydrogen atom according to valency, or
(ii) wherein for Formula IVa, two of A₁, A₂, A₃, and A₄ are nitrogen and the others are carbon, two of Ar, A_{2'}, A_{3'}, and A_{4'} are nitrogen and the others are carbon, and A₁, A₂, A₃, A₄, A_{1'}, A_{2'}, A_{3'}, and A_{4'} are independently bonded to one or no hydrogen atom according to valency,
or
B. wherein for Formula Ia, IIa, or IVa, one or more of A₁, A₂, A₃, and A₄ are oxygen, nitrogen, or sulfur, one or more of Ar, A_{2'}, A_{3'}, and A_{4'} are oxygen, nitrogen, or sulfur, and A₁, A₂, A₃, A₄, A_{1'}, A_{2'}, A_{3'}, and A_{4'} are independently bonded to one or no hydrogen atom according to valency, and one or more of X₁, X₂, X₃, X₄, X_{1'}, X_{2'}, X_{3'}, and X_{4'} are oxygen, nitrogen, or sulfur, and X₁, X₂, X₃, X₄, X_{1'}, X_{2'}, X_{3'}, and X_{4'} are independently bonded to one or no hydrogen atom according to valency, optionally
wherein for Formula IVa, R₁, R₂, R₃, R₄, R_{1'}, R_{2'}, R_{3'}, and R_{4'} are independently absent, hydrogen, deuterium, substituted alkyl, unsubstituted alkyl, substituted aryl, unsubstituted aryl, or halogen (such as fluorine), and/or
wherein R₁ₐ, R₂ₐ, R₃ₐ, R₄ₐ, R_{1a'}, R_{2a'}, R_{3a'}, and R_{4a'} are independently absent, hydrogen, deuterium, substituted alkyl, unsubstituted alkyl, substituted aryl, or unsubstituted aryl, and/or
wherein for Formula IVa, one or more of A₁, A₂, A₃, and A₄ are nitrogen, one or more of A_{1'}, A_{2'}, A_{3'}, and A_{4'} are nitrogen, and A₁, A₂, A₃, A₄, A_{1'}, A_{2'}, A_{3'}, and A_{4'} are independently bonded to one or no hydrogen atom according to valency, and one or more of X₁, X₂, X₃, X₄, X_{1'}, X_{2'}, X_{3'}, and X_{4'} are nitrogen, and X₁, X₂, X₃, X₄, X_{1'}, X_{2'}, X_{3'}, and X_{4'} are independently bonded to one or no hydrogen atom according to valency, and/or
wherein for Formula IVa, one of A₁, A₂, A₃, and A₄ is nitrogen and the others are carbon, one of Ar, A_{2'}, A_{3'}, and A_{4'} is nitrogen and the others are carbon, and A₁, A₂, A₃, A₄, A_{1'}, A_{2'}, A_{3'}, and A_{4'} are independently bonded to one or no hydrogen atom according to valency, and one of X₁, X₂, X₃, and X₄ is nitrogen and the others are carbon, one of X₁, X_{2'}, X_{3'}, and X_{4'} is nitrogen and the others are carbon, and X₁, X₂, X₃, X₄, X_{1'}, X_{2'}, X_{3'}, and X_{4'} are independently bonded to one or no hydrogen atom according to valency.

13. The compound of any one of claims 1 to 12, having a structure:

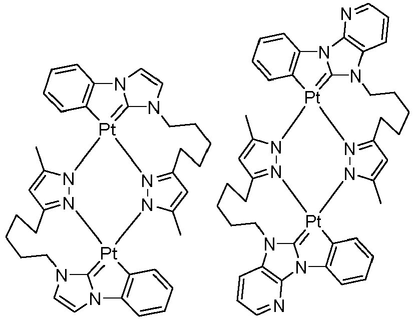

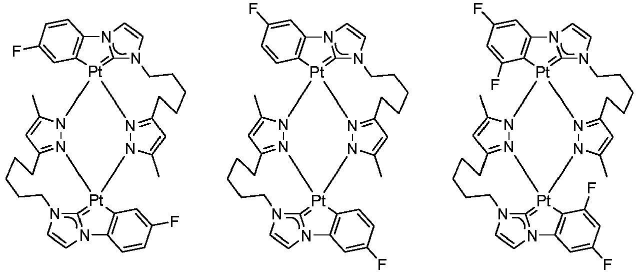

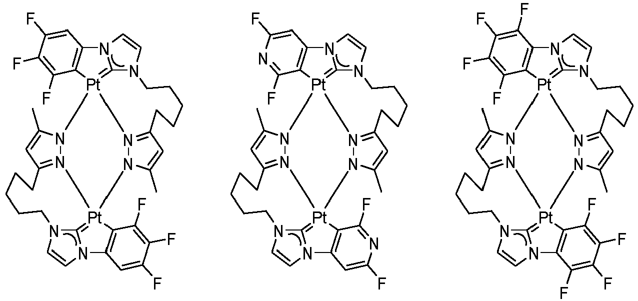

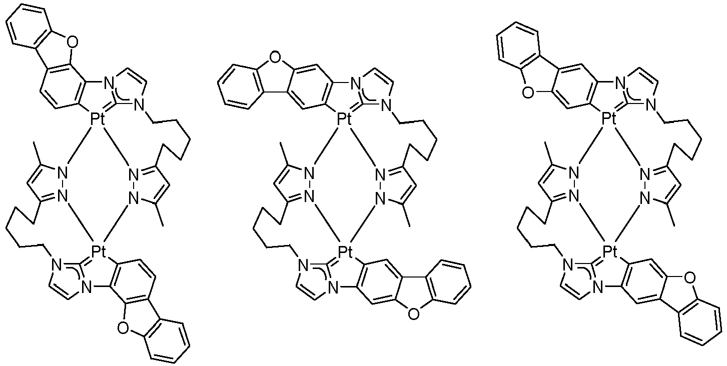

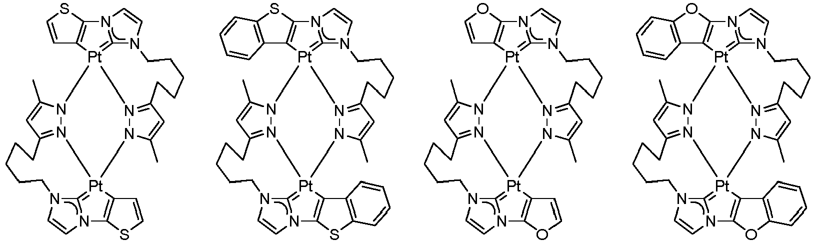

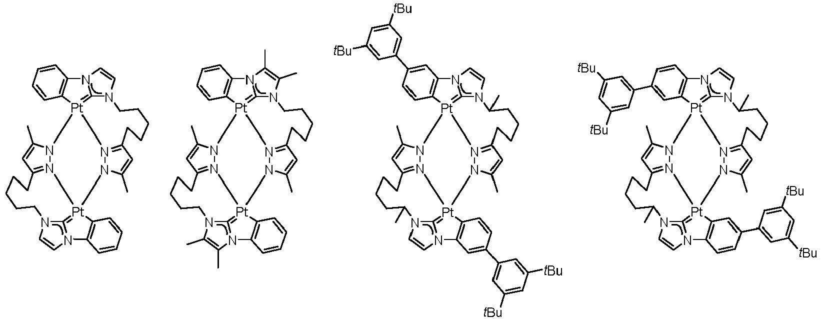

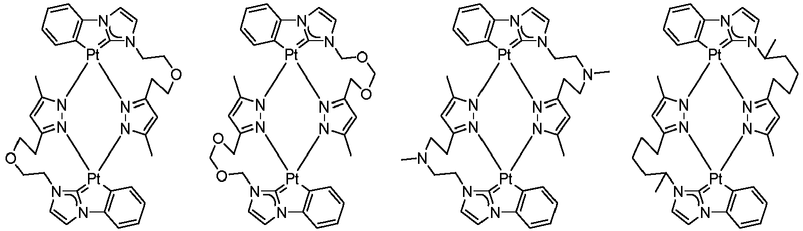

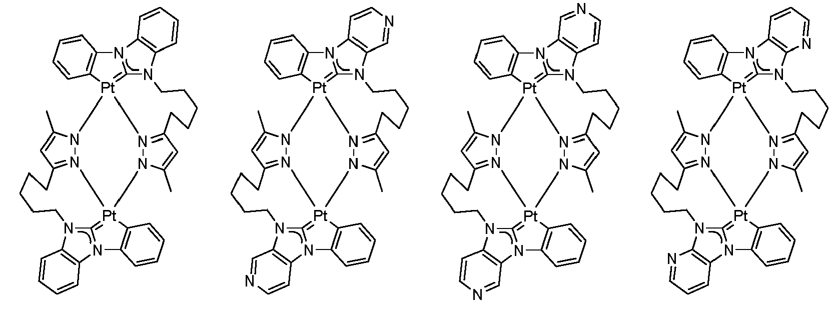

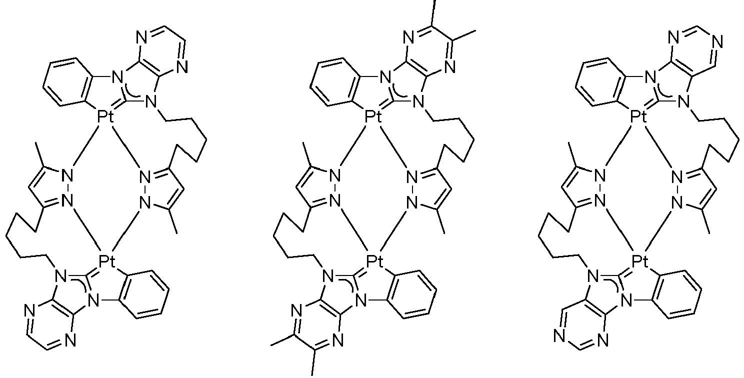

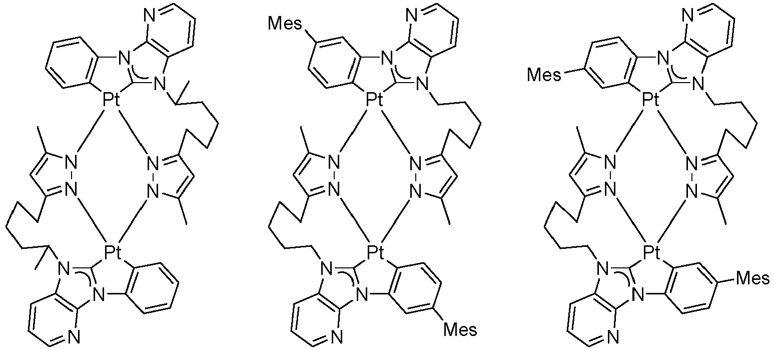

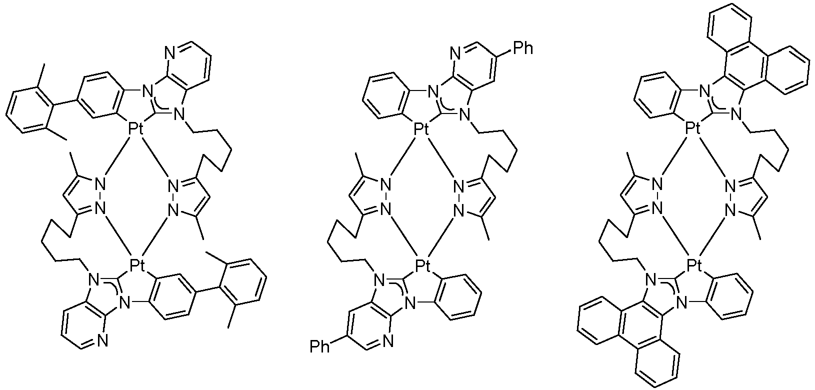

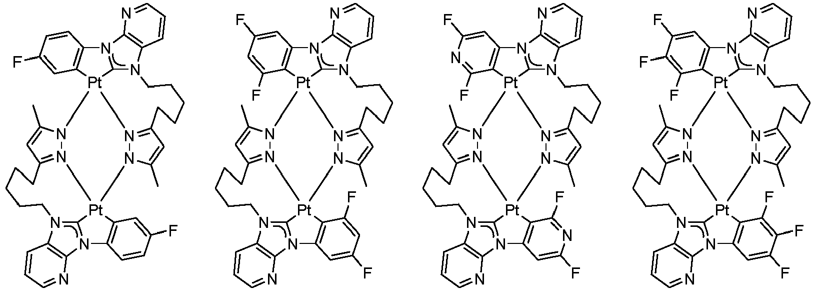

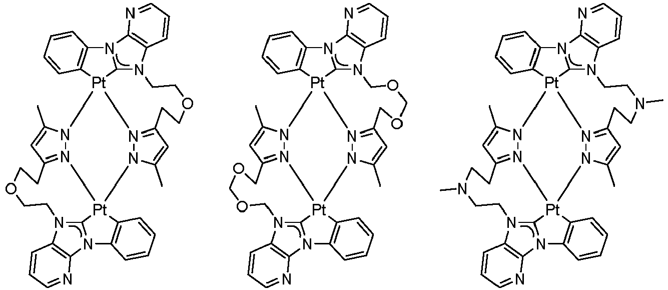

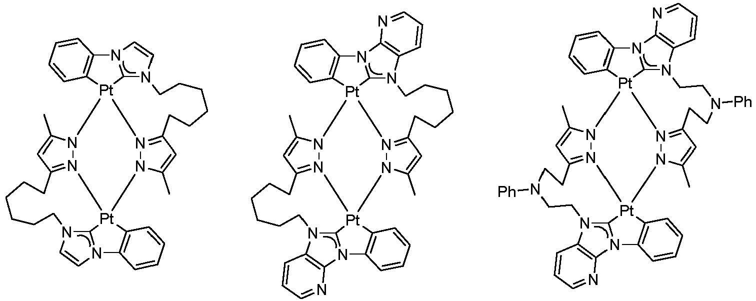

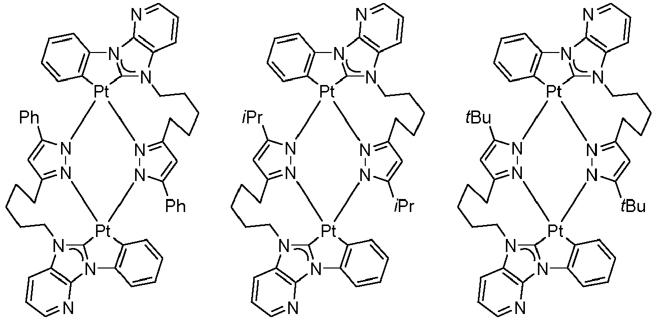

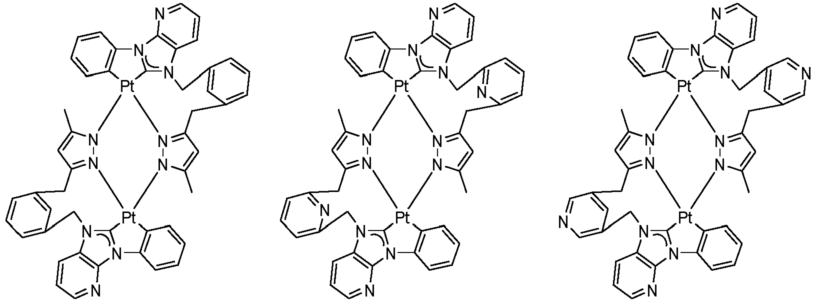

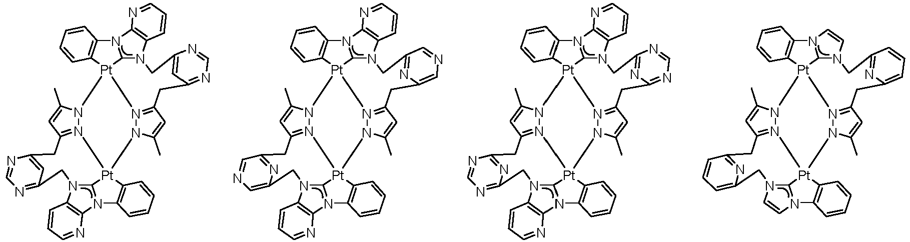

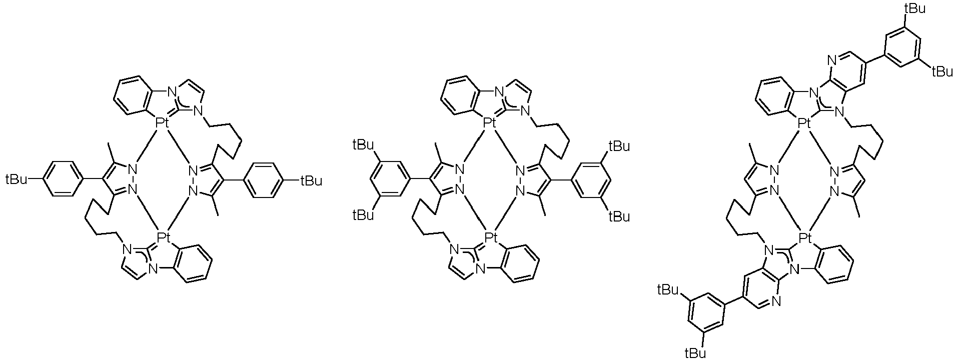

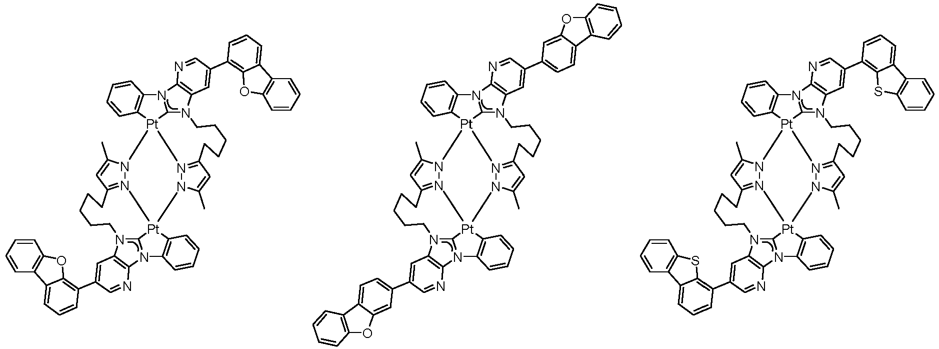

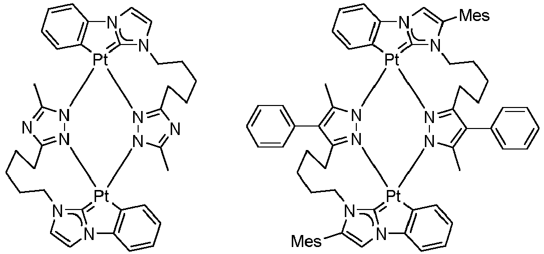

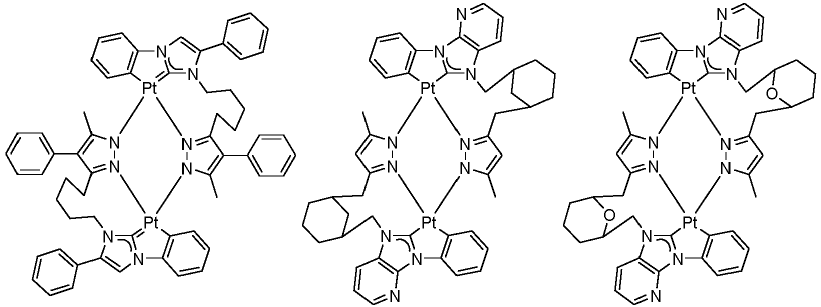

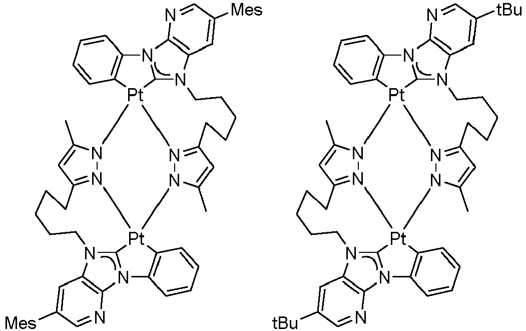

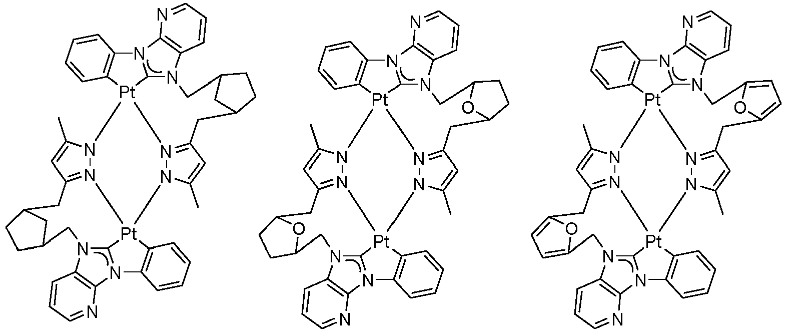

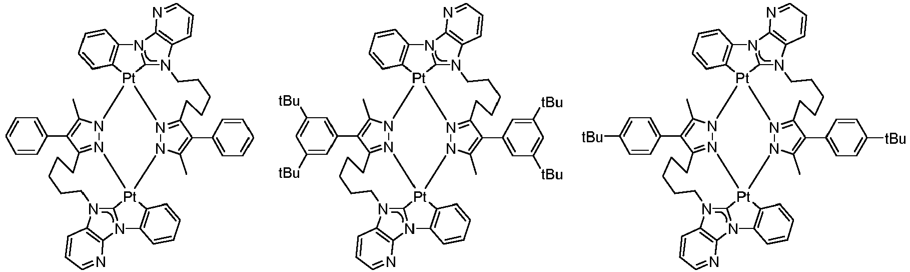

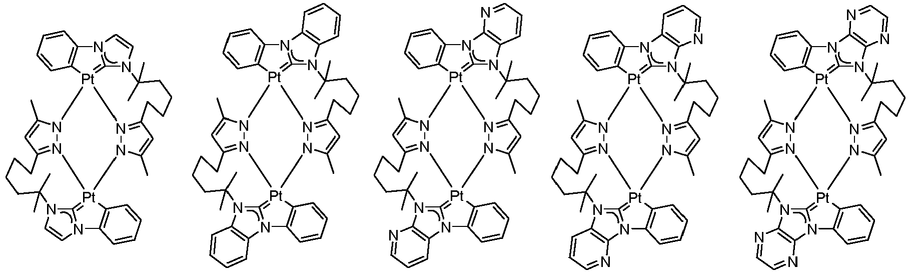

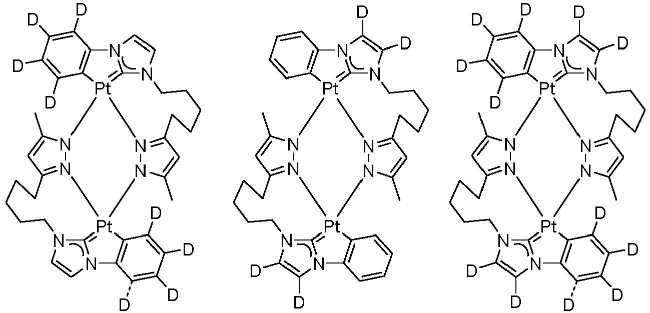

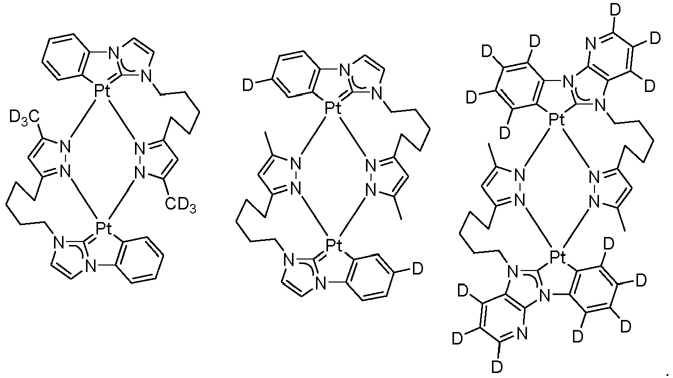

14. An organic electronic component comprising the compound of any one of claims 1 to 13, optionally
wherein the organic electronic component is an organic light-emitting diode (OLED) or a light-emitting electrochemical cell (LEEC), and/or
wherein the compounds are in a light-emitting layer, and/or
further comprising an anode, a cathode, a hole transport region, and an electron transport region,
wherein the hole transport region comprises a hole injection layer and/or a hole transport layer, and optionally an electron blocking layer,
wherein the electron transport region comprises an electron transport layer and/or an electron injection layer, and optionally a hole blocking layer,
wherein the light emitting layer is located in between the anode and the cathode,
wherein the hole transport region is located between the anode and the light-emitting layer, and wherein the electron transport region is located in between the cathode and the light-emitting layer,
optionally wherein the light-emitting layer is fabricated by vacuum deposition, spin-coating or ink printing (such as, ink-jet printing or roll-to-roll printing).

15. A light-emitting layer comprising the compound of any one of claims 1 to 13, optionally further comprising a pure organic emitter, wherein the compound:
(i) acts as a sensitizer to transfer energy to the pure organic emitter, or
(ii) has a higher-lying singlet state than the pure organic emitter.

16. An OLED, comprising the light-emitting layer of claim 15.

17. A device, comprising the OLED of claim 16, wherein the device is selected from stationary visual display units, mobile visual display units, illumination units, keyboards, clothes, ornaments, garment accessories, wearable devices, medical monitoring devices, wall papers, tablet computers, laptops, advertisement panels, panel display units, household appliances, or office appliances.

## Patentansprüche

1. Verbindung mit einer Struktur: 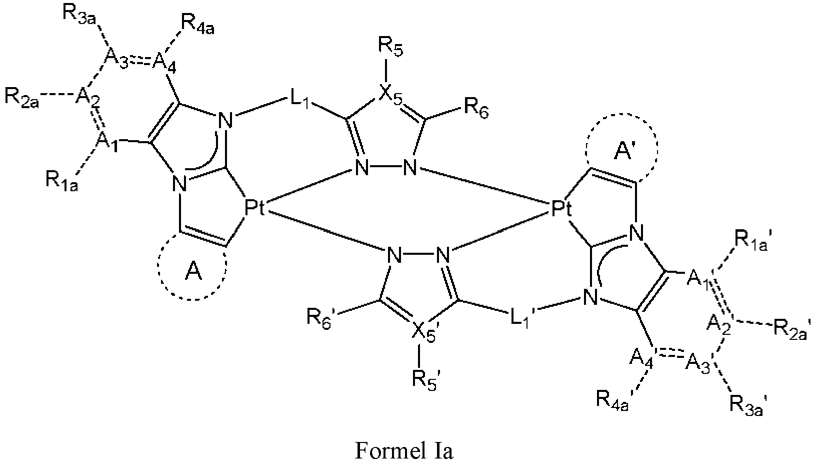 wobei:
die Verbindung eine insgesamt neutrale, negative oder positive Ladung aufweist,
die gestrichelten linearen Linien das Vorhandensein oder Fehlen einer Bindung bezeichnen,
A und A' unabhängig ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes C₁-C₂₀-Heterocyclyl, ein unsubstituiertes C₁-C₂₀-Heterocyclyl, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl oder kondensierte Kombinationen davon sind; bevorzugt A und A' unabhängig ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes C₁-C₂₀-Heterocyclyl, ein unsubstituiertes C₁-C₂₀-Heterocyclyl oder kondensierte Kombinationen davon sind,
X₅ und X_{5'} unabhängig Kohlenstoff oder Stickstoff sind und unabhängig je nach Wertigkeit an ein oder kein Wasserstoffatom gebunden sind, bevorzugt X₅ und X_{5'} Kohlenstoff sind,
R₅, R₆, R_{5'} und R_{6'} unabhängig nicht vorhanden, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Thiol, Cyano, Nitro-, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Alkylthio, substituiertes Alkylthio, unsubstituiertes Carbonyl, substituiertes Carbonyl, unsubstituiertes Carboxyl, substituiertes Carboxyl, unsubstituierter Ester, substituierter Ester, substituiertes C₃-C₂₀-Cycloalkyl, unsubstituiertes C₃-C₂₀-Cycloalkyl, substituiertes C₁-C₂₀-Heterocyclyl, unsubstituiertes C₁-C₂₀-Heterocyclyl, substituiertes C₃-C₂₀-Cycloalkenyl, unsubstituiertes C₃-C₂₀-Cycloalkenyl, substituiertes C₃-C₂₀-Cycloalkinyl, unsubstituiertes C₃-C₂₀-Cycloalkinyl sind oder R₅ und R₆ zusammen, R_{5'} und R_{6'} zusammen mit dem Atom, an das sie angeheftet sind, ein substituiertes Aryl, ein unsubstituiertes Aryl, ein substituiertes Heteroaryl, ein unsubstituiertes Heteroaryl, ein substituiertes C₁-C₂₀-Heterocyclyl, ein unsubstituiertes C₁-C₂₀-Heterocyclyl, kondensierte Kombinationen davon bilden oder bevorzugt R₅, R₆, R_{5'} und R_{6'} unabhängig nicht vorhanden, Wasserstoff, substituiertes Alkyl, unsubstituiertes Alkyl, substituiertes Aryl, unsubstituiertes Aryl sind,
A₁, A₂, A₃, A₄, A_{1'}, A_{2'}, A_{3'} und A_{4'} unabhängig nicht vorhanden, Wasserstoff, Deuterium, Kohlenstoff, Stickstoff, unsubstituiertes Aryl oder unsubstituiertes Aryl sind und, wenn vorhanden, unabhängig je nach Wertigkeit an ein, zwei, drei, vier, fünf oder kein Wasserstoffatom gebunden sind,
R₁ₐ, R₂ₐ, R₃ₐ, R₄ₐ, R_{1a'}, R_{2a'}, R_{3a'} und R_{4a'} unabhängig nicht vorhanden, Wasserstoff, Deuterium, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Thiol, Cyano, Nitro-, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Alkylthio, substituiertes Alkylthio, unsubstituiertes Carbonyl, substituiertes Carbonyl, unsubstituiertes Carboxyl, substituiertes Carboxyl, unsubstituierter Ester, substituierter Ester, substituiertes C₃-C₂₀-Cycloalkyl, unsubstituiertes C₃-C₂₀-Cycloalkyl, substituiertes C₁-C₂₀-Heterocyclyl, unsubstituiertes C₁-C₂₀-Heterocyclyl, substituiertes C₃-C₂₀-Cycloalkenyl, unsubstituiertes C₃-C₂₀-Cycloalkenyl, substituiertes C₃-C₂₀-Cycloalkinyl, unsubstituiertes C₃-C₂₀-Cycloalkinyl, unsubstituiertes C₁-C₂₀-Heterocyclyl, eine kondensierte Kombination davon (wie z. B. Dibenzofuran-4-yl, Dibenzofuran-3-yl, Dibenzothiopen-4-yl, Dibenzothiopen-3-yl *usw.*) sind oder R₁ₐ und R₂ₐ zusammen, R₂ₐ und R₃ₐ zusammen, R₃ₐ und R₄ₐ zusammen, R_{1a'} und R_{2a'} zusammen, R_{2a'} und R_{3a'} zusammen, R_{3a'} und R_{4a'} zusammen, oder eine Kombination davon, mit dem Atom, an das sie angeheftet sind, ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes C₁-C₂₀-Heterocyclyl, ein unsubstituiertes C₁-C₂₀-Heterocyclyl, kondensierte Kombinationen davon bilden oder R₁ₐ und R₂ₐ zusammen, R₂ₐ und R₃ₐ zusammen, R₃ₐ und R₄ₐ zusammen, R_{1a'} und R_{2a'} zusammen, R_{2a'} und R_{3a'} zusammen, R_{3a'} und R_{4a'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes C₁-C₂₀ Heterocyclyl, ein unsubstituiertes C₁-C₂₀-Heterocyclyl, kondensierte Kombinationen davon bilden, und
L₁ und L_{1'} unabhängig substituiertes Alkyl, unsubstituiertes Alkyl, substituiertes Alkenyl, unsubstituiertes Alkenyl, substituiertes Alkinyl, unsubstituiertes Alkinyl, unsubstituiertes Alkoxy, substituiertes Alkoxy, unsubstituiertes Aroxy, substituiertes Aroxy, unsubstituiertes Alkylthio, substituiertes Alkylthio, unsubstituiertes Carbonyl, substituiertes Carbonyl, unsubstituiertes Carboxyl, substituiertes Carboxyl, unsubstituierter Ester, substituierter Ester, unsubstituierter Ether, substituierter Ether, unsubstituierter Polyether, substituierter Polyether, substituiertes Amino, unsubstituiertes Amino, substituiertes Amid, unsubstituiertes Amid, substituiertes Aryl, unsubstituiertes Aryl, substituiertes Heteroaryl, unsubstituiertes Heteroaryl, substituiertes Polyaryl, unsubstituiertes Polyaryl, substituiertes Polyheteroaryl, unsubstituiertes Polyheteroaryl, substituiertes C₃-C₂₀-Cycloalkyl, unsubstituiertes C₃-C₂₀-Cycloalkyl, substituiertes C₁-C₂₀-Heterocyclyl, unsubstituiertes C₁-C₂₀-Heterocyclyl, substituiertes C₃-C₂₀-Cycloalkenyl, unsubstituiertes C₃-C₂₀-Cycloalkenyl, substituiertes C₃-C₂₀-Cycloalkinyl, unsubstituiertes C₃-C₂₀-Cycloalkinyl oder kondensierte Kombinationen davon sind.

2. Verbindung nach Anspruch 1, wobei L₁ und L₁' unabhängig substituiertes Alkyl oder unsubstituiertes Alkyl sind, optional
wobei L₁ und L₁' unabhängig substituiertes C₁-C₁₀-Alkyl, unsubstituiertes C₁-C₁₀-Alkyl, substituiertes C₂-C₁₀-Alkyl oder unsubstituiertes C₂-C₁₀-Alkyl sind, bevorzugt, wobei das substituierte Alkyl, substituierte C₁-C₁₀-Alkyl, substituierte C₂-C₁₀-Alkyl einen oder mehrere Alkylsubstituenten (wie z. B. Methyl, Ethyl, Propyl, Iso-Propyl, n-Butyl, sec-Butyl, tert-Butyl), eine oder mehrere Etherbindungen, eine oder mehrere Amingruppen (wie z. B. substituiertes Amin oder unsubstituiertes Amin), eine oder mehrere substituierte Arylgruppen, eine oder mehrere substituierte Heteroarylgruppen, eine oder mehrere substituierte C₃₋C₂₀-Cycloalkylgruppen, eine oder mehrere substituierte C₁-C₂₀-Heterocyclylgruppen oder eine Kombination davon enthält.

3. Verbindung nach Anspruch 1 oder Anspruch 2, wobei R₁ₐ, R₂ₐ, R₃ₐ, R₄ₐ, R_{1a'}, R_{2a'}, R_{3a'} und R_{4a'} unabhängig nicht vorhanden, Wasserstoff, Deuterium, substituiertes Alkyl, unsubstituiertes Alkyl, substituiertes Aryl oder unsubstituiertes Aryl sind oder R₁ₐ und R₂ₐ zusammen, R₂ₐ und R₃ₐ zusammen, R₃ₐ und R₄ₐ zusammen, R_{1a'} und R_{2a'} zusammen, R_{2a'} und R_{3a'} zusammen, R_{3a'} und R_{4a'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes C₁-C₂₀-Heterocyclyl, ein unsubstituiertes C₁-C₂₀-Heterocyclyl, kondensierte Kombinationen davon bilden.

4. Verbindung nach einem der Ansprüche 1 bis 3, mit einer Struktur: 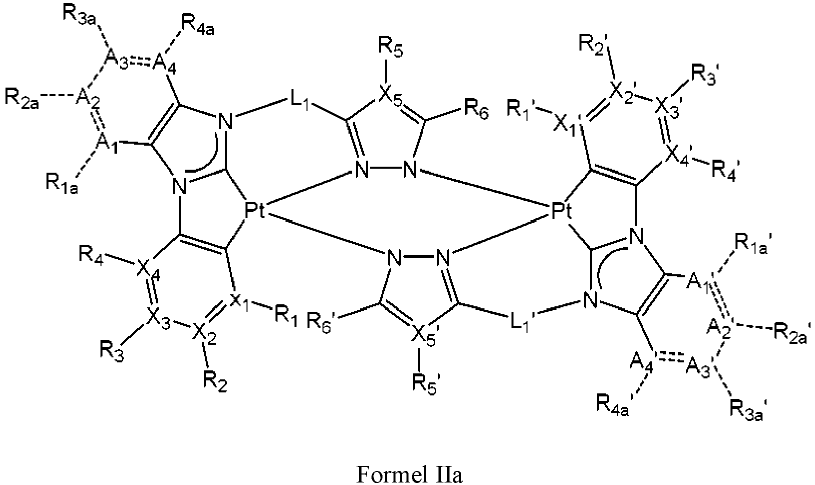 oder 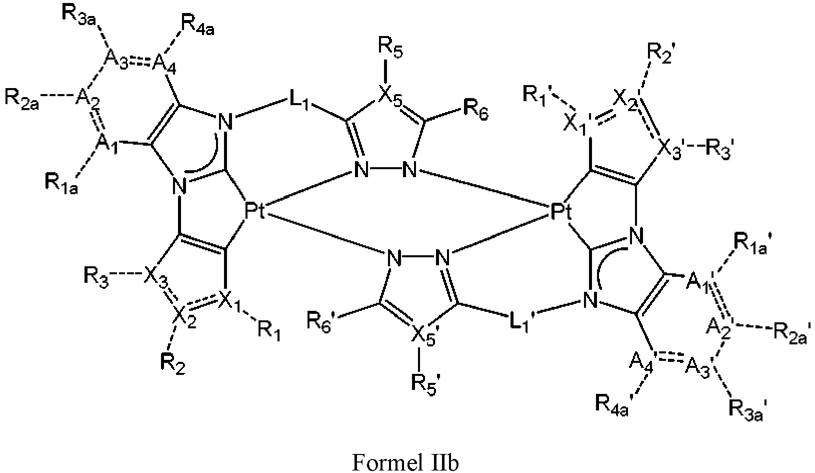 wobei:
die gestrichelten linearen Linien das Vorhandensein oder Fehlen einer Bindung bezeichnen,
X₁, X₂, X₃, X₄, X_{1'}, X_{2'}, X_{3'} und X_{4'}, wenn vorhanden, unabhängig Kohlenstoff, Stickstoff, Sauerstoff oder Schwefel sind und unabhängig je nach Wertigkeit an ein oder kein Wasserstoffatom gebunden sind,
R₁, R₂, R₃, R₄, R_{1'}, R_{2'}, R_{3'} und R_{4'} unabhängig nicht vorhanden, Wasserstoff, Deuterium, substituiertes Alkyl (wie z. B.Trifluormethyl), unsubstituiertes Alkyl, substituiertes Alkenyl, unsubstituiertes Alkenyl, substituiertes Alkinyl, unsubstituiertes Alkinyl, substituiertes Aryl (wie z. B. Mesityl (2,4,6-Trimethylphenyl), 3,5-Di-tert-butylphenyl, 2,6-Dimethylphenyl), unsubstituiertes Aryl, Halogen (wie z. B. Fluor), Hydroxyl, Thiol, Cyano, Nitro-, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Alkylthio, substituiertes Alkylthio, unsubstituiertes Carbonyl, substituiertes Carbonyl, unsubstituiertes Carboxyl, substituiertes Carboxyl, unsubstituierter Ester, substituierter Ester, substituiertes C₃-C₂₀-Cycloalkyl, unsubstituiertes C₃-C₂₀-Cycloalkyl, substituiertes C₁-C₂₀-Heterocyclyl, unsubstituiertes C₁-C₂₀-Heterocyclyl, substituiertes C₃-C₂₀-Cycloalkenyl, unsubstituiertes C₃-C₂₀-Cycloalkenyl, substituiertes C₃-C₂₀-Cycloalkinyl oder unsubstituiertes C₃-C₂₀-Cycloalkinyl sind oder R₁ und R₂ zusammen, R₂ und R₃ zusammen, R₃ und R₄ zusammen, R_{1'} und R_{2'} zusammen, R_{2'} und R_{3'} zusammen, R_{3'} und R_{4'} zusammen, oder eine Kombination davon, mit dem Atom, an das sie angeheftet sind, ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes C₁-C₂₀-Heterocyclyl, ein unsubstituiertes C₁-C₂₀-Heterocyclyl oder kondensierte Kombinationen davon bilden, optional
wobei R₁, R₂, R₃, R₄, R_{1'}, R_{2'}, R_{3'} und R_{4'} unabhängig nicht vorhanden, Wasserstoff, Deuterium, substituiertes Alkyl (wie z. B. Trifluormethyl), unsubstituiertes Alkyl, substituiertes Aryl (wie z. B. Mesityl (2,4,6-Trimethylphenyl), 3,5-Di-tert-butylphenyl, 2,6-Dimethylphenyl), unsubstituiertes Aryl, Halogen (wie z. B. Fluor) sind oder R₁ und R₂ zusammen, R₂ und R₃ zusammen, R₃ und R₄ zusammen, R_{1'} und R_{2'} zusammen, R_{2'} und R_{3'} zusammen, R_{3'} und R_{4'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes C₁-C₂₀-Heterocyclyl, ein unsubstituiertes C₁-C₂₀-Heterocyclyl oder kondensierte Kombinationen davon bilden.

5. Verbindung nach einem der Ansprüche 1 bis 4, mit einer Struktur: 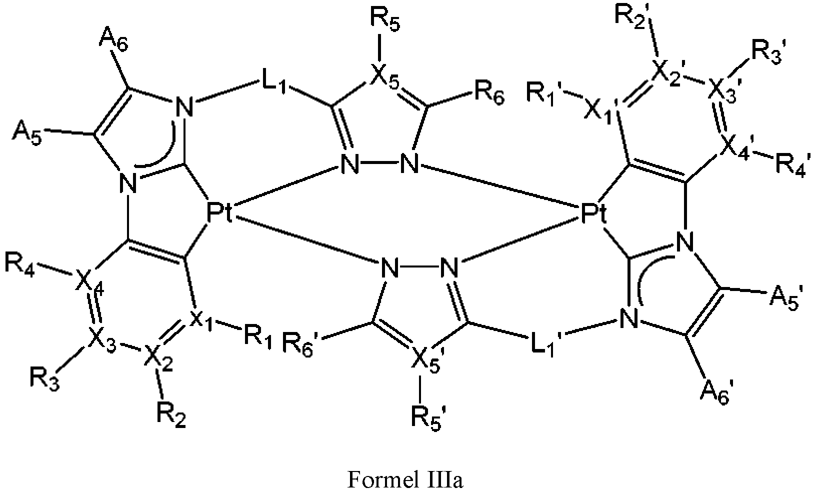 oder 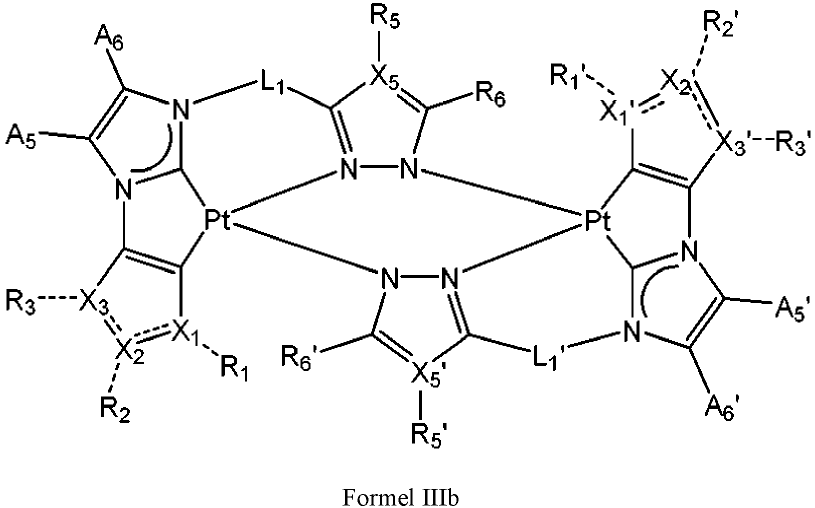 wobei:
die gestrichelten linearen Linien das Vorhandensein oder Fehlen einer Bindung bezeichnen,
A₅, A₆, A_{5'} und A_{6'} unabhängig Wasserstoff, Deuterium, unsubstituiertes Alkyl, substituiertes Alkyl, substituiertes Aryl, unsubstituiertes Aryl, unsubstituiertes Heteroaryl, substituiertes Heteroaryl, unsubstituiertes Polyheteroaryl, substituiertes Polyheteroaryl, substituiertes C₁-C₂₀-Heterocyclyl oder unsubstituiertes C₁₋C₂₀-Heterocyclyl, oder bevorzugt Wasserstoff, unsubstituiertes Alkyl, substituiertes Alkyl, Deuterium, substituiertes Aryl oder unsubstituiertes Aryl sind, optional
wobei A₅, A₆, A_{5'} und A_{6'} Wasserstoff oder Deuterium sind, oder
wobei A₅, A₆, A_{5'} und A_{6'} Folgendes sind:
(i) unsubstituiertes Alkyl (wie z. B. unsubstituiertes C₁-C₁₀-Alkyl, unsubstituiertes C₁-C₅-Alkyl oder unsubstituiertes C₁-C₃-Alkyl) oder substituiertes Alkyl (wie z. B. substituiertes C₁-C₁₀-Alkyl, substituiertes C₁-C₅-Alkyl oder substituiertes C₁-C₃-Alkyl), oder
(ii) Wasserstoff, substituiertes Aryl oder unsubstituiertes Aryl, mit der Maßgabe, dass mindestens eines von A₅ und A₆ oder A_{5'} und A_{6'} substituiertes Aryl oder unsubstituiertes Aryl ist.

6. Verbindung nach Anspruch 4 oder Anspruch 5, wobei,
(i) für Formel IIa oder IIIa, X₁, X₂, X₃, X₄, X_{1'}, X_{2'}, X_{3'} und X_{4'} Kohlenstoff sind und unabhängig je nach Wertigkeit an ein oder kein Wasserstoffatom gebunden sind, oder
(ii) wobei, für Formel IIa oder IIIa, ein oder mehrere von X₁, X₂, X₃ und X₄ und ein oder mehrere von X_{1'}, X_{2'}, X_{3'} und X_{4'} Stickstoff sind und X₁, X₂, X₃, X₄, X_{1'}, X_{2'}, X_{3'} und X_{4'} unabhängig je nach Wertigkeit an ein oder kein Wasserstoffatom gebunden sind, optional
wobei, für Formel IIa oder IIIa, X₂ und X_{2'} Stickstoff sind, X₁, X₃, X₄, X_{1'}, X_{3'} und X_{4'} Kohlenstoff sind und X₁, X₂, X₃, X₄, X_{1'}, X_{2'}, X_{3'} und X_{4'} unabhängig je nach Wertigkeit an ein oder kein Wasserstoffatom gebunden sind.

7. Verbindung nach einem der Ansprüche 4 bis 6, wobei, für Formel IIa oder IIIa, R₁, R₂, R₃, R₄, R_{1'}, R_{2'}, R_{3'} und R_{4'} unabhängig nicht vorhanden, Wasserstoff, Deuterium, substituiertes Alkyl (wie z. B. Trifluormethyl), unsubstituiertes Alkyl, substituiertes Aryl (wie z. B. Mesityl (2,4,6-Trimethylphenyl), 3,5-Di-tert-butylphenyl, 2,6-Dimethylphenyl), unsubstituiertes Aryl, Halogen (wie z. B. Fluor) sind oder R₁ und R₂ zusammen, R₂ und R₃ zusammen, R₃ und R₄ zusammen, R_{1'} und R_{2'} zusammen, R_{2'} und R_{3'} zusammen, R_{3'} und R_{4'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes C₁-C₂₀-Heterocyclyl, ein unsubstituiertes C₁-C₂₀-Heterocyclyl oder kondensierte Kombinationen davon bilden,
optional wobei, für Formel IIa oder IIIa, R₁ und R₂ zusammen, R₂ und R₃ zusammen, R₃ und R₄ zusammen, R_{1'} und R_{2'} zusammen, R_{2'} und R_{3'} zusammen, R_{3'} und R_{4'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes C₁-C₂₀-Heterocyclyl, ein unsubstituiertes C₁-C₂₀-Heterocyclyl oder kondensierte Kombinationen davon bilden,
ferner optional wobei, für Formel IIa oder IIIa, R₁ und R₂ zusammen, R₂ und R₃ zusammen, R₃ und R₄ zusammen, R_{1'} und R_{2'} zusammen, R_{2'} und R_{3'} zusammen, R_{3'} und R4_{'} zusammen, oder eine Kombination davon, mit dem Atom, an das sie angeheftet sind, Folgendes bilden: 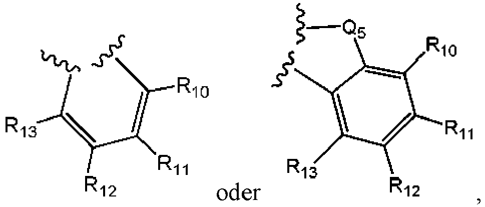
wobei Q₅ NR₁₄, Kohlenstoff oder Schwefel oder Sauerstoff ist; und R₁₀-R₁₄ unabhängig nicht vorhanden, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Amino, Amido, Ether, Thiol, Cyano, Nitro, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Carbonyl, substituiertes Carbonyl, unsubstituierter Ester, substituierter Ester, substituiertes C₁-C₂₀-Heterocyclyl oder unsubstituiertes C₁-C₂₀-Heterocyclyl sind, optional wobei Q₅ NR₁₄, Kohlenstoff oder Schwefel oder Sauerstoff ist, wie z. B. Sauerstoff; und R₁₀-R₁₄ unabhängig nicht vorhanden, Wasserstoff, substituiertes Alkyl oder unsubstituiertes Alkyl sind,
ferner optional, wobei Q₅ Sauerstoff ist; und R₁₀-R₁₄ Wasserstoff sind.

8. Verbindung nach Anspruch 4 oder Anspruch 5, wobei für Formel IIb oder IIIb:
(a) ein oder mehrere von X₁, X₂, und X₃ und ein oder mehrere von X_{1'}, X_{2'} und X_{3'} Schwefel, Sauerstoff oder Stickstoff sind und X₁, X₂, X₃, X_{1'}, X_{2'} und X_{3'} unabhängig je nach Wertigkeit an ein oder kein Wasserstoffatom gebunden sind; und/oder
(b)
(i) wobei, für Formel IIb oder IIIb, eines von X₁, X₂, und X₃ und eines von X_{1'}, X_{2'} und X_{3'} Schwefel sind und X₁, X₂, X₃, X_{1'}, X_{2'} und X_{3'} unabhängig je nach Wertigkeit an ein oder kein Wasserstoffatom gebunden sind, oder
(ii) wobei, für Formel IIb oder IIIb, eines von X₁, X₂ und X₃ und eines von X_{1'}, X_{2'} und X_{3'} Sauerstoff sind und X₁, X₂, X₃, X_{1'}, X₂, und X_{3'} unabhängig je nach Wertigkeit an ein oder kein Wasserstoffatom gebunden sind;
und/oder
(c) wobei, für Formel IIb oder IIIb, R₁, R₂, R₃, R₁, R_{2'} und R_{3'} unabhängig nicht vorhanden, Wasserstoff, substituiertes Alkyl, unsubstituiertes Alkyl, substituiertes Aryl, unsubstituiertes Aryl, Halogen sind oder R₁ und R₂ zusammen, R₂ und R₃ zusammen, R_{1'} und R_{2'} zusammen, R_{2'} und R_{3'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes C₁-C₂₀-Heterocyclyl, ein unsubstituiertes C₁-C₂₀-Heterocyclyl oder kondensierte Kombinationen davon bilden; und/oder
(d) wobei, für Formel IIb oder IIIb, R₁, R₂, R₃, R₁, R_{2'} und R_{3'} nicht vorhanden, Wasserstoff oder eine Kombination davon sind.

9. Verbindung nach einem der Ansprüche 4, 5 oder 8, wobei, für Formel IIb oder IIIb, R₁ und R₂ zusammen, R₂ und R₃ zusammen, R_{1'} und R_{2'} zusammen, R_{2'} und R_{3'} zusammen, oder eine Kombination davon, mit dem Atom, an das sie angeheftet sind, ein substituiertes Aryl, ein unsubstituiertes Aryl, ein substituiertes Heteroaryl, ein unsubstituiertes Heteroaryl, ein substituiertes C₁-C₂₀-Heterocyclyl, ein unsubstituiertes C₁-C₂₀-Heterocyclyl oder kondensierte Kombinationen davon bilden, oder
wobei, für Formel IIb oder IIIb, R₁ und R₂ zusammen, R₂ und R₃ zusammen, R_{1'} und R_{2'} zusammen, R_{2'} und R_{3'} zusammen, oder eine Kombination davon, mit dem Atom, an das sie angeheftet sind, Folgendes bilden: 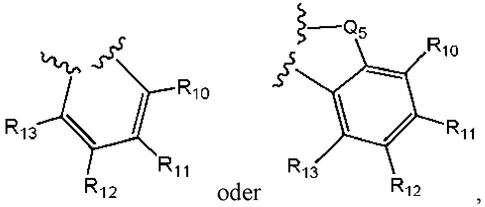
wobei Q₅ NR₁₄, Kohlenstoff oder Schwefel oder Sauerstoff ist; und R₁₀-R₁₄ unabhängig nicht vorhanden, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Amino, Amido, Ether, Thiol, Cyano, Nitro, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Carbonyl, substituiertes Carbonyl, unsubstituierter Ester, substituierter Ester, substituiertes C₁-C₂₀-Heterocyclyl oder unsubstituiertes C₁-C₂₀-Heterocyclyl sind, optional
wobei Q₅ NR₁₄, Kohlenstoff, Schwefel oder Sauerstoff ist, wie z. B. Schwefel, und R₁₀-R₁₄ unabhängig nicht vorhanden, Wasserstoff, substituiertes Alkyl oder unsubstituiertes Alkyl sind, ferner optional
wobei Q₅ Schwefel ist; und R₁₀-R₁₄ Wasserstoff sind.

10. Verbindung nach einem der Ansprüche 1 bis 4, wobei, für Formel Ia, IIa oder IIb, die Verbindung eine folgende Struktur aufweist: 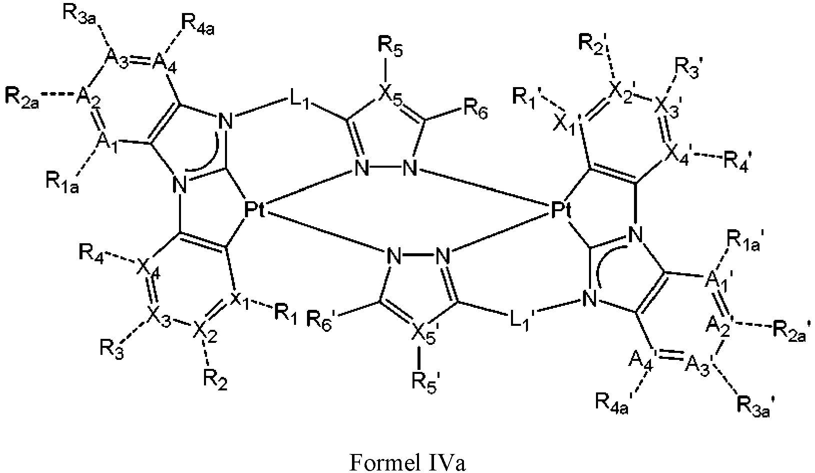 oder 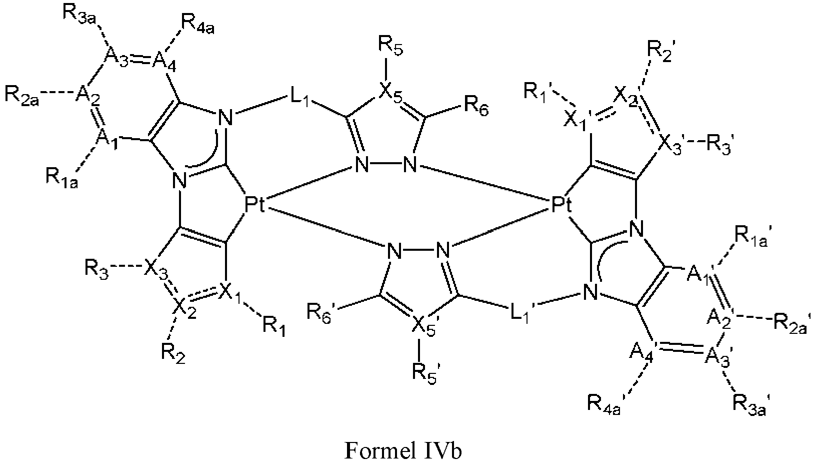 wobei:
A₁, A₂, A₃, A₄, A_{1'}, A_{2'}, A_{3'} und A_{4'} unabhängig Kohlenstoff, Stickstoff, Sauerstoff oder Schwefel sind und unabhängig je nach Wertigkeit an ein oder kein Wasserstoffatom gebunden sind, und
X₁, X₂, X₃, X₄, X_{1'}, X_{2'}, X_{3'} und X_{4'}, wenn vorhanden, unabhängig Kohlenstoff, Stickstoff, Sauerstoff oder Schwefel sind und unabhängig je nach Wertigkeit an ein oder kein Wasserstoffatom gebunden sind.

11. Verbindung nach Anspruch 10, wobei, für Formel IVa, A₁, A₂, A₃, A₄, A_{1'}, A_{2'}, A_{3'} und A_{4'} Kohlenstoff sind und unabhängig je nach Wertigkeit an ein oder kein Wasserstoffatom gebunden sind und X₁, X₂, X₃, X₄, X_{1'}, X_{2'}, X_{3'} und X_{4'} Kohlenstoff sind und unabhängig je nach Wertigkeit an ein oder kein Wasserstoffatom gebunden sind, und/oder
wobei, für Formel IVa, R₁, R₂, R₃, R₄, R_{1'}, R_{2'}, R_{3'} und R_{4'} unabhängig nicht vorhanden, Wasserstoff, Deuterium, substituiertes Alkyl, unsubstituiertes Alkyl, substituiertes Aryl, unsubstituiertes Aryl oder Halogen sind, und/oder
wobei, für Formel IVa, R₁ₐ, R₂ₐ, R₃ₐ, R₄ₐ, R_{1a'}, R_{2a'}, R_{3a',} und R_{4a'} unabhängig nicht vorhanden, Wasserstoff, Deuterium, substituiertes Alkyl, unsubstituiertes Alkyl, substituiertes Aryl oder unsubstituiertes Aryl sind oder R₁ₐ und R₂ₐ zusammen, R₂ₐ und R₃ₐ zusammen, R₃ₐ und R₄ₐ zusammen, R_{1a'} und R_{2a'} zusammen, R_{2a'} und K_{3a'}, zusammen, K_{3a'}, und R_{4a'} zusammen, oder eine Kombination davon, mit dem Atom, an das sie angeheftet sind, ein substituiertes Aryl oder ein unsubstituiertes Aryl bilden, und/oder
wobei, für Formel IVa, R₁ₐ und R₂ₐ zusammen, R₃ₐ und R₄ₐ zusammen, R_{1a'} und R_{2a'} zusammen, R_{3a'} und R_{4a'} zusammen mit dem Atom, an das sie angeheftet sind, ein substituiertes Aryl oder ein unsubstituiertes Aryl bilden.

12. Verbindung nach einem der Ansprüche 1 bis 4 oder 11, wobei,
A. für Formel Ia, IIa oder IVa, ein oder mehrere von A₁, A₂, A₃ und A₄ Stickstoff sind, ein oder mehrere von A_{1'}, A_{2'}, A_{3'} und A_{4'} Stickstoff sind und A₁, A₂, A₃, A₄, A_{1'}, A_{2'}, A_{3'} und A_{4'} unabhängig je nach Wertigkeit an ein oder kein Wasserstoffatom gebunden sind und X₁, X₂, X₃, X₄, X_{1'}, X_{2'}, X_{3'} und X_{4'} und Kohlenstoff sind und unabhängig je nach Wertigkeit an ein oder kein Wasserstoffatom gebunden sind, optional
wobei, für Formel IVa, R₁, R₂, R₃, R₄, R₁, R_{2'}, R_{3'} und R_{4'} unabhängig nicht vorhanden, Wasserstoff, Deuterium, substituiertes Alkyl, unsubstituiertes Alkyl, substituiertes Aryl (wie z. B. Mesityl (2,4,6-Trimethylphenyl), 3,5-Di-tert-butylphenyl, 2,6-Dimethylphenyl), unsubstituiertes Aryl oder Halogen (wie z. B. Fluor) sind,
und/oder
wobei R₁ₐ, R₂ₐ, R₃ₐ, R₄ₐ, R_{1a'}, R_{2a'}, R_{3a'} und R_{4a'} unabhängig nicht vorhanden, Wasserstoff, Deuterium, substituiertes Alkyl, unsubstituiertes Alkyl, substituiertes Aryl oder unsubstituiertes Aryl (wie z. B. Phenyl) sind, und/oder
(i) wobei, für Formel IVa, eines von A₁, A₂, A₃ und A₄ Stickstoff ist und die anderen Kohlenstoff sind, eines von A_{1'}, A_{2'}, A_{3'} und A_{4'} Stickstoff ist und die anderen Kohlenstoff sind und A₁, A₂, A₃, A₄, A_{1'}, A_{2'}, A_{3'} und A_{4'} unabhängig je nach Wertigkeit an ein oder kein Wasserstoffatom gebunden sind, oder
(ii) wobei, für Formel IVa, zwei von A₁, A₂, A₃ und A₄ Stickstoff und die anderen Kohlenstoff sind, zwei von A_{1'}, A_{2'}, A_{3'} und A_{4'} Stickstoff sind und die anderen Kohlenstoff sind und A₁, A₂, A₃, A₄, A_{1'}, A_{2'}, A_{3'} und A_{4'} unabhängig je nach Wertigkeit an ein oder kein Wasserstoffatom gebunden sind,
oder
B. wobei, für Formel Ia, IIa oder IVa, ein oder mehrere von A₁, A₂, A₃ und A4 Sauerstoff, Stickstoff oder Schwefel sind, ein oder mehrere von A_{1'}, A_{2'}, A_{3'} und A_{4'} Sauerstoff, Stickstoff oder Schwefel sind und A₁, A₂, A₃, A₄, A_{1'}, A_{2'}, A_{3'} und A_{4'} unabhängig je nach Wertigkeit an ein oder kein Wasserstoffatom gebunden sind und ein oder mehrere von X₁, X₂, X₃, X₄, X_{1'}, X_{2'}, X_{3'} und X_{4'} Sauerstoff, Stickstoff oder Schwefel sind und X₁, X₂, X₃, X₄, X_{1'}, X_{2'}, X_{3'} und X_{4'} unabhängig je nach Wertigkeit an ein oder kein Wasserstoffatom gebunden sind, optional
wobei, für Formel IVa, R₁, R₂, R₃, R₄, R₁, R_{2'}, R_{3'} und R_{4'} unabhängig nicht vorhanden, Wasserstoff, Deuterium, substituiertes Alkyl, unsubstituiertes Alkyl, substituiertes Aryl, unsubstituiertes Aryl oder Halogen (wie z. B. Fluor) sind, und/oder
wobei R₁ₐ, R₂ₐ, R₃ₐ, R₄ₐ, R_{1a'}, R_{2a'}, R_{3a'} und R_{4a'} unabhängig nicht vorhanden, Wasserstoff, Deuterium, substituiertes Alkyl, unsubstituiertes Alkyl, substituiertes Aryl oder unsubstituiertes Aryl sind, und/oder
wobei, für Formel IVa, ein oder mehrere von A₁, A₂, A₃ und A₄ Stickstoff sind, ein oder mehrere von A_{1'}, A_{2'}, A_{3'} und A_{4'} Stickstoff sind und A₁, A₂, A₃, A₄, A_{1'}, A_{2'}, A_{3'} und A_{4'} unabhängig je nach Wertigkeit an ein oder kein Wasserstoffatom gebunden sind und ein oder mehrere von X₁, X₂, X₃, X₄, X_{1'}, X_{2'}, X_{3'} und X_{4'} Stickstoff sind und X₁, X₂, X₃, X₄, X_{1'}, X_{2'}, X_{3'} und X_{4'} unabhängig je nach Wertigkeit an ein oder kein Wasserstoffatom gebunden sind, und/oder
wobei, für Formel IVa, eines von A₁, A₂, A₃ und A₄ Stickstoff ist und die anderen Kohlenstoff sind, eines von A_{1'}, A_{2'}, A_{3'} und A_{4'} Stickstoff ist und die anderen Kohlenstoff sind und A₁, A₂, A₃, A₄, A_{1'}, A_{2'}, A_{3'} und A_{4'} unabhängig je nach Wertigkeit an ein oder kein Wasserstoffatom gebunden sind und eines von X₁, X₂, X₃ und X₄ Stickstoff ist und die anderen Kohlenstoff sind, eines von X_{1'}, X_{2'}, X_{3'} und X_{4'} Stickstoff ist und die anderen Kohlenstoff sind und X₁, X₂, X₃, X₄, X_{1'}, X_{2'}, X_{3'} und X_{4'} unabhängig je nach Wertigkeit an ein oder kein Wasserstoffatom gebunden sind.

13. Verbindung nach einem der Ansprüche 1 bis 12, mit einer Struktur:

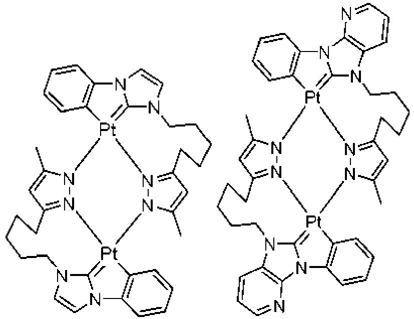

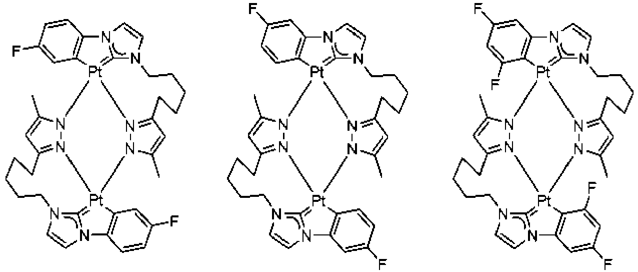

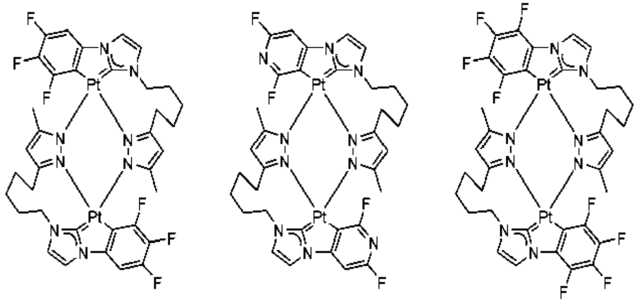

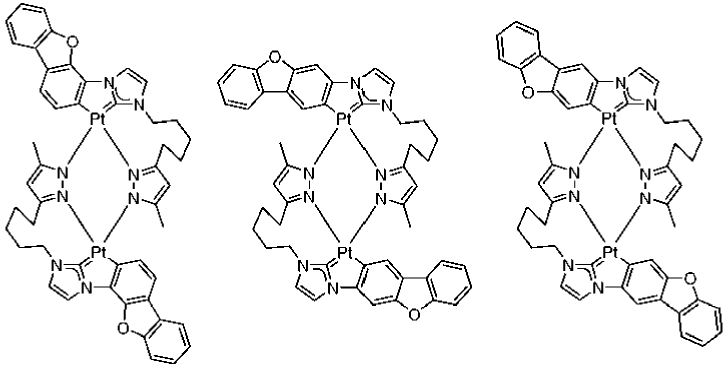

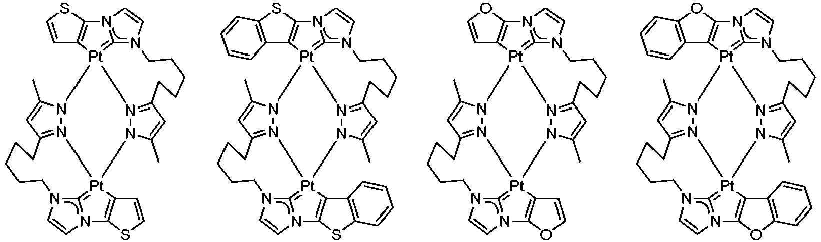

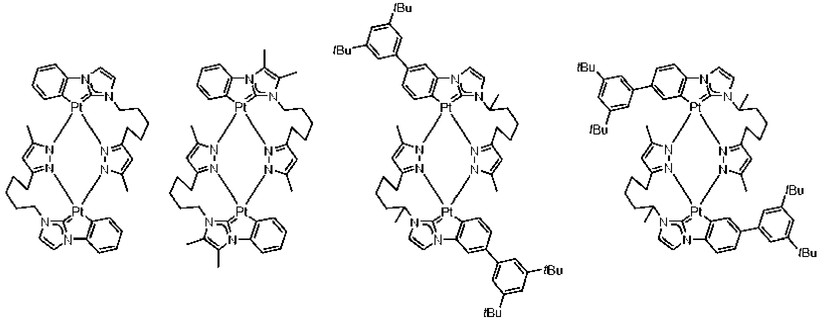

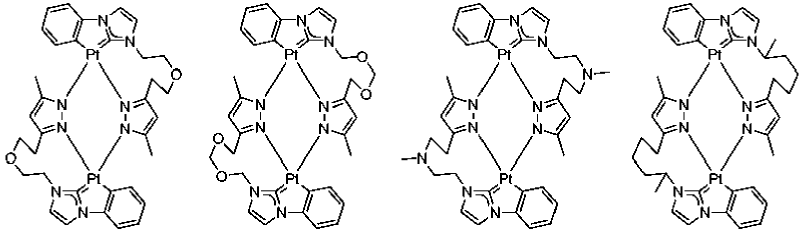

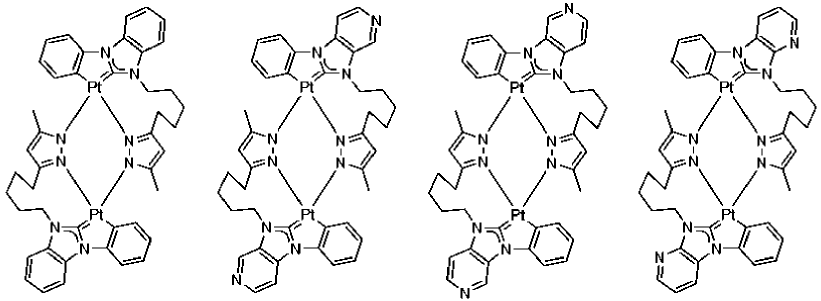

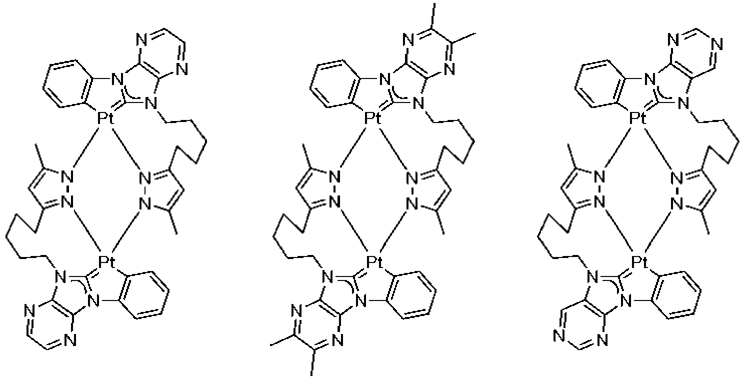

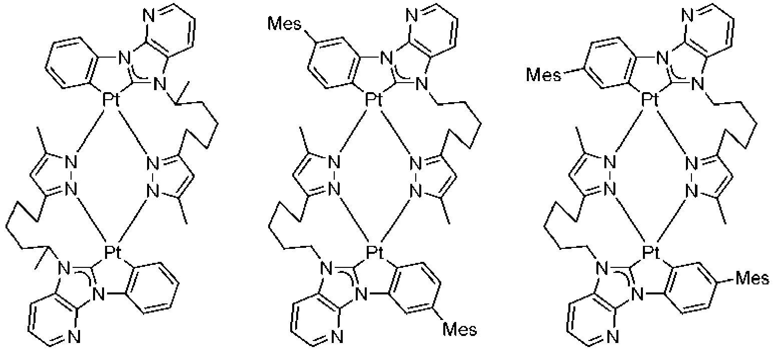

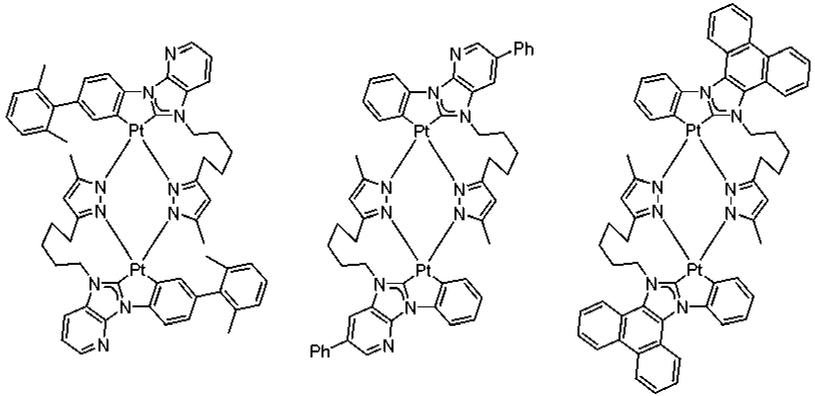

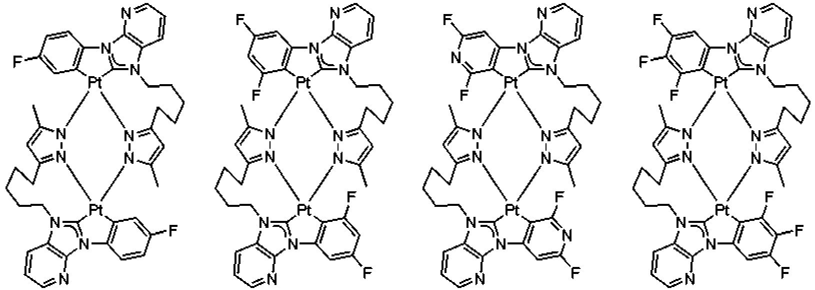

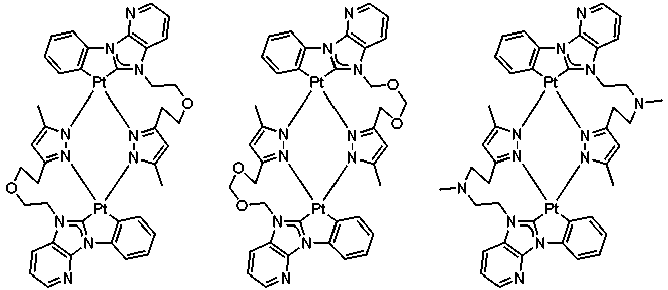

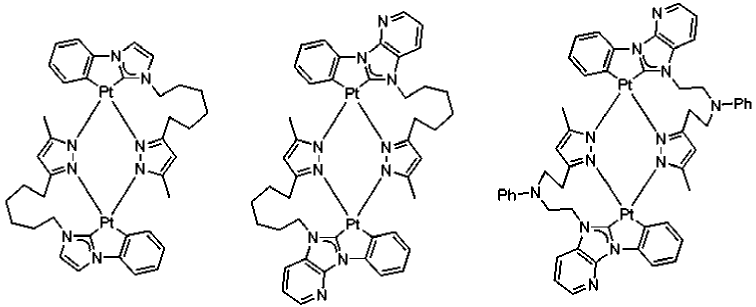

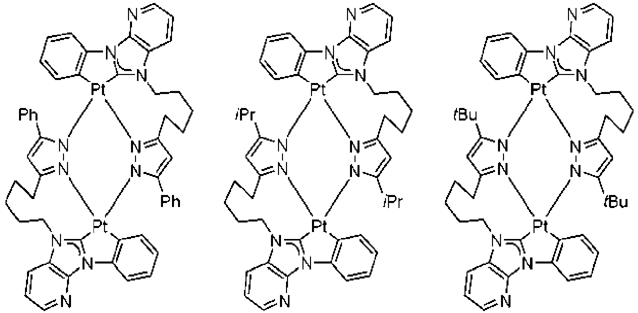

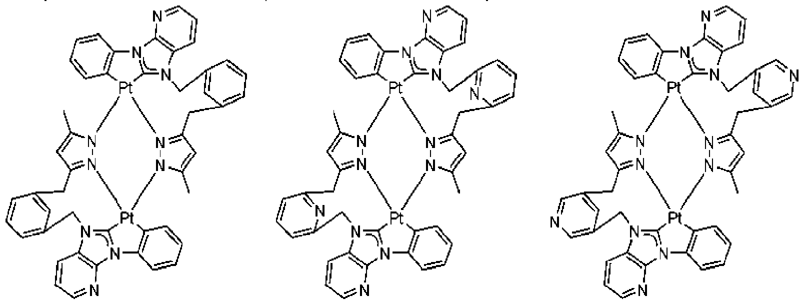

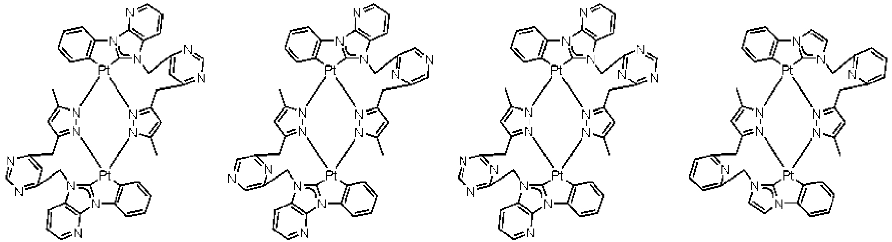

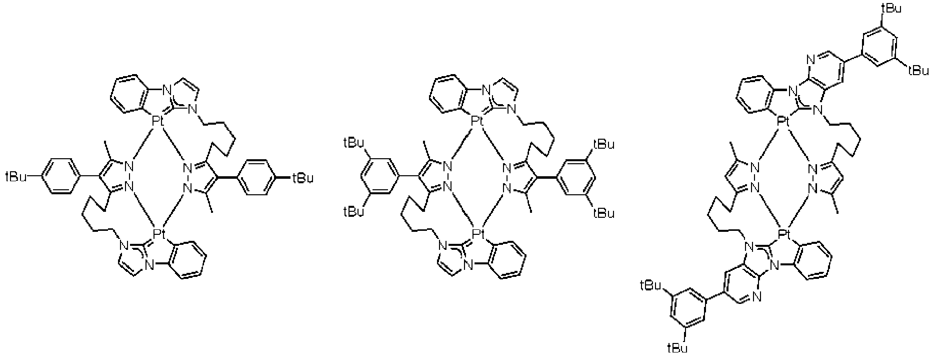

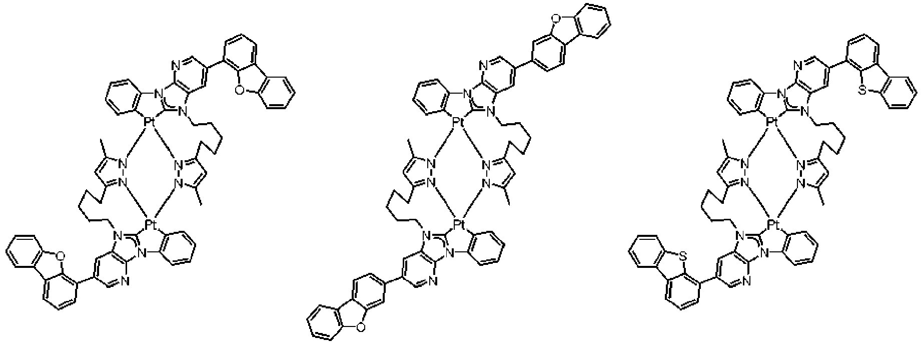

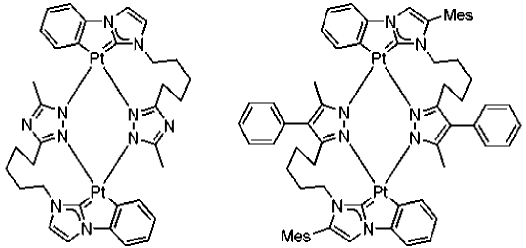

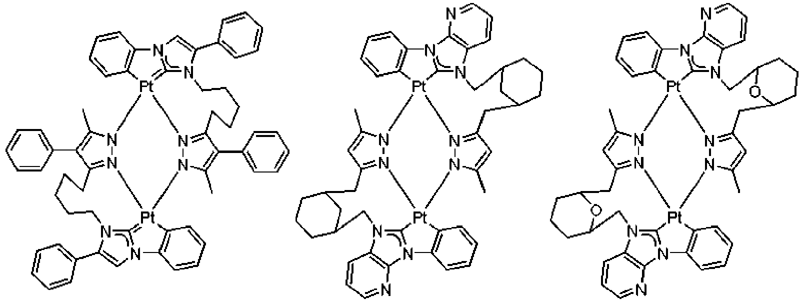

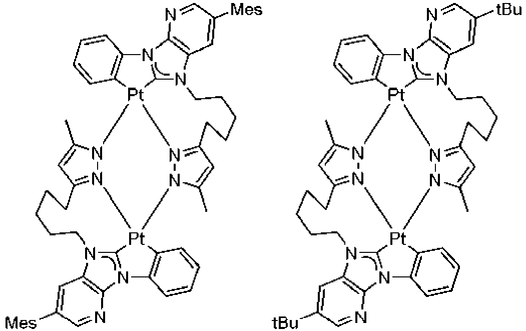

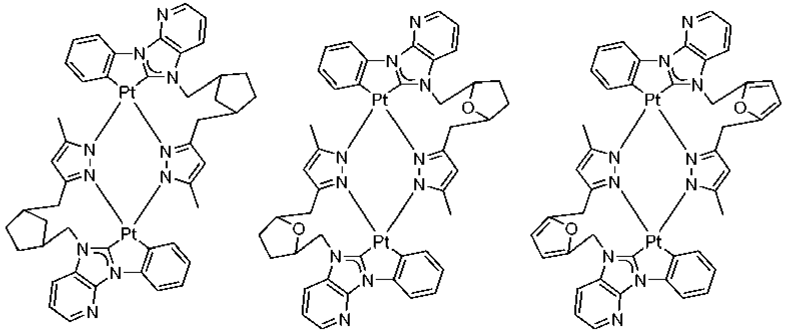

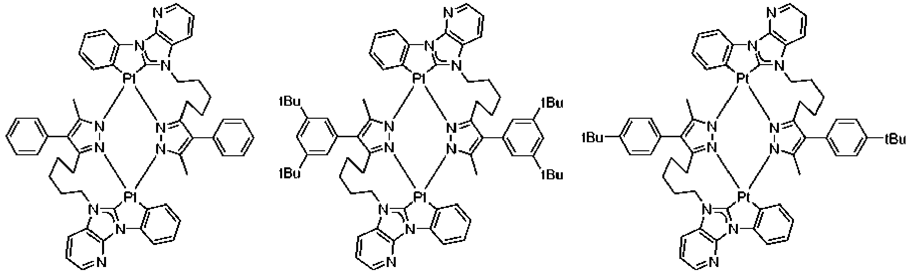

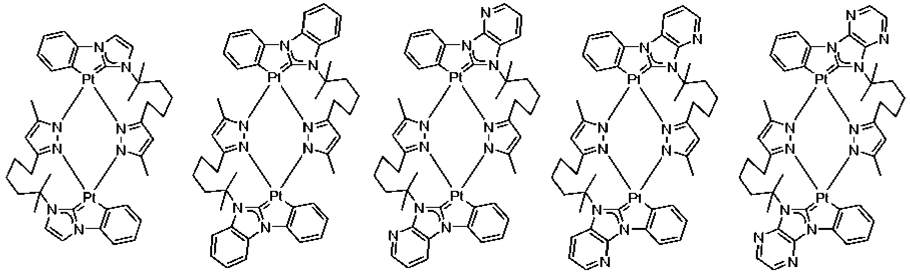

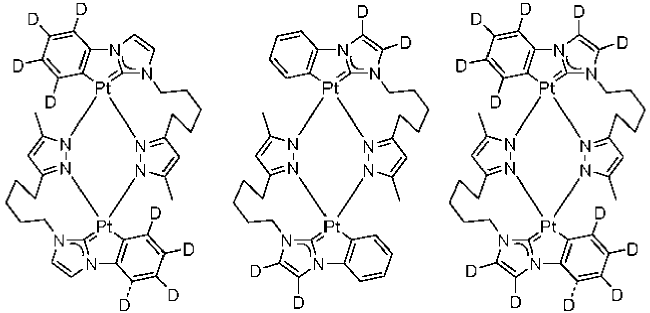

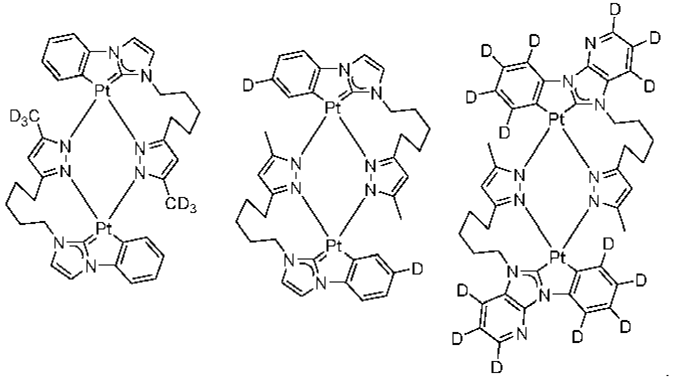

14. Organische elektronische Komponente, umfassend die Verbindung nach einem der Ansprüche 1 bis 13, optional,
wobei die organische elektronische Komponente eine organische lichtemittierende Diode (OLED) oder eine lichtemittierende elektrochemische Zelle (LEEC) ist, und/oder
wobei die Verbindungen in einer lichtemittierenden Schicht sind, und/oder
ferner umfassend eine Anode, eine Kathode, einen Lochtransportbereich und einen Elektronentransportbereich,
wobei der Lochtransportbereich eine Lochinjektionsschicht und/oder eine Lochtransportschicht und optional eine Elektronenblockierschicht umfasst,
wobei der Elektronentransportbereich eine Elektronentransportschicht und/oder eine Elektroneninjektionsschicht und optional eine Lochblockierschicht umfasst,
wobei die lichtemittierende Schicht zwischen der Anode und der Kathode befindlich ist,
wobei der Lochtransportbereich zwischen der Anode und der lichtemittierenden Schicht befindlich ist und wobei der Elektronentransportbereich zwischen der Kathode und der lichtemittierenden Schicht befindlich ist,
optional wobei die lichtemittierende Schicht durch Vakuumabscheidung, Rotationsbeschichtung oder Tintendruck (wie z. B. Tintenstrahldruck oder Rolle-zu-Rolle-Druck) hergestellt wird.

15. Lichtemittierende Schicht, umfassend die Verbindung nach einem der Ansprüche 1 bis 13, optional ferner umfassend einen reinen organischen Emitter, wobei die Verbindung:
(i) als Sensibilisator zur Übertragung von Energie an den reinen organischen Emitter fungiert, oder
(ii) einen höher liegenden Singulettzustand als der reine organische Emitter aufweist.

16. OLED, umfassend die lichtemittierende Schicht nach Anspruch 15.

17. Gerät, umfassend die OLED nach Anspruch 16, wobei das Gerät ausgewählt ist aus stationären visuellen Anzeigeeinheiten, mobilen visuellen Anzeigeeinheiten, Beleuchtungseinheiten, Tastaturen, Kleidern, Ornamenten, Bekleidungszubehör, tragbaren Geräten, medizinischen Überwachungsgeräten, Wallpapern, Tablet-Computern, Laptops, Werbetafeln, Tafelanzeigeeinheiten, Haushaltsgeräten oder Bürogeräten.

## Revendications

1. Composé ayant une structure : 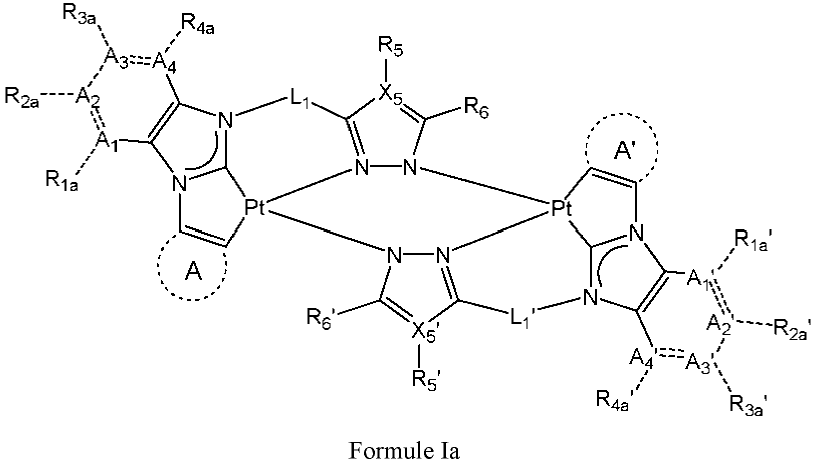 dans laquelle :
le composé a une charge globale neutre, négative ou positive,
les traits linéaires en tirets indiquent la présence ou l'absence d'une liaison,
A et A' sont indépendamment un cycloalkyle substitué, un cycloalkyle non substitué, un cycloalkényle substitué, un cycloalkényle non substitué, un cycloalkynyle substitué, un cycloalkynyle non substitué, un C₁-C₂₀ hétérocyclyle substitué, un C₁-C₂₀ hétérocyclyle non substitué, un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, ou des combinaisons fusionnées de ceux-ci ; de préférence A et A' sont indépendamment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un C₁-C₂₀ hétérocyclyle substitué, un C₁-C₂₀ hétérocyclyle non substitué, ou une combinaison fusionnée de ceux-ci,
X₅, et X_{5'}sont indépendamment carbone ou azote, et sont indépendamment liés à un ou aucun atome d'hydrogène selon la valence, de préférence X₅ et X_{5'}sont carbone,
R₅, R₆, R_{5'}, et R_{6'} sont indépendamment absents, hydrogène, alkyle substitué, alkyle non substitué, alkényle substitué, alkényle non substitué, alkynyle substitué, alkynyle non substitué, aryle substitué, aryle non substitué, halogène, hydroxyle, thiol, cyano, nitro-, alkoxy non substitué, alkoxy substitué, aroxy non substitué, aroxy substitué, hétéroaryle non substitué, hétéroaryle substitué, polyhétéroaryle non substitué, polyhétéroaryle substitué, alkylthio non substitué, alkylthio substitué, carbonyle non substitué, carbonyle substitué, carboxyle non substitué, carboxyle substitué, ester non substitué, ester substitué, C₃-C₂₀ cycloalkyle substitué, C₃-C₂₀ cycloalkyle non substitué, C₁-C₂₀hétérocyclyle substitué, C₁-C₂₀hétérocyclyle non substitué, C₃-C₂₀ cycloalkényle substitué, C₃-C₂₀ cycloalkényle non substitué, C₃-C₂₀ cycloalkynyle substitué, C₃-C₂₀ cycloalkynyle non substitué, ou R₅ et R₆ ensemble, R_{5'} et R_{6'} ensemble, avec l'atome auquel ils sont fixés, forment un aryle substitué, un aryle non substitué, un hétéroaryle substitué, un hétéroaryle non substitué, un C₁-C₂₀ hétérocyclyle substitué, un C₁-C₂₀ hétérocyclyle non substitué, des combinaisons fusionnées de ceux-ci, ou de préférence R₅, R₆, R_{5'} et R_{6'} sont indépendamment absents, hydrogène, alkyle substitué, alkyle non substitué, aryle substitué, aryle non substitué,
A₁, A₂, A₃, A₄, A_{1'}, A_{2'}, A_{3'} et A_{4'} sont indépendamment absents, hydrogène, deutérium, carbone, azote, aryle non substitué, ou aryle non substitué et, lorsqu'ils sont présents, sont indépendamment liés à un, deux, trois, quatre, cinq ou aucun atome(s) d'hydrogène selon la valence,
R₁ₐ, R₂ₐ, R₃ₐ, R₄ₐ, R_{1a'}, R_{2a'}, R_{3a',} et R_{4a'} sont indépendamment absents, hydrogène, deutérium, alkyle substitué, alkyle non substitué, alkényle substitué, alkényle non substitué, alkynyle substitué, alkynyle non substitué, aryle substitué, aryle non substitué, halogène, hydroxyle, thiol, cyano, nitro-, alkoxy non substitué, alkoxy substitué, aroxy non substitué, aroxy substitué, hétéroaryle non substitué, hétéroaryle substitué, polyhétéroaryle non substitué, polyhétéroaryle substitué, alkylthio non substitué, alkylthio substitué, carbonyle non substitué, carbonyle substitué, carboxyle non substitué, carboxyle substitué, ester non substitué, ester substitué, C₃-C₂₀ cycloalkyle substitué, C₃-C₂₀ cycloalkyle non substitué, C₁-C₂₀ hétérocyclyle substitué, C₁-C₂₀ hétérocyclyle non substitué, C₃-C₂₀ cycloalkényle substitué, C₃-C₂₀ cycloalkényle non substitué, C₃-C₂₀ cycloalkynyle substitué, C₃-C₂₀ cycloalkynyle non substitué, C₁-C₂₀ hétérocyclyle non substitué, une combinaison fusionnée de ceux-ci (tels que dibenzofuran-4-yle, dibenzofuran-3-yle, dibenzothiopen-4-yle, dibenzothiopen-3-yle, *etc*.), ou R₁ₐ et R₂ₐ ensemble, R₂ₐ et R₃ₐ ensemble, R₃ₐ et R₄ₐ ensemble, R_{1a'} et R_{2a'} ensemble, R_{2a'} et R_{3a'} ensemble, R_{3a'} et R_{4a'} ensemble, ou une combinaison de ceux-ci, avec l'atome auquel ils sont fixés, forment un cycloalkyle substitué, un cycloalkyle non substitué, un cycloalkényle substitué, un cycloalkényle non substitué, un cycloalkynyle substitué, un cycloalkynyle non substitué, un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un C₁-C₂₀ hétérocyclyle substitué, un C₁-C₂₀ hétérocyclyle non substitué, des combinaisons fusionnées de ceux-ci, ou R₁ₐ et R₂ₐ ensemble, R₂ₐ et R₃ₐ ensemble, R₃ₐ et R₄ₐ ensemble, R_{1a'} et R_{2a'} ensemble, R_{2a'} et R_{3a'} ensemble, R_{3a'} et R_{4a'} ensemble, ou une combinaison de ceux-ci, avec l'atome auquel ils sont fixés, forment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un C₁-C₂₀ hétérocyclyle substitué, un C₁-C₂₀ hétérocyclyle non substitué, des combinaisons fusionnées de ceux-ci, et
L₁ et L_{1'} sont indépendamment alkyle substitué, alkyle non substitué, alkényle substitué, alkényle non substitué, alkynyle substitué, alkynyle non substitué, alkoxy non substitué, alkoxy substitué, aroxy non substitué, aroxy substitué, alkylthio non substitué, alkylthio substitué, carbonyle non substitué, carbonyle substitué, carboxyle non substitué, carboxyle substitué, ester non substitué, ester substitué, éther non substitué, éther substitué, polyéther non substitué, polyéther substitué, amino substitué, amino non substitué, amide substitué, amide non substitué, aryle substitué, aryle non substitué, hétéroaryle substitué, hétéroaryle non substitué, polyaryle substitué, polyaryle non substitué, polyhétéroaryle substitué, polyhétéroaryle non substitué, C₃-C₂₀ cycloalkyle substitué, C₃-C₂₀ cycloalkyle non substitué, C₁-C₂₀ hétérocyclyle substitué, C₁-C₂₀ hétérocyclyle non substitué, C₃-C₂₀ cycloalkényle substitué, C₃-C₂₀ cycloalkényle non substitué, C₃-C₂₀ cycloalkynyle substitué, C₃-C₂₀ cycloalkynyle non substitué, ou des combinaisons fusionnées de ceux-ci.

2. Composé selon la revendication 1, dans lequel L₁ et L₁' sont indépendamment alkyle substitué ou alkyle non substitué, éventuellement
dans lequel L₁ et L₁' sont indépendamment C₁-C₁₀ alkyle substitué, C₁-C₁₀ alkyle non substitué, C₂-C₁₀ alkyle substitué ou C₂-C₁₀ alkyle non substitué, de préférence dans lequel l'alkyle substitué, le C₁-C₁₀ alkyle substitué, le C₂-C₁₀ alkyle substitué contient un ou plusieurs substituants d'alkyle (tels que méthyle, éthyle, propyle, iso-propyle, n-butyle, sec-butyle, tert-butyle), une ou plusieurs liaisons d'éther, un ou plusieurs groupes amine (tels qu'amine substitué ou amine non substitué), un ou plusieurs groupes aryle substitué, un ou plusieurs groupes hétéroaryle substitué, un ou plusieurs groupes C₃-C₂₀ cycloalkyle substitué, un ou plusieurs groupes C₁-C₂₀ hétérocyclyle substitué, ou une combinaison de ceux-ci.

3. Composé selon la revendication 1 ou la revendication 2, dans lequel R₁ₐ, R₂ₐ, R₃ₐ, R₄ₐ, R_{1a'}, R_{2a'}, R_{3a'} et R_{4a'} sont indépendamment absents, hydrogène, deutérium, alkyle substitué, alkyle non substitué, aryle substitué ou aryle non substitué, ou R₁ₐ et R₂ₐ ensemble, R₂ₐ et R₃ₐ ensemble, R₃ₐ et R₄ₐ ensemble, R_{1a'} et R₂ₐ ensemble, R_{2a'} et R_{3a'} ensemble, R_{3a'} et R_{4a'} ensemble, ou une combinaison de ceux-ci, avec l'atome auquel ils sont fixés, forment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un C₁-C₂₀ hétérocyclyle substitué, un C₁-C₂₀ hétérocyclyle non substitué, des combinaisons fusionnées de ceux-ci.

4. Composé selon l'une quelconque des revendications 1 à 3, ayant une structure : 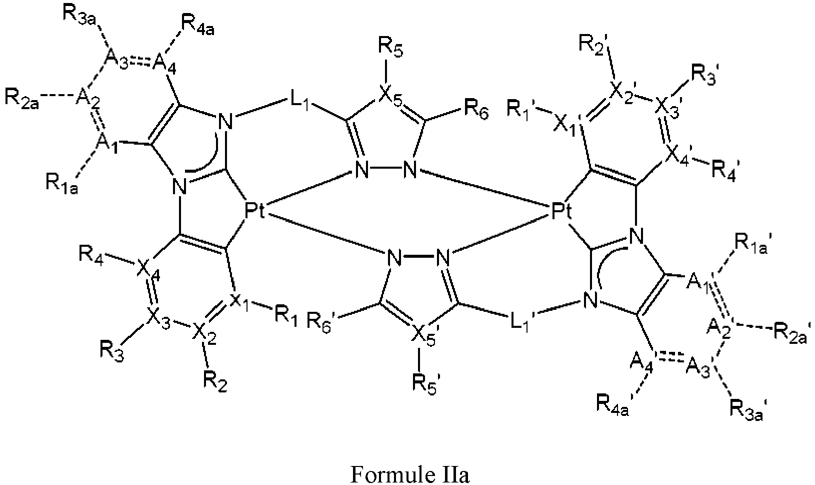 ou 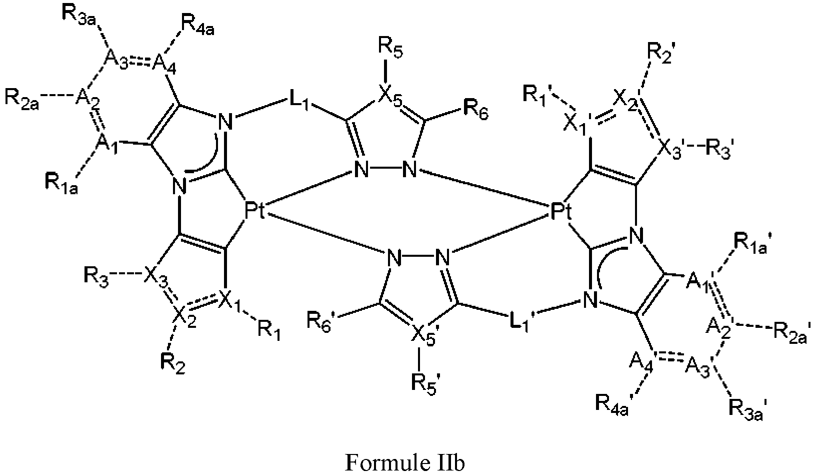 dans laquelle :
les traits linéaires en tirets désignent la présence ou l'absence d'une liaison, X₁, X₂, X₃, X₄, X_{1'}, X_{2'}, X_{3'}, et X_{4'}, quand ils sont présents, sont indépendamment carbone, azote, oxygène ou soufre, et sont indépendamment liés à un ou aucun atome d'hydrogène selon la valence,
R₁, R₂, R₃, R₄, R_{1'}, R_{2'}, R_{3'} et R_{4'} sont indépendamment absents, hydrogène, deutérium, alkyle substitué (tel que trifluorométhyle), alkyle non substitué, alkényle substitué, alkényle non substitué, alkynyle substitué, alkynyle non substitué, aryle substitué (tel que mésityle (2,4,6-triméthylphényle), 3,5-di-*tert*-butylphényle, 2,6-diméthylphényle), aryle non substitué, halogène (tel que fluor), hydroxyle, thiol, cyano, nitro-, alkoxy non substitué, alkoxy substitué, aroxy non substitué, aroxy substitué, hétéroaryle non substitué, hétéroaryle substitué, polyhétéroaryle non substitué, polyhétéroaryle substitué, alkylthio non substitué, alkylthio substitué, carbonyle non substitué, carbonyle substitué, carboxyle non substitué, carboxyle substitué, ester non substitué, ester substitué, C₃-C₂₀ cycloalkyle substitué, C₃-C₂₀ cycloalkyle non substitué, C₁-C₂₀ hétérocyclyle substitué, C₁-C₂₀hétérocyclyle non substitué, C₃-C₂₀ cycloalkényle substitué, C₃-C₂₀ cycloalkényle non substitué, C₃-C₂₀ cycloalkynyle substitué, ou C₃-C₂₀ cycloalkynyle non substitué, ou R₁ et R₂ ensemble, R₂ et R₃ ensemble, R₃ et R₄ ensemble, R_{1'} et R_{2'} ensemble, R_{2'} et R_{3'} ensemble, R_{3'} et R_{4'} ensemble, ou une combinaison de ceux-ci, avec l'atome auquel ils sont fixés, forment un cycloalkyle substitué, un cycloalkyle non substitué, un cycloalkényle substitué, un cycloalkényle non substitué, un cycloalkynyle substitué, un cycloalkynyle non substitué, un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un C₁-C₂₀ hétérocyclyle substitué, un C₁-C₂₀ hétérocyclyle non substitué, ou des combinaisons fusionnées de ceux-ci, éventuellement
dans lequel R₁, R₂, R₃, R₄, R_{1'}, R_{2'}, R_{3'} et R_{4'} sont indépendamment absents, hydrogène, deutérium, alkyle substitué (tel que trifluorométhyle), alkyle non substitué, aryle substitué (tel que mésityle (2,4,6-triméthylphényle), 3,5-di-*tert*-butylphényle, 2,6-diméthylphényle), aryle non substitué, halogène (tel que fluor), ou R₁ et R₂ ensemble, R₂ et R₃ ensemble, R₃ et R₄ ensemble, R_{1'} et R_{2'} ensemble, R_{2'} et R_{3'} ensemble, R_{3'} et R_{4'} ensemble, ou une combinaison de ceux-ci, avec l'atome auquel ils sont fixés, forment un aryle substitué, un aryle non substitué, un hétéroaryle substitué, un hétéroaryle non substitué, un C₁-C₂₀ hétérocyclyle substitué, un C₁-C₂₀ hétérocyclyle non substitué, ou des combinaisons fusionnées de ceux-ci.

5. Composé selon l'une quelconque des revendications 1 à 4, ayant une structure : 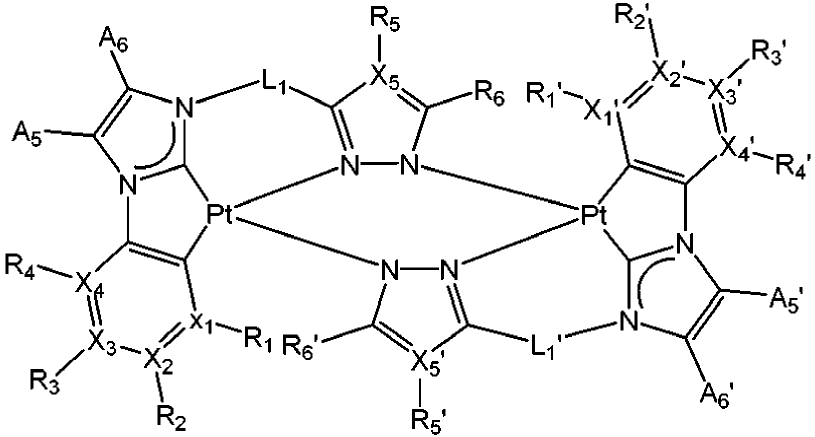 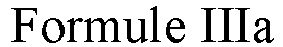 ou 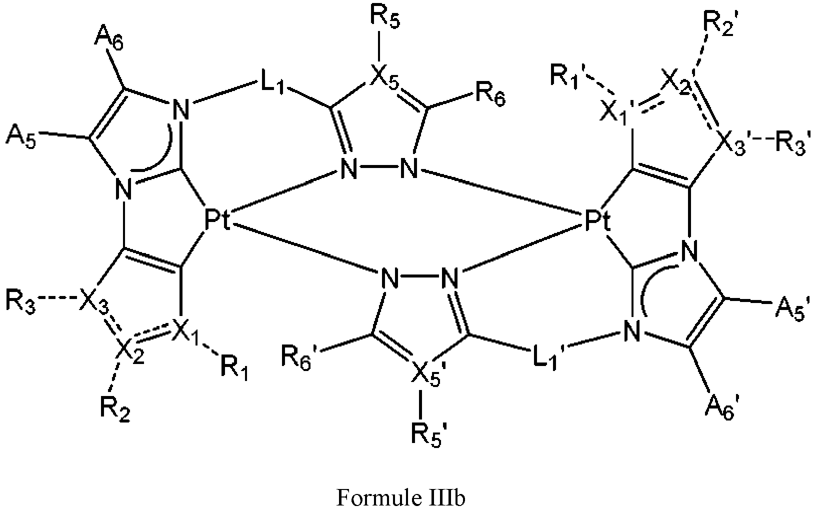 dans laquelle :
les traits linéaires en tirets désignent la présence ou l'absence d'une liaison,
A₅, A₆, A_{5'} et A_{6'} sont indépendamment hydrogène, deutérium, alkyle non substitué, alkyle substitué, aryle substitué, aryle non substitué, hétéroaryle non substitué, hétéroaryle substitué, polyhétéroaryle non substitué, polyhétéroaryle substitué, C₁-C₂₀hétérocyclyle substitué, ou C₁-C₂₀hétérocyclyle non substitué ; ou de préférence hydrogène, alkyle non substitué, alkyle substitué, deutérium, aryle substitué, ou aryle non substitué, éventuellement dans laquelle A₅, A₆, A_{5'} et A_{6'} sont hydrogène ou deutérium, ou dans laquelle A₅, A₆, A_{5'} et A_{6'} sont
(i) alkyle non substitué (tel que C₁-C₁₀ alkyle non substitué, C₁-C₅ alkyle non substitué ou C₁-C₃ alkyle non substitué) ou alkyle substitué (tel que C₁-C₁₀ alkyle substitué, C₁-C₅ alkyle substitué, ou C₁-C₃ alkyle substitué), ou
(ii) hydrogène, aryle substitué ou aryle non substitué, étant entendu qu'au moins l'un de A₅ et A₆, ou de A_{5'} et A_{6'}, est aryle substitué ou aryle non substitué.

6. Composé selon la revendication 4 ou la revendication 5, dans lequel
(i) pour la Formule IIa ou IIIa, X₁, X₂, X₃, X₄, X_{1'}, X_{2'}, X_{3'}, et X_{4'} sont carbone et sont indépendamment liés à un ou aucun atome d'hydrogène selon la valence, ou
(ii) dans lequel, pour la Formule IIa ou IIIa, un ou plusieurs de X₁, X₂, X₃, et X₄, et un ou plusieurs de X_{1'}, X_{2'}, X_{3'} et X_{4'} sont azote, et X₁, X₂, X₃, X₄, X_{1'}, X_{2'}, X_{3'}, et X_{4'} sont indépendamment liés à un ou aucun atome d'hydrogène selon la valence, éventuellement dans lequel, pour la Formule IIa ou IIIa, X₂ et X_{2'} sont azote, X₁, X₃, X₄, X_{1'}, X_{3'} et X_{4'} sont carbone, et X₁, X₂, X₃, X₄, X_{1'}, X_{2'}, X_{3'} et X_{4'} sont indépendamment liés à un ou aucun atome d'hydrogène selon la valence.

7. Composé selon l'une quelconque des revendications 4 à 6, dans lequel, pour la Formule IIa ou IIIa, R₁, R₂, R₃, R₄, R_{1'} R_{2'}, R_{3'}, et R_{4'} sont indépendamment absents, hydrogène, deutérium, alkyle substitué (tel que trifluorométhyle), alkyle non substitué, aryle substitué (tel que mésityle (2,4,6-triméthylphényle), 3,5-di-*tert*-butylphényle, 2,6-diméthylphényle), aryle non substitué, halogène (tel que fluor), ou R₁ et R₂ ensemble, R₂ et R₃ ensemble, R₃ et R₄ ensemble, R_{1'} et R_{2'} ensemble, R_{2'} et R_{3'} ensemble, R_{3'} et R_{4'} ensemble, ou une combinaison de ceux-ci, avec l'atome auquel ils sont fixés, forment un aryle substitué, un aryle non substitué, un hétéroaryle substitué, un hétéroaryle non substitué, un C₁-C₂₀ hétérocyclyle substitué, un C₁-C₂₀ hétérocyclyle non substitué, ou des combinaisons fusionnées de ceux-ci, éventuellement dans lequel, pour la Formule IIa ou IIIa, R₁ et R₂ ensemble, R₂ et R₃ ensemble, R₃ et R₄ ensemble, R_{1'} et R_{2'} ensemble, R_{2'} et R_{3'} ensemble, R_{3'} et R_{4'} ensemble, ou une combinaison de ceux-ci, avec l'atome auquel ils sont fixés, forment un aryle substitué, un aryle non substitué, un hétéroaryle substitué, un hétéroaryle non substitué, un C₁-C₂₀ hétérocyclyle substitué, un C₁-C₂₀ hétérocyclyle non substitué, ou des combinaisons fusionnées de ceux-ci, dans lequel, pour la Formule IIa ou IIIa, R₁ et R₂ ensemble, R₂ et R₃ ensemble, R₃ et R₄ ensemble, R_{1'} et R_{2'} ensemble, R_{2'} et R_{3'} ensemble, R_{3'} et R_{4'} ensemble, ou une combinaison de ceux-ci, avec l'atome auquel ils sont fixés, forment en outre éventuellement : 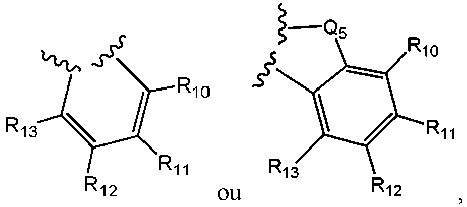
où Q₅ est NR₁₄, carbone ou soufre, ou oxygène ; et R₁₀-R₁₄ sont are indépendamment absents, hydrogène, alkyle substitué, alkyle non substitué, alkényle substitué, alkényle non substitué, alkynyle substitué, alkynyle non substitué, aryle substitué, aryle non substitué, halogène, hydroxyle, amino, amido, éther, thiol, cyano, nitro, alkoxy non substitué, alkoxy substitué, aroxy non substitué, aroxy substitué, hétéroaryle non substitué, hétéroaryle substitué, polyhétéroaryle non substitué, polyhétéroaryle substitué, carbonyle non substitué, carbonyle substitué, ester non substitué, ester substitué, C₁-C₂₀hétérocyclyle substitué, ou C₁-C₂₀hétérocyclyle non substitué, éventuellement où Q₅ est NR₁₄, carbone ou soufre, ou oxygène, tel que oxygène ; et R₁₀-R₁₄ sont indépendamment absents, hydrogène, alkyle substitué, ou alkyle non substitué
éventuellement, en outre, où Q₅ est oxygène ; et R₁₀-R₁₄ sont hydrogène.

8. Composé selon la revendication 4 ou la revendication 5, dans lequel, pour la Formule IIb ou IIIb :
(a) un ou plusieurs de X₁, X₂, et X₃, et un ou plusieurs de X_{1'}, X_{2'} et X_{3'} sont soufre, oxygène, ou azote, et X₁, X₂, X₃, X_{1'}, X_{2'} et X_{3'} sont indépendamment liés à un ou aucun atome d'hydrogène selon la valence ; et/ou
(b)
(i) dans lequel, pour la Formule IIb ou IIIb, l'un de X₁, X₂, et X₃, et l'un de X_{1'}, X_{2'} et X_{3'} sont soufre, et X₁, X₂, X₃, X_{1'}, X_{2'} et X_{3'} sont indépendamment liés à un ou aucun atome d'hydrogène selon la valence, ou
(ii) dans lequel, pour la Formule IIb ou IIIb, l'un de X₁, X₂, et X₃, et l'un de X_{1'}, X_{2'} et X_{3'}, sont oxygène, et X₁, X₂, X₃, X_{1'}, X_{2'}, et X_{3'} sont indépendamment liés à un ou aucun atome d'hydrogène selon la valence ; et/ou
(c) dans lequel, pour la Formule IIb ou IIIb, R₁, R₂, R₃, R_{1'}, R_{2'}, et R_{3'} sont indépendamment absents, hydrogène, alkyle substitué, alkyle non substitué, aryle substitué, aryle non substitué, halogène, ou R₁ et R₂ ensemble, R₂ et R₃ ensemble, R_{1'} et R_{2'} ensemble, R_{2'} et R_{3'} ensemble, ou une combinaison de ceux-ci, avec l'atome auquel ils sont fixés, forment un aryle substitué, un aryle non substitué, un hétéroaryle substitué, un hétéroaryle non substitué, un C₁-C₂₀ hétérocyclyle non substitué, un C₁-C₂₀ hétérocyclyle non substitué, ou une combinaison fusionnée de ceux-ci ; et/ou
(d) dans lequel, pour la Formule IIb ou IIIb, R₁, R₂, R₃, R₁, R_{2'}, et R₃ sont absents, hydrogène, ou une combinaison de ceux-ci.

9. Composé selon l'une quelconque des revendications 4, 5, ou 8, dans lequel, pour la Formule IIb ou IIIb, R₁ et R₂ ensemble, R₂ et R₃ ensemble, R_{1'} et R_{2'} ensemble, R_{2'} et R_{3'} ensemble, ou une combinaison de ceux-ci, avec l'atome auquel ils sont fixés, forment un aryle substitué, un aryle non substitué, un hétéroaryle substitué, un hétéroaryle non substitué, un C₁-C₂₀ hétérocyclyle substitué, un C₁-C₂₀ hétérocyclyle non substitué, ou des combinaisons fusionnées de ceux-ci, ou dans lequel, pour la Formule IIb ou IIIb, R₁ et R₂ ensemble, R₂ et R₃ ensemble, R_{1'} et R_{2'} ensemble, R_{2'} et R_{3'} ensemble, ou une combinaison de ceux-ci, avec l'atome auquel ils sont fixés, forment : 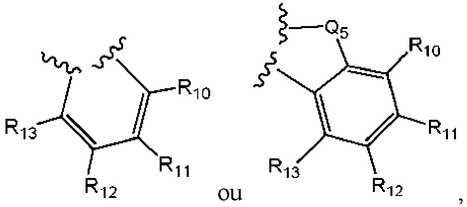
où Q₅ est NR₁₄, carbone ou soufre, ou oxygène ; et R₁₀-R₁₄ sont indépendamment absents, hydrogène, alkyle substitué, alkyle non substitué, alkényle substitué, alkényle non substitué, alkynyle substitué, alkynyle non substitué, aryle substitué, aryle non substitué, halogène, hydroxyle, amino, amido, éther, thiol, cyano, nitro, alkoxy non substitué, alkoxy substitué, aroxy non substitué, aroxy substitué, hétéroaryle non substitué, hétéroaryle substitué, polyhétéroaryle non substitué, polyhétéroaryle substitué, carbonyle non substitué, carbonyle substitué, ester non substitué, ester substitué, C₁-C₂₀ hétérocyclyle substitué, ou C₁-C₂₀ hétérocyclyle non substitué, éventuellement
où Q₅ est NR₁₄, carbone, soufre, ou oxygène, tel que soufre, et R₁₀-R₁₄ sont indépendamment absents, hydrogène, alkyle substitué, ou alkyle non substitué, en outre, éventuellement
où Q₅ est soufre ; et R₁₀-R₁₄ sont hydrogène.

10. Composé selon l'une quelconque des revendications 1 à 4, dans lequel, pour la Formule Ia, IIa, ou IIb, le compsoé a une structure : 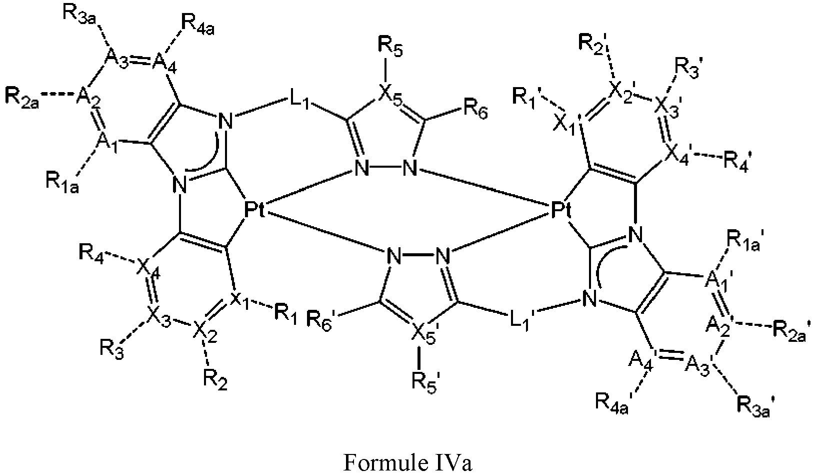 ou 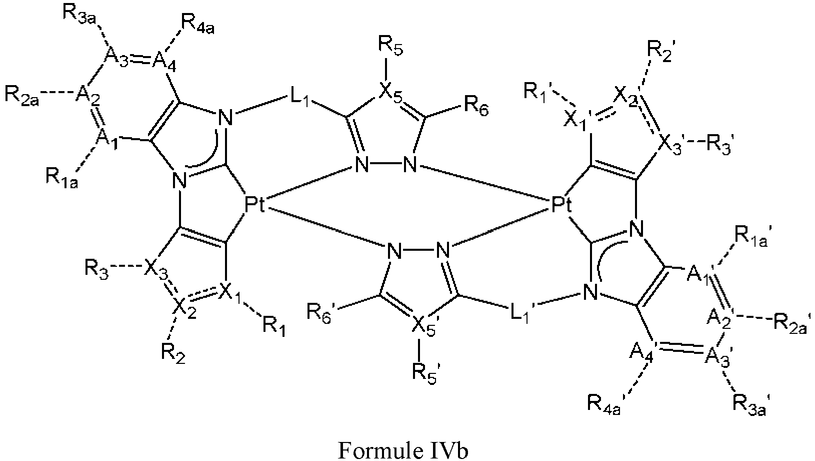 dans laquelle :
A₁, A₂, A₃, A₄, A_{1'}, A_{2'}, A_{3'}, et A_{4'} sont indépendamment carbone, azote, oxygène ou soufre, et sont indépendamment liés à un ou aucun atome d'hydrogène selon la valence, et
X₁, X₂, X₃, X₄, X_{1'}, X_{2'}, X_{3'}, et X_{4'}, quand ils sont présents, sont indépendamment carbone, azote, oxygène ou soufre, et sont indépendamment liés à un ou aucun atome d'hydrogène selon la valence.

11. Composé selon la revendication 10, dans lequel, pour la Formule IVa, A₁, A₂, A₃, A₄, A_{1'}, A_{2'}, A_{3'}, et A_{4'} sont carbone, et sont indépendamment liés à un ou aucun atome d'hydrogène selon la valence, et X₁, X₂, X₃, X₄, X_{1'}, X_{2'}, X_{3'}, et X_{4'} sont carbone et sont indépendamment liés à un ou aucun atome d'hydrogène selon la valence, et/ou
dans lequel, pour la Formule IVa, R₁, R₂, R₃, R₄, R_{1'}, R_{2'}, R_{3'}, et R_{4'} sont indépendamment absents, hydrogène, deutérium, alkyle substitué, alkyle non substitué, aryle substitué, aryle non substitué ou halogène, et/ou
dans lequel, pour la Formule IVa, R₁ₐ, R₂ₐ, R₃ₐ, R₄ₐ, R_{1a'}, R_{2a'}, R_{3a',} et R_{4a'} sont indépendamment absents, hydrogène, deutérium, alkyle substitué, alkyle non substitué, aryle substitué, ou aryle non substitué, ou R₁ₐ et R₂ₐ ensemble, R₂ₐ et R₃ₐ ensemble, R₃ₐ et R₄ₐ ensemble, R_{1a'} et R_{2a'} ensemble, R_{2a'} et R_{1a'} ensemble, R_{3a'} et R_{4a'} ensemble, ou une combinaison de ceux-ci, avec l'atome auquel ils sont fixés, forment un aryle substitué ou un aryle non substitué, et/ou
dans lequel, pour la Formule IVa, R₁ₐ et R₂ₐ ensemble, R₃ₐ et R₄ₐ ensemble, R_{1a'} et R_{2a'} ensemble, R_{3a'} et R_{4a'} ensemble, avec l'atome auquel ils sont fixés, forment un aryle substitué ou un aryle non substitué.

12. Composé selon l'une quelconque des revendications 1 à 4 ou 11, dans lequel
A. pour la Formule Ia, IIa, ou IVa, un ou plusieurs de A₁, A₂, A₃, et A₄ sont azote, un ou plusieurs de A_{1'}, A_{2'}, A_{3'}, et A_{4'} sont azote, et A₁, A₂, A₃, A₄, Ar, A_{2'}, A_{3'}, et A_{4'} sont indépendamment liés à un ou aucun atome d'hydrogène selon la valence, et X₁, X₂, X₃, X₄, X_{1'}, X_{2'}, X_{3'}, et X_{4'} sont carbone, et sont indépendamment liés à un ou aucun atome d'hydrogène selon la valence, éventuellement
dans lequel, pour la Formule IVa, R₁, R₂, R₃, R₄, R_{1'} R_{2'}, R_{3'}, et R_{4'} sont indépendamment absents, hydrogène, deutérium, alkyle substitué, alkyle non substitué, aryle substitué (tel que mésityle (2,4,6-triméthylphényle), 3,5-di-*tert*-butylphényle, 2,6-diméthylphényle), aryle non substitué, or halogène (tel que fluor),
et/ou
dans lequel R₁ₐ, R₂ₐ, R₃ₐ, R₄ₐ, R_{1a'}, R_{2a'}, R_{3a',} et R_{4a'} sont indépendamment absents, hydrogène, deutérium, alkyle substitué, alkyle non substitué, aryle substitué ou aryle non substitué (tel que phényle),
et/ou
(i) dans lequel, pour la Formule IVa, un de A₁, A₂, A₃, et A₄ est azote et les autres sont carbone, un de A_{1'}, A_{2'}, A_{3'}, et A_{4'} est azote et les autres sont carbone, et A₁, A₂, A₃, A₄, A_{1'}, A_{2'}, A_{3'}, et A_{4'} sont indépendamment liés à un ou aucun atome d'hydrogène selon la valence, ou
(ii) dans lequel, pour la Formule IVa, deux de A₁, A₂, A₃, et A₄ sont azote et les autres sont carbone, deux de A_{1'}, A_{2'}, A_{3'}, et A_{4'} sont azote et les autres sont carbone, et A₁, A₂, A₃, A₄, Ar, A_{2'}, A_{3'}, et A_{4'} sont indépendamment liés à un ou aucun atome d'hydrogène selon la valence,
ou
B. dans lequel, pour la Formule Ia, IIa, ou IVa, un ou plusieurs de A₁, A₂, A₃, et A4 sont oxygène, azote ou soufre, un ou plusieurs de A_{1'}, A_{2'}, A_{3'}, et A_{4'} sont oxygène, azote, ou soufre, et A₁, A₂, A₃, A₄, Ar, A_{2'}, A_{3'}, et A_{4'} sont indépendamment liés à un ou aucun atome d'hydrogène selon la valence, et un ou plusieurs de X₁, X₂, X₃, X₄, X_{1'}, X_{2'}, X_{3'}, et X_{4'} sont oxygène, azote ou soufre, et X₁, X₂, X₃, X₄, X_{1'}, X_{2'}, X_{3'}, et X_{4'} sont indépendamment liés à un ou aucun atome d'hydrogène selon la valence, éventuellement
dans lequel, pour la Formule IVa, R₁, R₂, R₃, R₄, R₁, R_{2'}, R_{3'}, et R_{4'} sont indépendamment absents, hydrogène, deutérium, alkyle substitué, alkyle non substitué, aryle substitué, aryle non substitué ou halogène (tel que fluor), et/ou
dans lequel R₁ₐ, R₂ₐ, R₃ₐ, R₄ₐ, R_{1a'}, R_{2a'}, R_{3a',} et R_{4a'} sont indépendamment absents, hydrogène, deutérium, alkyle substitué, alkyle non substitué, aryle substitué, ou aryle non substitué, et/ou
dans lequel, pour la Formule IVa, un ou plusieurs de A₁, A₂, A₃, et A₄ sont azote, un ou plusieurs de A_{1'}, A_{2'}, A_{3'}, et A_{4'} sont azote, et A₁, A₂, A₃, A₄, Ar, A_{2'}, A_{3'}, et A_{4'} sont indépendamment liés à un ou aucun atome d'hydrogène selon la valence, et un ou plusieurs de X₁, X₂, X₃, X₄, X_{1'}, X_{2'}, X_{3'}, et X_{4'} sont azote, et X₁, X₂, X₃, X₄, X_{1'}, X_{2'}, X_{3'}, et X_{4'} sont indépendamment liés à un ou aucun atome d'hydrogène selon la valence, et/ou
dans lequel, pour la Formule IVa, un de A₁, A₂, A₃, et A₄ est azote et les autres sont carbone, un de A_{1'}, A_{2'}, A_{3'}, et A_{4'} est azote et les autres sont carbone, et A₁, A₂, A₃, A₄, A_{1'}, A_{2'}, A_{3'}, et A_{4'} sont indépendamment liés à un ou aucun atome d'hydrogène selon la valence, et un de X₁, X₂, X₃, et X₄ est azote et les autres sont carbone, un de X_{1'}, X_{2'}, X_{3'}, et X_{4'} est azote et les autres sont carbone, et X₁, X₂, X₃, X₄, X_{1'}, X_{2'}, X_{3'} et X_{4'} sont indépendamment liés à un ou aucun atome d'hydrogène selon la valence.

13. Composé selon l'une quelconque des revendications 1 à 12, ayant une structure :

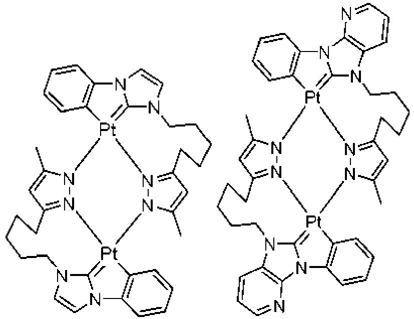

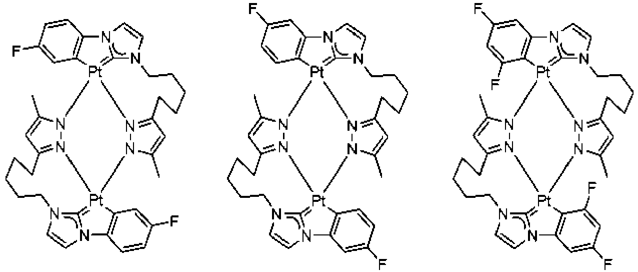

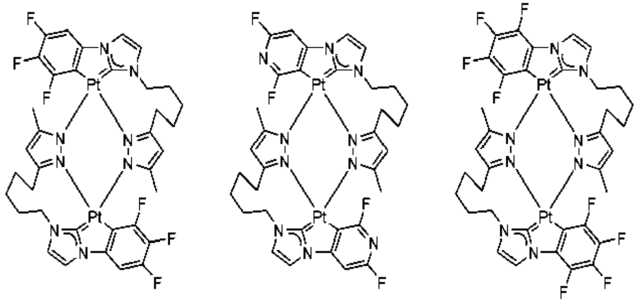

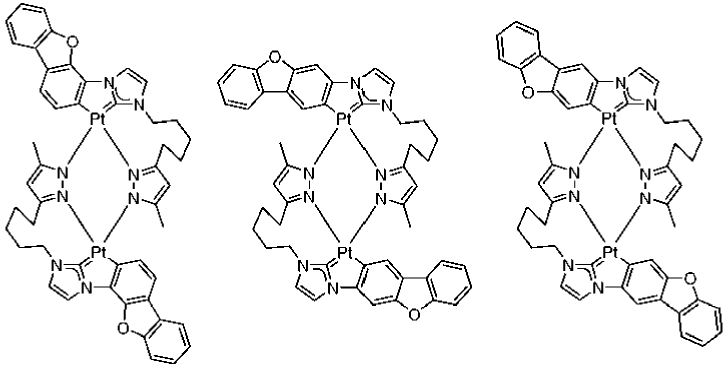

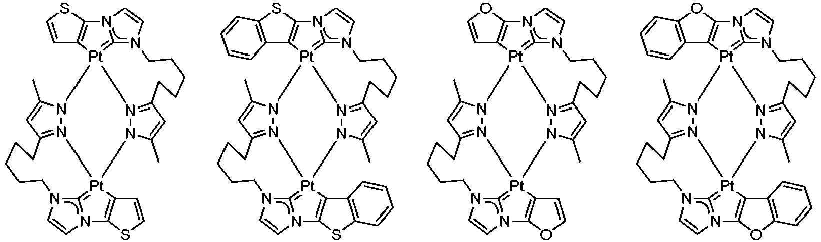

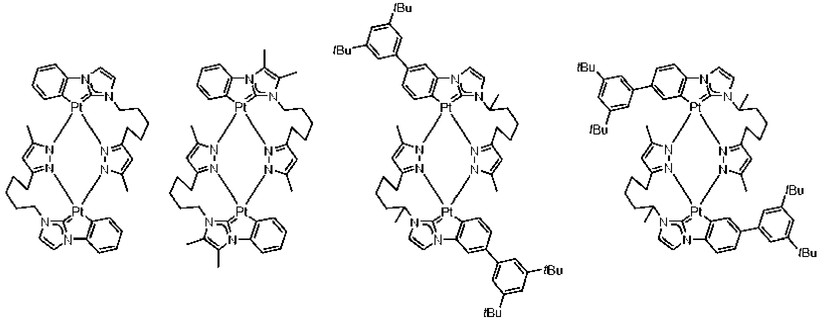

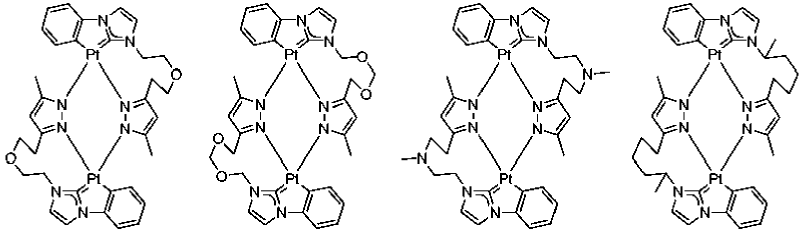

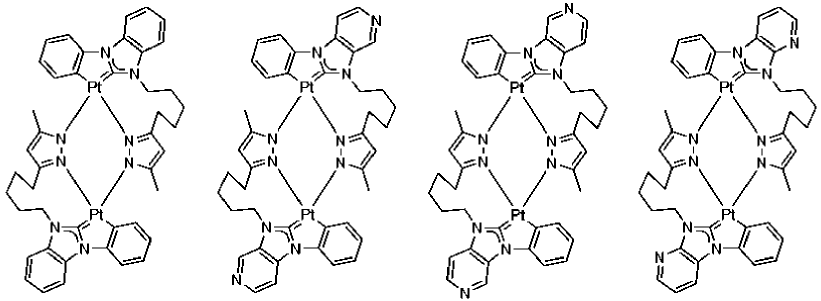

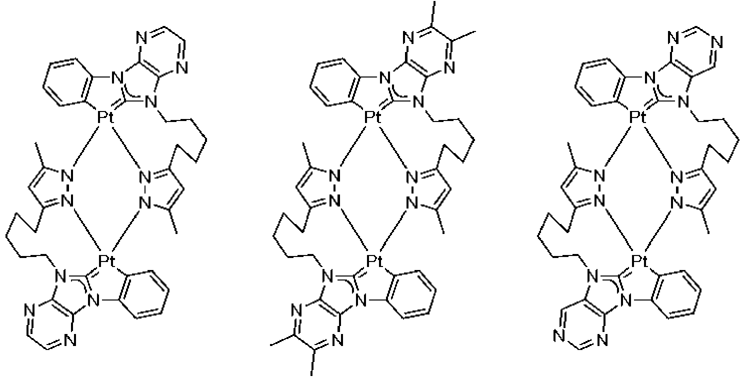

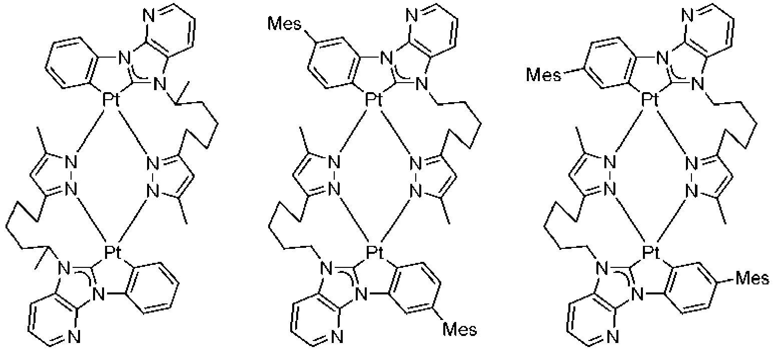

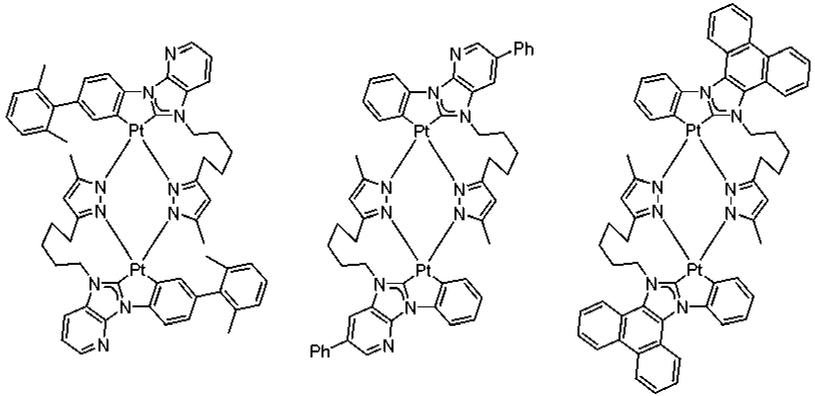

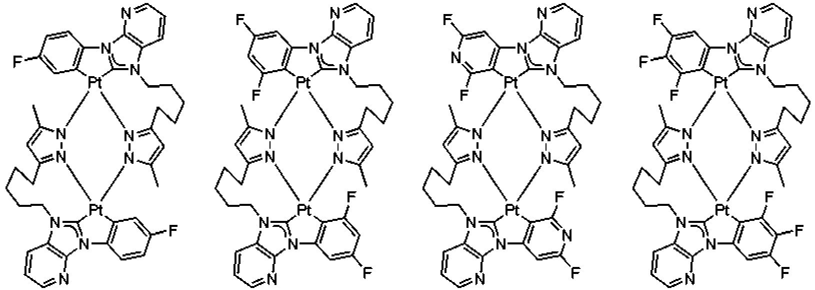

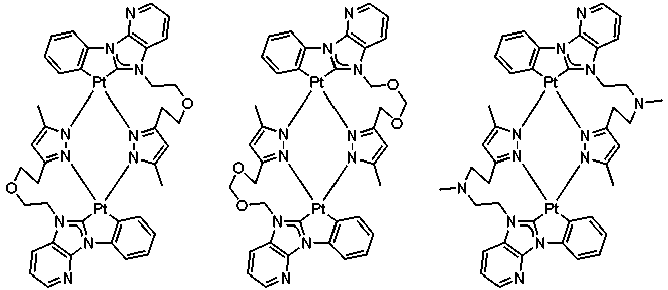

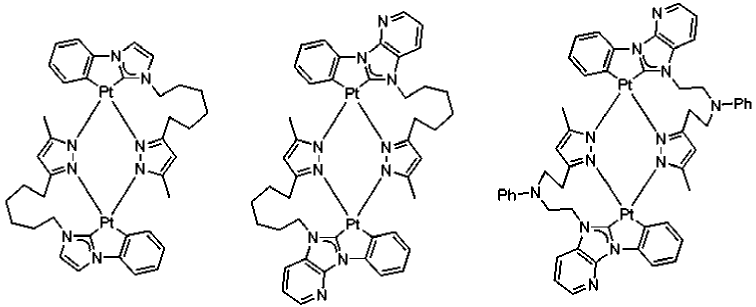

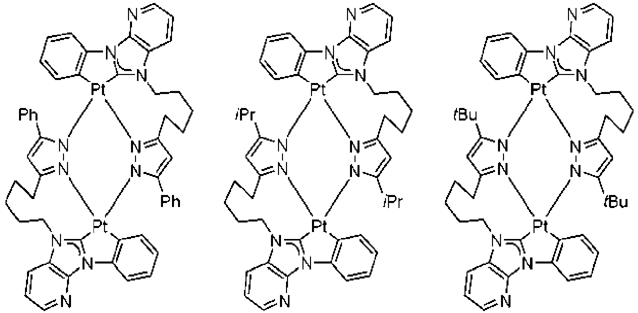

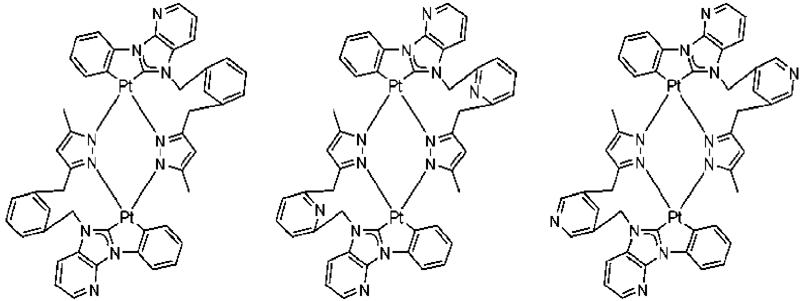

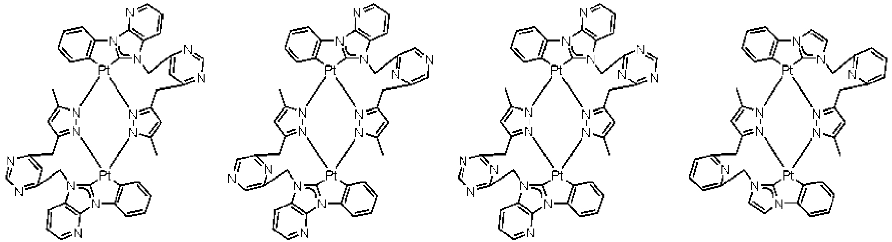

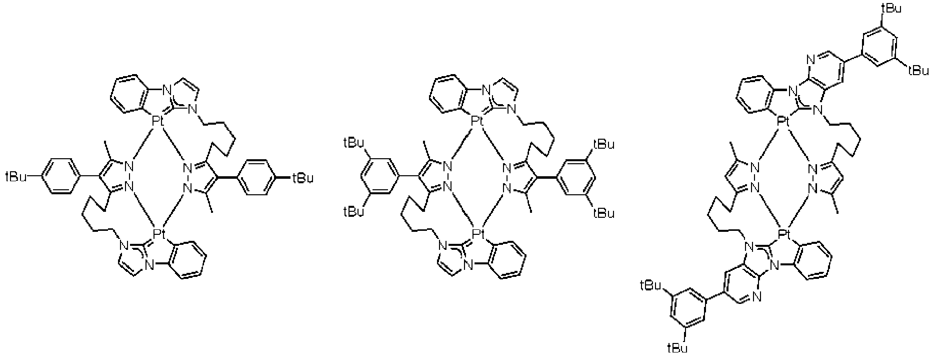

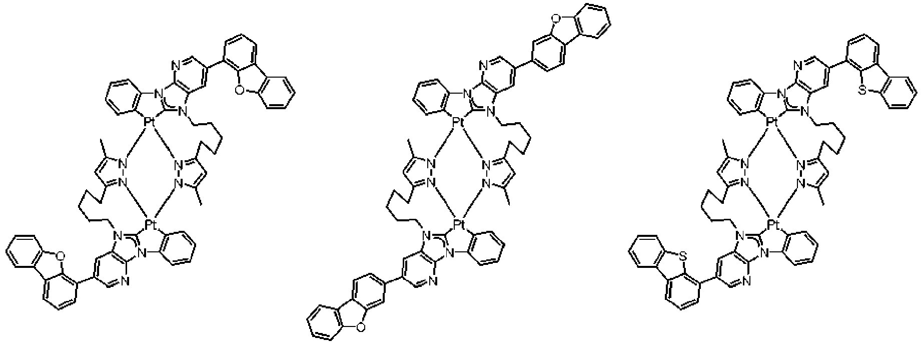

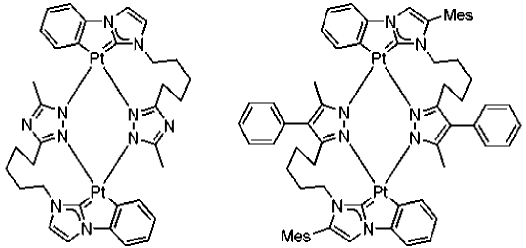

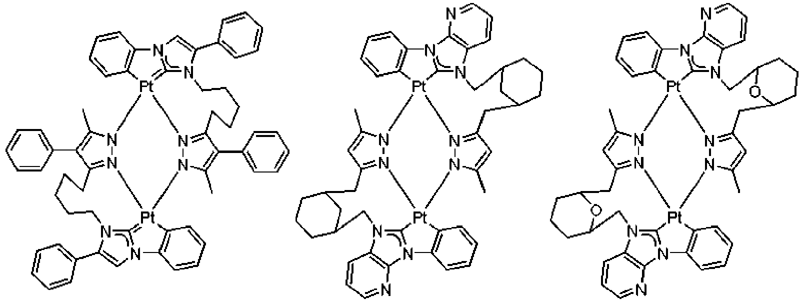

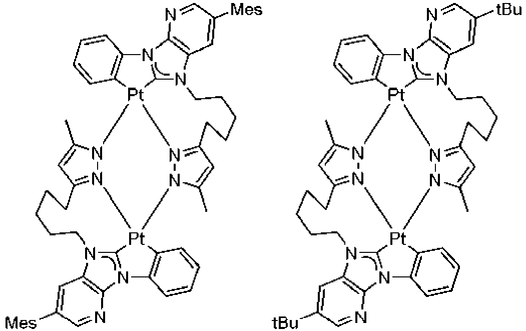

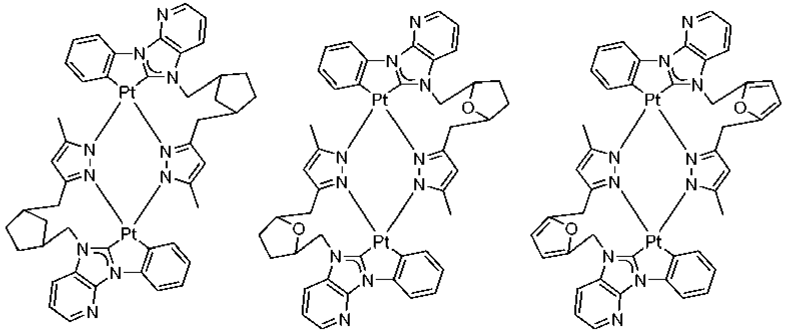

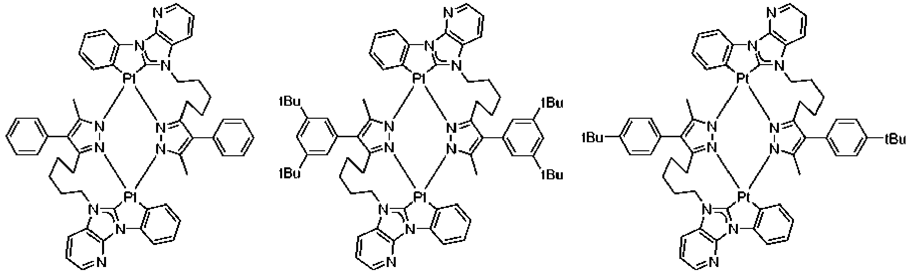

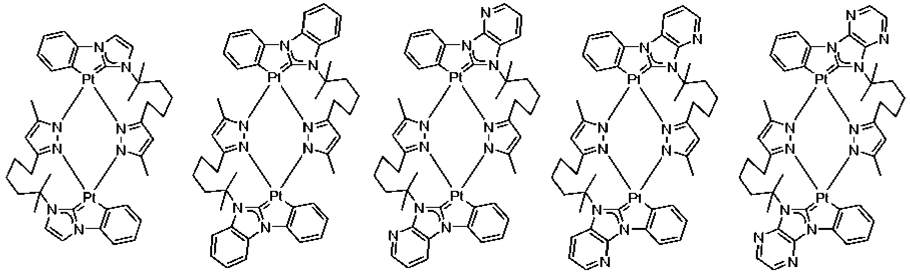

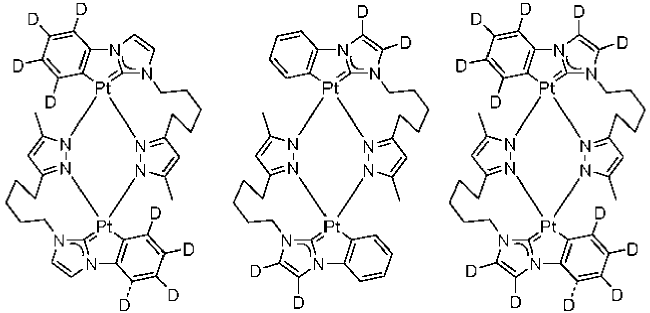

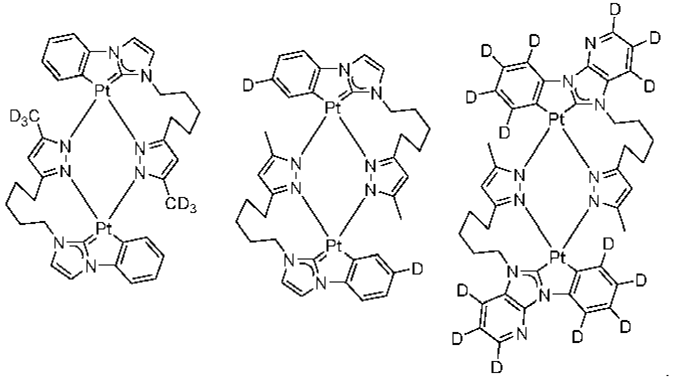

14. Composant électronique organique comprenant le composé selon l'une quelconque des revendications 1 à 13, éventuellement
le composant électronique organique étant une diode électroluminescente organique (OLED) ou une cellule électrochimique émettrice de lumière (LEEC), et/ou
dans lequel les composés sont dans une couche émettrice de lumière, et/ou
comprenant en outre une anode, une cathode, une zone de transport de trous et une zone de transport d'électrons,
dans lequel la zone de transport de trous comprend une couche d'injection de trous et/ou une couche de transport de trous, et éventuellement une couche de blocage d'électrons,
dans lequel la zone de transport d'électrons comprend une couche de transport d'électrons et/ou une couche d'injection d'électrons, et éventuellement une couche de blocage de trous,
la couche émettrice de lumière étant située entre l'anode et la cathode,
dans lequel la zone de transport de trous est située entre l'anode et la couche émettrice de lumière, et dans lequel la zone de transport d'électrons est située entre la cathode et la couche émettrice de lumière,
éventuellement dans lequel la couche émettrice de lumière est fabriquée par dépôt sous vide, dépôt par rotation ou impression à l'encre (telle qu'impression par jets d'encre ou impression de rouleau à rouleau).

15. Couche émettrice de lumière comprenant le composé selon l'une quelconque des revendications 1 à 13, comprenant en outre éventuellement un émetteur organique pur, dans laquelle le composé :
(i) joue le rôle de sensibilisateur pour transférer l'énergie à l'émetteur organique pur, ou
(ii) a un état singulet plus élevé que l'émetteur organique pur.

16. OLED, comprenant la couche émettrice de lumière de la revendication 15.

17. Dispositif, comprenant l'OLED de la revendication 16, le dispositif étant sélectionné parmi : dispositifs d'affichage fixes, dispositifs d'affichage mobiles, unités d'éclairage, claviers, vêtements, ornements, accessoires vestimentaires, dispositifs portables, dispositifs de surveillance médicale, papiers peints, tablettes électroniques, ordinateurs portables, panneaux publicitaires, panneaux d'affichage, appareils ménagers, ou appareils de bureau.
